(19) Europäisches Patentamt
European Patent Office
Office européen des brevets

(11) EP 4 131 442 A1

(12) # EUROPEAN PATENT APPLICATION
published in accordance with Art. 153(4) EPC

(43) Date of publication:
**08.02.2023 Bulletin 2023/06**

(21) Application number: **21781173.6**

(22) Date of filing: **22.03.2021**

(51) International Patent Classification (IPC):
***H01L 51/42*** *(2006.01)* ***H01L 31/10*** *(1974.07)*
***H01L 27/30*** *(2006.01)*

(52) Cooperative Patent Classification (CPC):
**C08G 83/00; H01L 27/30; H01L 31/10; H01L 51/42;**
Y02E 10/549

(86) International application number:
**PCT/JP2021/011596**

(87) International publication number:
**WO 2021/200316 (07.10.2021 Gazette 2021/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **31.03.2020 JP 2020063463**

(71) Applicant: **SUMITOMO CHEMICAL COMPANY, LIMITED**
**Tokyo 103-6020 (JP)**

(72) Inventors:
- **FERRARA, Giovanni**
**Tsukuba-shi, Ibaraki 300-3294 (JP)**
- **ARAKI, Takafumi**
**Tsukuba-shi, Ibaraki 300-3294 (JP)**
- **OZEKI, Miho**
**Tsukuba-shi, Ibaraki 300-3294 (JP)**

(74) Representative: **Vossius & Partner Patentanwälte Rechtsanwälte mbB**
**Siebertstraße 3**
**81675 München (DE)**

(54) **PHOTODETECTOR ELEMENT, SENSOR AND BIOMETRIC DEVICE INCLUDING SAME, COMPOSITION, AND INK**

(57) Provided is a photodetector having a small dark current ratio. A photodetector includes a first electrode, a second electrode, and an active layer provided between the first electrode and the second electrode, the active layer contains a p-type semiconductor material and an n-type semiconductor material, the p-type semiconductor material contains a polymer having the highest occupied molecular orbital (HOMO) of -5.45 eV or less, and the n-type semiconductor material contains a non-fullerene compound. It is preferable that the polymer contained in the p-type semiconductor material contains a constitutional unit DU having an electron donating property and a constitutional unit AU having an electron accepting property, and the non-fullerene compound contains a moiety DP having an electron donating property and a moiety AP having an electron accepting property.

[FIG. 1]

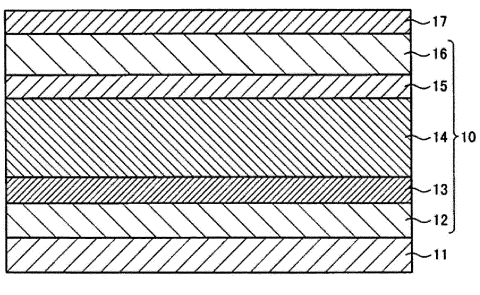


EP 4 131 442 A1

## Description

TECHNICAL FIELD

The present invention relates to a photodetector, a sensor and a biometric authentication device each including the photodetector, a composition, and an ink.

BACKGROUND ART

A photoelectric conversion element is, for example, an extremely useful device from the viewpoint of energy saving and reduction of a carbon dioxide emission amount, and has attracted attention.
A photodetector, which is a kind of photoelectric conversion element, can generate an electromotive force in a certain direction by irradiation with light, and can extract an electrical signal to the outside. In the photodetector, it is ideal that no current flows in a dark state in which light is not irradiated. However, in a case where a voltage (reverse bias) in a direction opposite to an electromotive force generated by irradiation with light is applied to the photodetector, a current may flow in a dark state in which light is not irradiated (so-called dark current).
In order to reduce the dark current, a material of an intermediate layer disposed between an electrode and an active layer of a photodetector has been studied (Non-Patent Documents 1 and 2).

PRIOR ART DOCUMENTS

NON-PATENT DOCUMENTS

Non-Patent Document 1: Appl. Phys. Lett. 110, 083301 (2017)
Non-Patent Document 2: RSC Adv. 2017, 7, 1743-1748

SUMMARY OF THE INVENTION

PROBLEMS TO BE SOLVED BY THE INVENTION

A magnitude of a voltage applied to the photodetector can vary depending on a kind of device on which the photodetector is mounted. Usually, when a voltage applied to the photodetector is increased, a dark current is also increased. From the viewpoint of using the photodetector as an element having versatility to various devices, it is preferable that a change in dark current is small even when a voltage applied to the photodetector varies. Specifically, a dark current ratio is preferably small. Here, a ratio (dark current (-3 V)/dark current (-0.5 V)) of a dark current obtained when a voltage of -3 V is applied to a dark current obtained when a voltage of -0.5 V is applied is referred to as the dark current ratio. However, a direction in which an electromotive force generated in the photodetector by light irradiation is positive. Hereinafter, the "dark current (-3 V)/dark current (-0.5 V)" is also simply referred to as a dark current ratio.
Therefore, there is a need for a photodetector having a small dark current ratio, a sensor including the photodetector, a biometric authentication device including the photodetector, an X-ray sensor including the photodetector, a near-infrared sensor including the photodetector, a composition by which a photodetector having a small dark current ratio can be manufactured, and an ink by which a photodetector having a small dark current ratio can be manufactured.

MEANS FOR SOLVING THE PROBLEMS

As a result of conducting intensive studies to solve the above problems, the present inventors have found that a dark current ratio can be reduced by a photodetector including an active layer containing a specific p-type semiconductor material and a specific n-type semiconductor material, thereby completing the present invention.
That is, the present invention provides the followings.

[1] A photodetector including: a first electrode; a second electrode; and an active layer provided between the first electrode and the second electrode,

in which the active layer contains a p-type semiconductor material and an n-type semiconductor material,
the p-type semiconductor material contains a polymer having the highest occupied molecular orbital (HOMO) of - 5.45 eV or less, and

the n-type semiconductor material contains a non-fullerene compound.

[2] A photodetector including: a first electrode; a second electrode; and an active layer provided between the first electrode and the second electrode,

in which the active layer contains a p-type semiconductor material and an n-type semiconductor material,
the p-type semiconductor material contains a polymer containing a constitutional unit DU having an electron donating property and a constitutional unit AU having an electron accepting property,
the n-type semiconductor material contains a non-fullerene compound,
the constitutional unit DU includes one or more pairs of atoms n-bonded to each other, and among absolute values of differences in electronegativity of the pairs of atoms n-bonded to each other, a maximum value is represented by $DUD_{max}$,
the constitutional unit AU includes one or more pairs of atoms π-bonded to each other, and among absolute values of differences in electronegativity of the pairs of atoms n-bonded to each other, a maximum value is represented by $AUD_{max}$,
the non-fullerene compound contains a moiety DP having an electron donating property and a moiety AP having an electron accepting property,
the moiety DP includes one or more pairs of atoms π-bonded to each other, and among absolute values of differences in electronegativity of the pairs of atoms π-bonded to each other, a maximum value is represented by $DPD_{max}$,
the moiety AP includes one or more pairs of atoms π-bonded to each other, and among absolute values of differences in electronegativity of the pairs of atoms π-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

[3] The photodetector according to [1], in which the polymer contained in the p-type semiconductor material contains a constitutional unit DU having an electron donating property and a constitutional unit AU having an electron accepting property, and the non-fullerene compound contains a moiety DP having an electron donating property and a moiety AP having an electron accepting property.
[4] The photodetector according to [3], in which the constitutional unit DU includes one or more pairs of atoms n-bonded to each other, and among absolute values of differences in electronegativity of the pairs of atoms π-bonded to each other, a maximum value is represented by $DUD_{max}$,

the constitutional unit AU includes one or more pairs of atoms π-bonded to each other, and among absolute values of differences in electronegativity of the pairs of atoms π-bonded to each other, a maximum value is represented by $AUD_{max}$,
the moiety DP includes one or more pairs of atoms n-bonded to each other, and among absolute values of differences in electronegativity of the pairs of atoms π-bonded to each other, a maximum value is represented by $DPD_{max}$,
the moiety AP includes one or more pairs of atoms π-bonded to each other, and among absolute values of differences in electronegativity of the pairs of atoms π-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

[5] The photodetector according to any one of [2] to [4], in which the constitutional unit DU has a ketone structure, an imine structure, a sulfoxide structure, or a sulfone structure.
[6] The photodetector according to any one of [2] to [5], in which the moiety AP has a ketone structure, an imine structure, a sulfoxide structure, or a sulfone structure.
[7] The photodetector according to any one of [1] to [6], in which the polymer contained in the p-type semiconductor material contains a constitutional unit represented by the following Formula (I):

[Chem. 1]

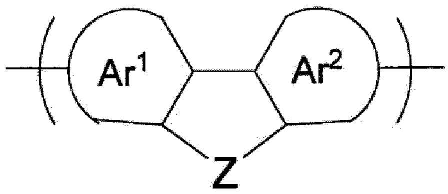

( I )

in the formula,
$Ar^1$ and $Ar^2$ each independently represent an aromatic carbocyclic ring which may have a substituent or an aromatic heterocyclic ring which may have a substituent, and
Z represents a group represented by any one of the following Formulas (Z-1) to (Z-4),

[Chem. 2]

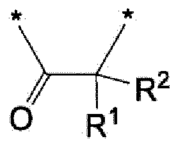

(Z-1)

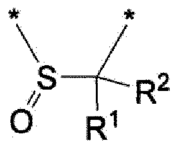

(Z-2)

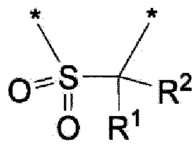

(Z-3)

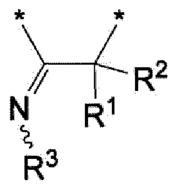

(Z-4)

wherein $R^1$, $R^2$, and $R^3$ each independently represent
a hydrogen atom,
a halogen atom,
an alkyl group which may have a substituent,
a cycloalkyl group which may have a substituent,
an alkenyl group which may have a substituent,
a cycloalkenyl group which may have a substituent,
an alkynyl group which may have a substituent,
a cycloalkynyl group which may have a substituent,
an alkyloxy group which may have a substituent,
an alkylthio group which may have a substituent,
an aryl group which may have a substituent,
an aryloxy group which may have a substituent,
an arylthio group which may have a substituent,
a monovalent heterocyclic group which may have a substituent,
a group represented by $-C(=O)-R^a$, or
a group represented by $-SO_2-R^b$, and
$R^a$ and $R^b$ each independently represent
a hydrogen atom,
an alkyl group which may have a substituent,
an aryl group which may have a substituent,
an alkyloxy group which may have a substituent,
an aryloxy group which may have a substituent, or

a monovalent heterocyclic group which may have a substituent.

[8] The photodetector according to [7], in which the polymer contained in the p-type semiconductor material contains a constitutional unit represented by the following Formula (II):

[Chem. 3]

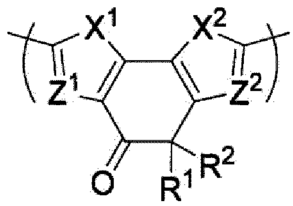

(I I)

in the formula,
$X^1$ and $X^2$ each independently represent a sulfur atom or an oxygen atom,
$Z^1$ and $Z^2$ each independently represent a group represented by =C(-$R^4$)- or a nitrogen atom,
$R^1$ and $R^2$ represent the same meanings as described above,
$R^4$ represents
a hydrogen atom,
a halogen atom,
an alkyl group which may have a substituent,
a cycloalkyl group which may have a substituent,
an alkenyl group which may have a substituent,
a cycloalkenyl group which may have a substituent,
an alkynyl group which may have a substituent,
a cycloalkynyl group which may have a substituent,
an alkyloxy group which may have a substituent,
an alkylthio group which may have a substituent,
an aryl group which may have a substituent,
an aryloxy group which may have a substituent,
an arylthio group which may have a substituent,
a monovalent heterocyclic group which may have a substituent,
a group represented by -C(=O)-$R^a$, or
a group represented by -$SO_2$-$R^b$, and
$R^a$ and $R^b$ each independently represent
a hydrogen atom,
an alkyl group which may have a substituent,
an aryl group which may have a substituent,
an alkyloxy group which may have a substituent,
an aryloxy group which may have a substituent, or
a monovalent heterocyclic group which may have a substituent.

[9] The photodetector according to any one of [1] to [8], in which the non-fullerene compound contained in the n-type semiconductor material contains a compound represented by the following Formula (III):

$$A^1\text{-}B^{10}\text{-}A^2 \qquad (III)$$

in the formula,
$A^1$ and $A^2$ each independently represent an electron-withdrawing group, and
$B^{10}$ represents a group having a n-conjugated system.

[10] The photodetector according to any one of [1] to [9], in which the non-fullerene compound contained in the n-type semiconductor material contains a compound represented by the following Formula (IV):

$$A^1\text{-}(S^1)_{n1}\text{-}B^{11}\text{-}(S^2)_{n2}\text{-}A^2 \qquad (IV)$$

in Formula (IV),
$A^1$ and $A^2$ each independently represent an electron-withdrawing group,
$S^1$ and $S^2$ each independently represent
a divalent carbocyclic group which may have a substituent,
a divalent heterocyclic group which may have a substituent,
a group represented by $-C(R^{s1})=C(R^{s2})-$
(where, $R^{s1}$ and $R^{s2}$ each independently represent a hydrogen atom or a substituent), or
a group represented by -C=C-,
$B^{11}$ is a fused ring group having two or more structures selected from the group consisting of a carbocyclic structure and a heterocyclic structure, or a fused ring group that does not have an ortho-peri-fused structure, and represents a fused ring group which may have a substituent, and
n1 and n2 each independently represent an integer of 0 or more.

[11] The photodetector according to [10], in which $B^{11}$ is a fused ring group having two or more structures selected from the group consisting of structures represented by the following Formulas (Cy1) to (Cy9), or a fused ring group which may have a substituent,

[Chem. 4]

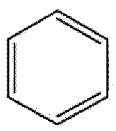
(Cy1)

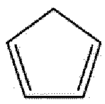
(Cy2)

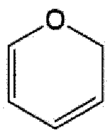
(Cy3)

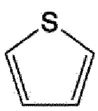
(Cy4)

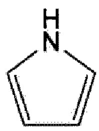
(Cy5)

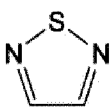
(Cy6)

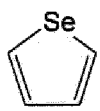
(Cy7)

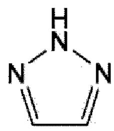
(Cy8)

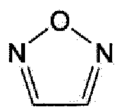
(Cy9)

[12] The photodetector according to [10] or [11], in which $S^1$ and $S^2$ each independently represent a group represented by any one of the following Formulas (s-1) and (s-2),

[Chem. 5]

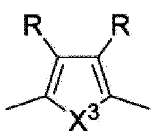
**(s-1)**

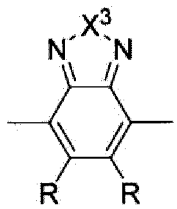
**(s-2)**

in Formula (s-1) and Formula (s-2),
$X^3$ represents an oxygen atom or a sulfur atom, and
a plurality of R's each independently represent a hydrogen atom or a substituent.

[13] The photodetector according to any one of [9] to [12], in which $A^1$ and $A^2$ each independently represent $-CH=C(-CN)_2$ or a group represented by any one of the following Formulas (a-1) to (a-9),

[Chem. 6]

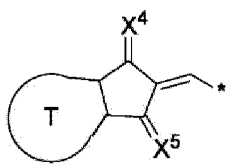

(a-1)

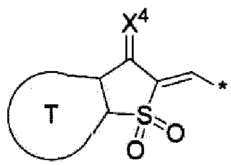

(a-2)

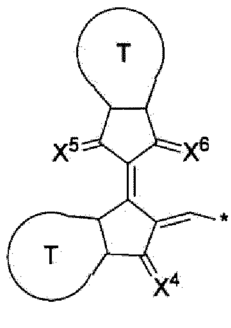

(a-3)

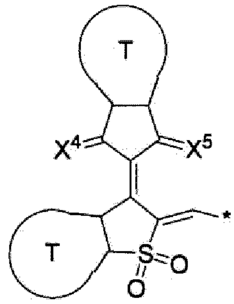

(a-4)

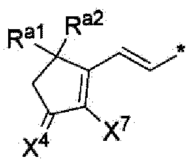

(a-5)

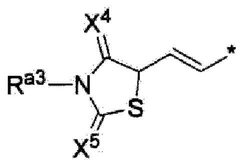

(a-6)

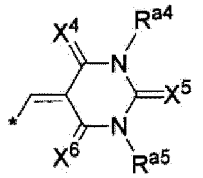

(a-7)

in Formulas (a-1) to (a-7),

T represents a carbocyclic ring which may have a substituent or a heterocyclic ring which may have a substituent,

$X^4$, $X^5$, and $X^6$ each independently represent an oxygen atom, a sulfur atom, an alkylidene group, or a group represented by $=C(-CN)_2$,

$X^7$ represents a hydrogen atom, a halogen atom, a cyano group, an alkyl group which may have a substituent, an alkyloxy group which may have a substituent, an aryl group which may have a substituent, or a monovalent heterocyclic group which may have a substituent, and

$R^{a1}$, $R^{a2}$, $R^{a3}$, $R^{a4}$, and $R^{a5}$ each independently represent a hydrogen atom, a halogen atom, an alkyl group which may have a substituent, an alkyloxy group which may have a substituent, an aryl group which may have a substituent, or a monovalent heterocyclic group which may have a substituent,

[Chem. 7]

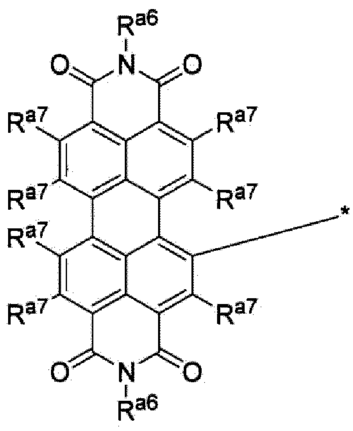

(a-8)

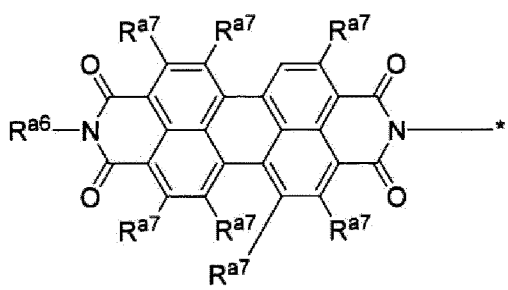

(a-9)

in Formula (a-8) and Formula (a-9),

$R^{a6}$ and $R^{a7}$ each independently represent
a hydrogen atom,
a halogen atom,
an alkyl group which may have a substituent,
a cycloalkyl group which may have a substituent,
an alkyloxy group which may have a substituent,
a cycloalkyloxy group which may have a substituent,
a monovalent aromatic carbocyclic group which may have a substituent, or
a monovalent aromatic heterocyclic group which may have a substituent, and
a plurality of $R^{a6}$'s and a plurality of $R^{a7}$'s may be the same as or different from each other.

[14] The photodetector according to any one of [1] to [8], in which the non-fullerene compound contains a compound represented by the following Formula (V) or (VI):

[Chem. 8]

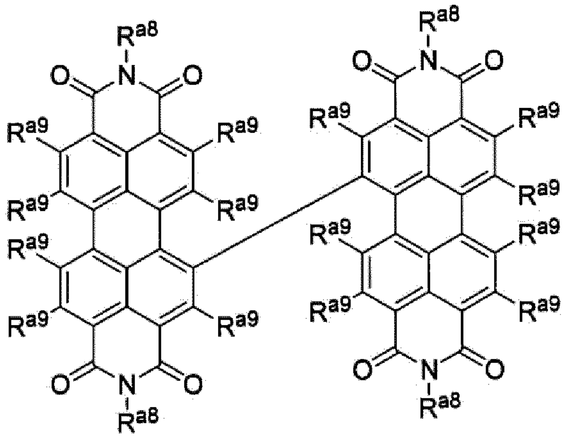

(V)

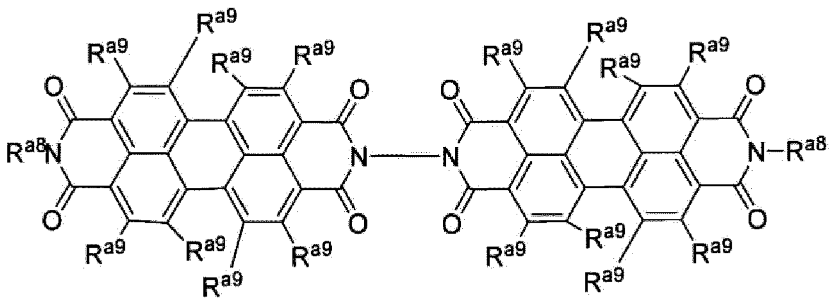

(VI)

in the formula,
$R^{a8}$ and $R^{a9}$ each independently represent
a hydrogen atom,
a halogen atom,
an alkyl group which may have a substituent,
a cycloalkyl group which may have a substituent,
an alkyloxy group which may have a substituent,
a cycloalkyloxy group which may have a substituent,
a monovalent aromatic carbocyclic group which may have a substituent, or
a monovalent aromatic heterocyclic group which may have a substituent, and
a plurality of $R^{a8}$'s and a plurality of $R^{a9}$'s may be the same as or different from each other.

[15] A sensor including the photodetector according to any one of [1] to [14].
[16] A biometric authentication device including the photodetector according to any one of [1] to [14].
[17] An X-ray sensor including the photodetector according to any one of [1] to [14].
[18] A near-infrared sensor including the photodetector according to any one of [1] to [14].

[19] A composition containing a p-type semiconductor material and an n-type semiconductor material,

in which the p-type semiconductor material contains a polymer having a HOMO of -5.45 eV or less, and
the n-type semiconductor material contains a non-fullerene compound.

[20] A composition containing a p-type semiconductor material and an n-type semiconductor material,

in which the p-type semiconductor material contains a polymer containing a constitutional unit DU having an electron donating property and a constitutional unit AU having an electron accepting property,
the n-type semiconductor material contains a non-fullerene compound,
the constitutional unit DU includes one or more pairs of atoms π-bonded to each other, and among absolute values of differences in electronegativity of the pairs of atoms π-bonded to each other, a maximum value is represented by $DUD_{max}$,
the constitutional unit AU includes one or more pairs of atoms π-bonded to each other, and among absolute values of differences in electronegativity of the pairs of atoms n-bonded to each other, a maximum value is represented by $AUD_{max}$,
the non-fullerene compound contains a moiety DP having an electron donating property and a moiety AP having an electron accepting property,
the moiety DP includes one or more pairs of atoms π-bonded to each other, and among absolute values of differences in electronegativity of the pairs of atoms π-bonded to each other, a maximum value is represented by $DPD_{max}$,
the moiety AP includes one or more pairs of atoms n-bonded to each other, and among absolute values of differences in electronegativity of the pairs of atoms π-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

[21] An ink containing the composition according to [19] or [20] .

The composition according to the present invention includes the following aspects.

[2-1] The composition according to [19], in which the p-type semiconductor material contains a polymer containing a constitutional unit DU having an electron donating property and a constitutional unit AU having an electron accepting property,

the constitutional unit DU includes one or more pairs of atoms π-bonded to each other, and among absolute values of differences in electronegativity of the pairs of atoms π-bonded to each other, a maximum value is represented by $DUD_{max}$,
the constitutional unit AU includes one or more pairs of atoms π-bonded to each other, and among absolute values of differences in electronegativity of the pairs of atoms π-bonded to each other, a maximum value is represented by $AUD_{max}$,
the non-fullerene compound contains a moiety DP having an electron donating property and a moiety AP having an electron accepting property,
the moiety DP includes one or more pairs of atoms π-bonded to each other, and among absolute values of differences in electronegativity of the pairs of atoms π-bonded to each other, a maximum value is represented by $DPD_{max}$,
the moiety AP includes one or more pairs of atoms π-bonded to each other, and among absolute values of differences in electronegativity of the pairs of atoms π-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

[2-2] An ink containing the composition according to [2-1]. EFFECT OF THE INVENTION

According to the present invention, it is possible to provide a photodetector having a small dark current ratio, a sensor including the photodetector, a biometric authentication device including the photodetector, an X-ray sensor including the photodetector, a near-infrared sensor including the photodetector, a composition by which a photodetector having a small dark current ratio can be manufactured, and an ink by which a photodetector having a small dark current ratio can be manufactured.

BRIEF DESCRIPTION OF THE DRAWINGS

Fig. 1 is a view schematically illustrating a configuration example of a photodetector.
Fig. 2 is a view schematically illustrating a configuration example of an image detection unit.
Fig. 3 is a view schematically illustrating a configuration example of a fingerprint detection unit.

MODE FOR CARRYING OUT THE INVENTION

[Description of Terms]

Terms and the like commonly used in the following description will be first described.
A "polymer compound" means a polymer having a molecular weight distribution and a number average molecular weight of $1 \times 10^3$ or more and $1 \times 10^8$ or less in terms of polystyrene. Note that a constitutional unit contained in the polymer compound is 100 mol% in total.
The "constitutional unit" means a unit of a structure of the polymer compound.
A "non-fullerene compound" means a compound that is neither fullerene nor a fullerene derivative.
A "hydrogen atom" may be a light hydrogen atom or a heavy hydrogen atom.
Examples of a "halogen atom" include a fluorine atom, a chlorine atom, a bromine atom, and an iodine atom.
An aspect of "which may have a substituent" includes both aspects of a case where all hydrogen atoms constituting a compound or group are unsubstituted and a case where some or all of one or more hydrogen atoms are substituted by a substituent.
Examples of the substituent include a halogen atom, an alkyl group, a cycloalkyl group, an alkenyl group, a cycloalkenyl group, an alkynyl group, a cycloalkynyl group, an alkyloxy group, a cycloalkyloxy group, an alkylthio group, a cycloalkylthio group, an aryl group, an aryloxy group, an arylthio group, a monovalent heterocyclic group, a substituted amino group, an acyl group, an imine residue, an amide group, an acid imide group, a substituted oxycarbonyl group, a cyano group, an alkylsulfonyl group, and a nitro group.
The "alkyl group" may be linear or branched. The alkyl group may have a substituent. The number of carbon atoms of the alkyl group is usually 1 to 30, preferably 3 to 30, and more preferably 12 to 19, without including the number of carbon atoms of the substituent.
Examples of the alkyl group include alkyl groups having no substituent, such as a methyl group, an ethyl group, a propyl group, an isopropyl group, a butyl group, an isobutyl group, a tert-butyl group, a pentyl group, a 3-methylbutyl group, a 2-ethylbutyl group, a hexyl group, a heptyl group, an octyl group, a 2-ethylhexyl group, a 3-propylheptyl group, a decyl group, a 3,7-dimethyloctyl group, a 3-heptyldodecyl group, a 2-ethyloctyl group, a 2-hexyldecyl group, a dodecyl group, a tetradecyl group, a hexadecyl group, an octadecyl group, and an icosyl group, and a group in which a hydrogen atom in these groups is substituted with a substituent such as an alkyloxy group, an aryl group, or a fluorine atom.
Specific examples of alkyl having a substituent include a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-dihexylphenyl)propyl group, and a 6-ethyloxyhexyl group.
The "cycloalkyl group" may be a monocyclic group or a polycyclic group. The cycloalkyl group may have a substituent. The number of carbon atoms of the cycloalkyl group is usually 3 to 30 and preferably 12 to 19 without

including the number of carbon atoms of the substituent.

Examples of the cycloalkyl group include alkyl groups having no substituent, such as a cyclopentyl group, a cyclohexyl group, a cycloheptyl group, and an adamantyl group, and a group in which a hydrogen atom in these groups is substituted with a substituent such as an alkyl group, an alkyloxy group, an aryl group, or a fluorine atom.

Specific examples of a cycloalkyl group having a substituent include a methylcyclohexyl group and an ethylcyclohexyl group.

The "alkenyl group" may be linear or branched. The alkenyl group may have a substituent. The number of carbon atoms of the alkenyl group is usually 2 to 30 and preferably 12 to 19 without including the number of carbon atoms of the substituent.

Examples of the alkenyl group include alkenyl groups having no substituent, such as a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, and a 7-octenyl group, and a group in which a hydrogen atom in these groups is substituted with a substituent such as an alkyloxy group, an aryl group, or a fluorine atom.

The "cycloalkenyl group" may be a monocyclic group or a polycyclic group. The cycloalkenyl group may have a substituent. The number of carbon atoms of the cycloalkenyl group is usually 3 to 30 and preferably 12 to 19 without including the number of carbon atoms of the substituent.

Examples of the cycloalkenyl group include cycloalkenyl groups having no substituent, such as a cyclohexenyl group, and a group in which a hydrogen atom in these groups is substituted with a substituent such as an alkyl group, an alkyloxy group, an aryl group, or a fluorine atom.

Examples of a cycloalkenyl group having a substituent include a methylcyclohexenyl group and an ethylcyclohexenyl group.

The "alkynyl group" may be linear or branched. The alkynyl group may have a substituent. The number of carbon atoms of the alkynyl group is usually 2 to 30 and preferably 12 to 19 without including the number of carbon atoms of the substituent.

Examples of the alkynyl group include alkynyl groups having no substituent, such as an ethynyl group, a 1-propynyl group, a 2-propynyl group, a 2-butynyl group, a 3-butynyl group, a 3-pentynyl group, a 4-pentynyl group, a 1-hexynyl group, and a 5-hexynyl group, and a group in which a hydrogen atom in these groups is substituted with a substituent such as an alkyloxy group, an aryl group, or a fluorine atom.

The "cycloalkynyl group" may be a monocyclic group or a polycyclic group. The cycloalkynyl group may have a substituent. The number of carbon atoms of the cycloalkynyl group is usually 4 to 30 and preferably 12 to 19 without including the number of carbon atoms of the substituent.

Examples of the cycloalkynyl group include cycloalkynyl groups having no substituent, such as a cyclohexynyl group, and a group in which a hydrogen atom in these groups is substituted with a substituent such as an alkyl group, an alkyloxy group, an aryl group, or a fluorine atom.

Examples of a cycloalkynyl group having a substituent include a methylcyclohexynyl group and an ethylcyclohexynyl group.

The "alkyloxy group" may be linear or branched. The alkyloxy group may have a substituent. The number of carbon atoms of the alkyloxy group is usually 1 to 30 and preferably 12 to 19 without including the number of carbon atoms of the substituent.

Examples of the alkyloxy group include alkyloxy groups having no substituent, such as a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, a 3-heptyldodecyloxy group, and a lauryloxy group, and a group in which a hydrogen atom in these groups is substituted with a substituent such as an alkyloxy group, an aryl group, or a fluorine atom.

A cycloalkyl group included in the "cycloalkyloxy group" may be a monocyclic group or a polycyclic group. The cycloalkyloxy group may have a substituent. The number of carbon atoms of the cycloalkyloxy group is usually 3 to 30 and preferably 12 to 19 without including the number of carbon atoms of the substituent.

Examples of the cycloalkyloxy group include cycloalkyloxy groups having no substituent, such as a cyclopentyloxy group, a cyclohexyloxy group, and a cycloheptyloxy group, and a group in which a hydrogen atom in these groups is substituted with a substituent such as a fluorine atom or an alkyl group.

The "alkylthio group" may be linear or branched. The alkylthio group may have a substituent. The number of carbon atoms of the alkylthio group is usually 1 to 30 and preferably 12 to 19 without including the number of carbon atoms of the substituent.

Examples of an alkylthio group that may have a substituent include a methylthio group, an ethylthio group, a propylthio group, an isopropylthio group, a butylthio group, an isobutylthio group, a tert-butylthio group, a pentylthio group, a hexylthio group, a heptylthio group, an octylthio group, a 2-ethylhexylthio group, a nonylthio group, a decylthio group, a 3,7-dimethyloctylthio group, a 3-heptyldodecylthio group, a laurylthio group, and a trifluoromethylthio group.

A cycloalkyl group included in the "cycloalkylthio group" may be a monocyclic group or a polycyclic group. The cycloalkylthio group may have a substituent. The number of carbon atoms of the cycloalkylthio group is usually 3 to 30 and preferably 12 to 19 without including the number of carbon atoms of the substituent.

Examples of a cycloalkylthio group which may have a substituent include a cyclohexylthio group.

A "p-valent aromatic carbocyclic group" means a remaining atomic group obtained by removing p hydrogen atoms directly bonded to carbon atoms constituting a ring from an aromatic hydrocarbon which may have a substituent. The p-valent aromatic carbocyclic group may have a substituent.

The "aryl group" means a monovalent aromatic carbocyclic group. The aryl group may have a substituent. The number of carbon atoms of the aryl group is usually 6 to 30 and preferably 6 to 10 without including the number of carbon atoms of the substituent.

Examples of the aryl group include aryl groups having no substituent, such as a phenyl group, a 1-naphthyl group, a 2-naphthyl group, a 1-anthracenyl group, a 2-anthracenyl group, a 9-anthracenyl group, 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, and a 4-phenylphenyl group, a group in which a hydrogen atom in these groups is substituted with a substituent such as an alkyl group, an alkyloxy group, an aryl group, or a fluorine atom.

The "aryloxy group" may have a substituent. The number of carbon atoms of the aryloxy group is usually 6 to 30 and preferably 6 to 10 without including the number of carbon atoms of the substituent.

Examples of the aryloxy group include aryloxy groups having no substituent, such as a phenoxy group, a 1-naphthyloxy group, a 2-naphthyloxy group, a 1-anthracenyloxy group, a 9-anthracenyloxy group, and a 1-pyrenyloxy group, and a group in which a hydrogen atom in these groups is substituted with a substituent such as an alkyl group, an alkyloxy group, or a fluorine atom.

The "arylthio group" may have a substituent. The number of carbon atoms of the arylthio group is usually 6 to 30 and preferably 6 to 10 without including the number of carbon atoms of the substituent.

Examples of an arylthio group which may have a substituent include a phenylthio group, a C1-C12 alkyloxyphenylthio group, a C1-C12 alkylphenylthio group, a 1-naphthylthio group, a 2-naphthylthio group, and a pentafluorophenylthio group. The "C1-C12 alkyl" indicates that the number of carbon atoms thereof is 1 to 12. Furthermore, "Cm-Cn alkyl" indicates that the number of carbon atoms is m to n. The same applies to the following.

The "p-valent heterocyclic group" (p represents an integer of 1 or more) means a remaining atomic group obtained by removing p hydrogen atoms among hydrogen atoms directly bonded to carbon atoms or heteroatoms constituting a ring from a heterocyclic compound which may have a substituent. A "p-valent aromatic heterocyclic group" is included in the "p-valent heterocyclic group". The "p-valent aromatic heterocyclic group" means a remaining atomic group obtained by removing p hydrogen atoms among hydrogen atoms directly bonded to carbon atoms or heteroatoms constituting a ring from an aromatic heterocyclic compound which may have a substituent.

The aromatic heterocyclic compound includes a compound in which an aromatic ring is fused to a heterocyclic ring even when the heterocyclic ring itself does not exhibit aromaticity, in addition to a compound in which a heterocyclic ring itself exhibits aromaticity.

Among the aromatic heterocyclic compounds, specific examples of the compound in which a heterocyclic ring itself exhibits aromaticity include oxadiazole, thiadiazole, thiazole, oxazole, thiophene, pyrrole, phosphole, furan, pyridine, pyrazine, pyrimidine, triazine, pyridazine, quinoline, isoquinoline, carbazole, and dibenzophosphole.

Among the aromatic heterocyclic compounds, specific examples of the compound in which an aromatic ring is fused to a heterocyclic ring even when the aromatic heterocyclic ring itself does not exhibit aromaticity include phenoxazine, phenothiazine, dibenzoborole, dibenzosilole, and benzopyran.

The p-valent heterocyclic group may have a substituent. The number of carbon atoms of the p-valent heterocyclic group is usually 2 to 30 and preferably 2 to 6 without including the number of carbon atoms of the substituent.

Examples of the monovalent heterocyclic group include a monovalent aromatic heterocyclic group (for example, a thienyl group, a pyrrolyl group, a furyl group, a pyridyl group, a quinolyl group, an isoquinolyl group, a pyrimidinyl group, and a triazinyl group), a monovalent non-aromatic heterocyclic group (for example, a piperidyl group, and a piperazyl group), and a group in which a hydrogen atom in these groups is substituted with a substituent such as an alkyl group, an alkyloxy group, or a fluorine atom.

The "substituted amino group" means an amino group having a substituent. As the substituent of the amino group, an alkyl group, an aryl group, and a monovalent heterocyclic group are preferable. The number of carbon atoms of the substituted amino group is usually 1 to 30 without including the number of carbon atoms of the substituent.

Examples of the substituted amino group include a dialkylamino group (for example, a dimethylamino group and a diethylamino group), and a diarylamino group (for example, a diphenylamino group, a bis(4-methylphenyl)amino group, a bis(4-tert-butylphenyl)amino group, and a bis(3,5-di-tert-butylphenyl)amino group).

The "acyl group" may have a substituent. The number of carbon atoms of the acyl group is usually 2 to 20 and preferably 2 to 18 without including the number of carbon atoms of the substituent. Specific examples of the acyl group include an acetyl group, a propionyl group, a butyryl group, an isobutyryl group, a pivaloyl group, a benzoyl group, a

trifluoroacetyl group, and a pentafluorobenzoyl group.

The "imine residue" means a remaining atomic group obtained by removing one hydrogen atom directly bonded to a carbon atom or a nitrogen atom constituting a carbon atom-nitrogen atom double bond from an imine compound. The "imine compound" means an organic compound having a carbon atom-nitrogen atom double bond in the molecule. Examples of the imine compound include aldimine, ketimine, and a compound in which a hydrogen atom bonded to a nitrogen atom constituting a carbon atom-nitrogen atom double bond in aldimine is substituted with an alkyl group or the like.

The number of carbon atoms of the imine residue is usually 2 to 20 and preferably 2 to 18. Examples of the imine residue include a group represented by the following structural formula.

[Chem. 9]

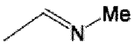
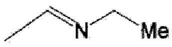
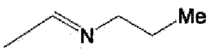
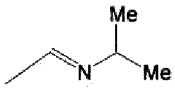
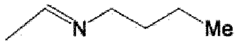
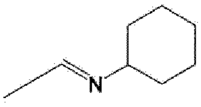
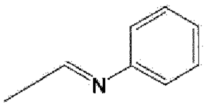
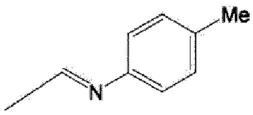
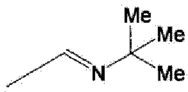
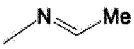
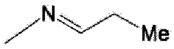
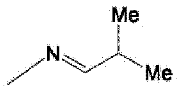
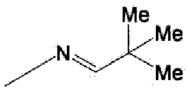
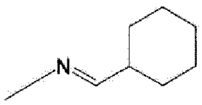
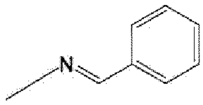
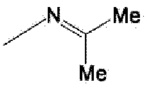
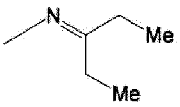
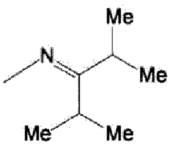
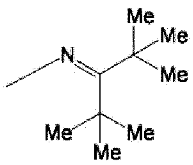
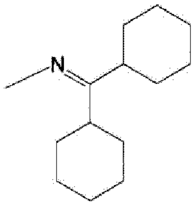
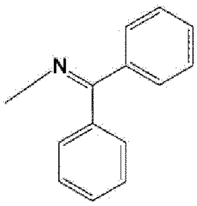
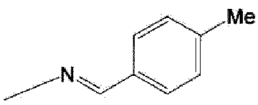
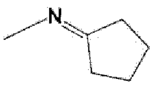
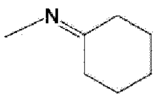

The "amide group" means a remaining atomic group obtained by removing one hydrogen atom bonded to a nitrogen atom from an amide. The number of carbon atoms of the amide group is usually 1 to 20 and preferably 1 to 18. Specific examples of the amide group include a formamide group, an acetamide group, a propioamide group, a butyroamide group, a benzamide group, a trifluoroacetamide group, a pentafluorobenzamide group, a diformamide group, a diacetamide group, a dipropioamide group, a dibutyroamide group, a dibenzamide group, a ditrifluoroacetamide group, and a dipentafluorobenzamide group.

The "acid imide group" means a remaining atomic group obtained by removing one hydrogen atom bonded to a nitrogen atom from an acid imide. The number of carbon atoms of the acid imide group is usually 4 to 20. Specific examples of the acid imide group include a group represented by the following structural formula.

[Chem. 10]

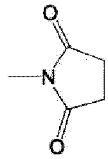
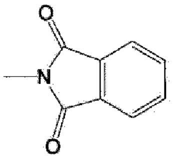
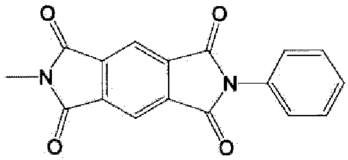
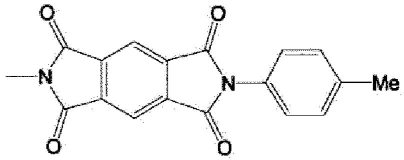
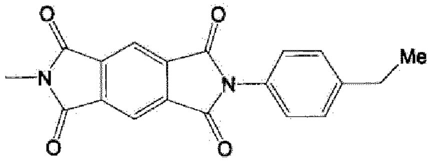
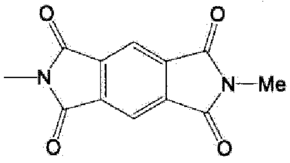
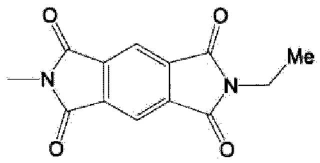
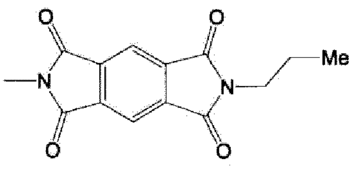
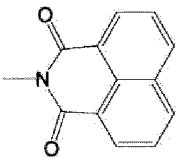
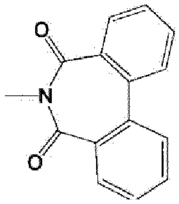

The "substituted oxycarbonyl group" means a group represented by R'-O-(C=O)-.

Here, R' represents an alkyl group, a cycloalkyl group, an aryl group, an arylalkyl group, or a monovalent heterocyclic group, and these groups may have a substituent.

The number of carbon atoms of the substituted oxycarbonyl group is usually 2 to 60 and preferably 2 to 48 without including the number of carbon atoms of the substituent.

Specific examples of the substituted oxycarbonyl group include a methoxycarbonyl group, an ethoxycarbonyl group, a propoxycarbonyl group, an isopropoxycarbonyl group, a butoxycarbonyl group, an isobutoxycarbonyl group, a tert-butyloxycarbonyl group, a pentyloxycarbonyl group, a hexyloxycarbonyl group, a cyclohexyloxycarbonyl group, a heptyloxycarbonyl group, an octyloxycarbonyl group, a 2-ethylhexyloxycarbonyl group, a nonyloxycarbonyl group, a decyloxycarbonyl group, a 3,7-dimethyloctyloxycarbonyl group, a dodecyloxycarbonyl group, a trifluoromethoxycarbonyl group, a pentafluoroethoxycarbonyl group, a perfluorobutoxycarbonyl group, a perfluorohexyloxycarbonyl group, a perfluorooctyloxycarbonyl group, a phenoxycarbonyl group, a naphthoxycarbonyl group, and a pyridyloxycarbonyl group.

The "alkylsulfonyl group" may be linear or branched. The alkylsulfonyl group may have a substituent. The number of carbon atoms of the alkylsulfonyl group is usually 1 to 30 without including the number of carbon atoms of the substituent. Specific examples of the alkylsulfonyl group include a methylsulfonyl group, an ethylsulfonyl group, and a dodecylsulfonyl group.

"*" represents a bond. "*" representing a bond may be omitted.

[1. Photodetector]

A photodetector according to an embodiment of the present invention includes a first electrode, a second electrode, and an active layer provided between the first electrode and the second electrode, and the active layer contains a p-type semiconductor material (electron-donating compound) and an n-type semiconductor material (electron-accepting compound). One kind of a p-type semiconductor material or a combination of two or more kinds of p-type semiconductor materials may be contained in the active layer. In addition, one kind of an n-type semiconductor material or a combination of two or more kinds of n-type semiconductor materials may be contained in the active layer.

[1.1. First Embodiment]

In a photodetector according to a first embodiment, the p-type semiconductor material contains a polymer having the highest occupied molecular orbital (HOMO) of -5.45 eV or less, and the n-type semiconductor material contains a non-fullerene compound.

Hereinafter, the photodetector according to the embodiment of the present invention will be described with

reference to the drawings. Note that the drawings merely schematically illustrate the shape, size, and arrangement of constituent elements to the extent that the invention can be understood. The present invention is not limited by the following description, and each constituent element can be appropriately changed without departing from the gist of the present invention. In addition, the configuration according to the embodiment of the present invention is not necessarily made or used in the arrangement illustrated in the drawings.

Here, a configuration example that can be taken by the photodetector of the present embodiment will be described. Fig. 1 is a view schematically illustrating the configuration of the photodetector of the present embodiment.

As illustrated in Fig. 1, a photodetector 10 is provided on a support substrate 11. The photodetector 10 includes a first electrode 12 provided so as to be in contact with the support substrate 11, a hole transport layer 13 provided so as to be in contact with the first electrode 12, an active layer 14 provided so as to be in contact with the hole transport layer 13, an electron transport layer 15 provided so as to be in contact with the active layer 14, and a second electrode 16 provided so as to be in contact with the electron transport layer 15. In this configuration example, a sealing member 17 is further provided so as to be in contact with the second electrode 16.

[1.1.1. Active Layer]

First, the active layer will be described.

(p-Type Semiconductor Material)

The p-type semiconductor material contains a polymer having a HOMO with an energy level value of -5.45 eV or less. As the energy level value of the HOMO of the polymer, a value measured by ultraviolet photoelectron spectroscopy (UPS method) can be used. Here, the UPS method refers to a method in which a solid surface to be measured is irradiated with ultraviolet rays, the number of photoelectrons emitted with respect to the energy of the irradiated ultraviolet rays is measured, the minimum energy generated by the photoelectrons is calculated, and a work function in a case of a metal and an energy level value of a HOMO in a case of a semiconductor are estimated from the minimum energy. The ultraviolet photoelectron spectroscopy can be performed using a photoelectron spectrometer in the atmosphere.

Since various materials are known and available as the p-type semiconductor material, a polymer having a HOMO with an energy level value of -5.45 eV or less can be selected from these materials.

The energy level value of the HOMO of the polymer contained in the p-type semiconductor material is preferably -5.50 eV or less and more preferably -5.58 eV or less.

As the polymer, a polymer containing a constitutional unit DU having an electron donating property and a constitutional unit AU having an electron accepting property is preferable. Among the constitutional units contained in the polymer, which is the constitutional unit DU and which is the constitutional unit AU can be relatively determined from an energy level of a HOMO or the lowest unoccupied molecular orbital (LUMO) of the constitutional unit. Specifically, by comparing the energy levels of the HOMOs of the constitutional units contained in the polymer, it can be determined that a constitutional unit having a high energy level of a HOMO is the constitutional unit DU having an electron donating property, and a constitutional unit having a low energy level of a HOMO is the constitutional unit AU having an electron accepting property. Alternatively, by comparing the energy levels of the LUMOs of the constitutional units contained in the polymer, it can be determined that a constitutional unit having a high energy level of a LUMO is the constitutional unit DU having an electron donating property, and a constitutional unit having a low energy level of a LUMO is the constitutional unit AU having an electron accepting property.

In addition, the polymer is more preferably a $\pi$ conjugated polymer compound containing a constitutional unit DU having an electron donating property and a constitutional unit AU having an electron accepting property. In the $\pi$ conjugated polymer compound, usually, the constitutional unit DU is a constitutional unit in which $\pi$ electrons are excessive, and the constitutional unit AU is a constitutional unit in which $\pi$ electrons are deficient.

The polymer may contain a constitutional unit in which a constitutional unit DU and a constitutional unit AU are directly bonded, or may contain a constitutional unit in which a constitutional unit DU and a constitutional unit AU are bonded via any other suitable constitutional unit.

The constitutional unit DU preferably includes one or more pairs of atoms $\pi$-bonded to each other. $DUD_{max}$ is preferably 0.05 or more, more preferably 0.4 or more, still more preferably 0.5 or more, and still more preferably 0.8 or more, under a condition in which Expression (a): $DUD_{max} - AUD_{max} > 0$ is satisfied, in which $DUD_{max}$ is a maximum value among absolute values of differences in electronegativity of the pairs of atoms included in the constitutional unit DU and $\pi$-bonded to each other. The definition of $AUD_{max}$ will be described below.

Note that in the present specification, the electronegativity means electronegativity as defined by Pauling.

Examples of the constitutional unit DU including one or more pairs of atoms include a unit having a ketone structure, a unit having an imine structure (carbon-nitrogen double bond), a unit having a sulfoxide structure, and a unit having a sulfone structure.

Examples of the unit having a ketone structure, the unit having an imine structure, the unit having a sulfoxide structure, or the unit having a sulfone structure include a constitutional unit represented by the following Formula (I). The constitutional unit DU is preferably a constitutional unit represented by the following Formula (I) .

[Chem. 11]

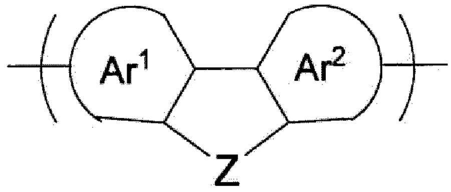

( I )

In Formula (I), $Ar^1$ and $Ar^2$ each independently represent an aromatic carbocyclic ring which may have a substituent or an aromatic heterocyclic ring which may have a substituent. Each of the aromatic carbocyclic ring and the aromatic heterocyclic ring may be a single ring or a fused ring. In a case where the aromatic carbocyclic ring or the aromatic heterocyclic ring is a fused ring, all of the rings constituting the fused ring may be a fused ring having aromaticity, or only some rings constituting the fused ring may be a fused ring having aromaticity. In a case where these groups have a plurality of substituents, these substituents may be the same as or different from each other.

Specific examples of the aromatic carbocyclic ring which may have a substituent as $Ar^1$ or $Ar^2$ include a benzene ring, a naphthalene ring, an anthracene ring, a tetracene ring, a pentacene ring, a pyrene ring, and a phenanthrene ring, a benzene ring and a naphthalene ring are preferable, and a benzene ring is more preferable. These rings may have a substituent.

The aromatic heterocyclic ring which may have a substituent as $Ar^1$ or $Ar^2$ includes a ring in which an aromatic ring is fused to a heterocyclic ring even when the heterocyclic ring itself constituting the ring does not exhibit aromaticity, in addition to a monocyclic ring and a fused ring in which a heterocyclic ring itself exhibits aromaticity.

Specific examples of the aromatic heterocyclic ring include ring structures having the above-described compound as an aromatic heterocyclic compound, and include an oxadiazole ring, a thiadiazole ring, a thiazole ring, an oxazole ring, a thiophene ring, a pyrrole ring, a phosphole ring, a furan ring, a pyridine ring, a pyrazine ring, a pyrimidine ring, a triazine ring, a pyridazine ring, a quinoline ring, an isoquinoline ring, a carbazole ring, a dibenzophosphole ring, a phenoxazine ring, a phenothiazine ring, a dibenzoborole ring, a dibenzosilole ring, and a benzopyran ring. These rings may have a substituent.

As a combination of $Ar^1$ and $Ar^2$, both $Ar^1$ and $Ar^2$ are preferably aromatic carbocyclic rings which may have a substituent (for example, a benzene ring) or aromatic heterocyclic rings which may have a substituent (for example, a thiophene ring).

Both $Ar^1$ and $Ar^2$ are preferably the same as or different from each other, and are aromatic heterocyclic rings which may have a substituent.

Z represents a group represented by any one of the following Formulas (Z-1) to (Z-4).

[Chem. 12]

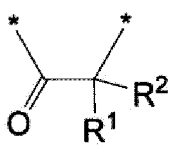

(Z-1)

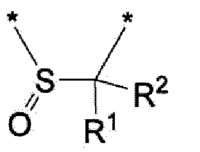

(Z-2)

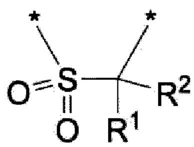

(Z-3)

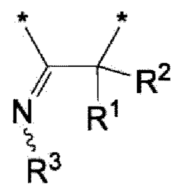

(Z-4)

$R^1$, $R^2$, and $R^3$ each independently represent a hydrogen atom, a halogen atom, an alkyl group which may have a substituent, a cycloalkyl group which may have a substituent, an alkenyl group which may have a substituent, a cycloalkenyl group which may have a substituent, an alkynyl group which may have a substituent, a cycloalkynyl group which may have a substituent, an alkyloxy group which may have a substituent, an alkylthio group which may have a substituent, an aryl group which may have a substituent, an aryloxy group which may have a substituent, an arylthio group which may have a substituent, a monovalent heterocyclic group which may have a substituent, a group represented by $-C(=O)-R^a$, or a group represented by $-SO_2-R^b$, and

$R^a$ and $R^b$ each independently represent a hydrogen atom, an alkyl group which may have a substituent, an aryl group which may have a substituent, an alkyloxy group which may have a substituent, an aryloxy group which may have a substituent, or a monovalent heterocyclic group which may have a substituent. In a case where these groups have a plurality of substituents, these substituents may be the same as or different from each other.

Examples and specific examples of the respective groups represented by $R^1$ to $R^3$ are the same as the examples and the specific examples in "Description of Terms".

Both $R^1$ and $R^2$ are preferably the same as or different from each other and are alkyl groups which may have a substituent or aryl groups which may have a substituent, and both $R^1$ and $R^2$ are more preferably the same as or different from each other and are alkyl groups which have 1 to 30 carbon atoms and may have a substituent. Here, the number of carbon atoms of the alkyl group does not include the number of carbon atoms of the substituent.

More preferably, $R^1$ and $R^2$ are each independently an ethyl group, an octyl group, a decyl group, a dodecyl group, a pentadecyl group, an octadecyl group, a 3-methylbutyl group, a 2-ethylhexyl group, a 3,7-dimethyloctyl group, a 3,7,11-trimethyldodecyl group, or a 3-heptyldodecyl group.

$R^3$ is preferably an alkyl group which may have a substituent or an aryl group which may have a substituent, and more preferably an aryl group which may have a substituent.

The constitutional unit DU is preferably a unit having a ketone structure, and more preferably a constitutional unit represented by Formula (I), in which Z is a group represented by Formula (Z-1).

Specific examples of the constitutional unit represented by Formula (I) in which Z is a group represented by Formula (Z-1) include groups represented by the following Formulas (1) to (5) and groups represented by Formulas (101) to (116) described below.

[Chem. 13]

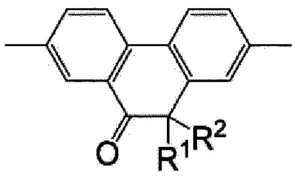

(1)

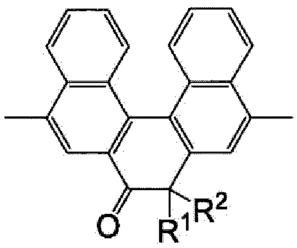

(2)

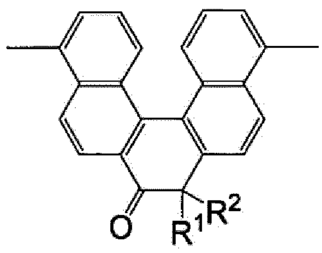

(3)

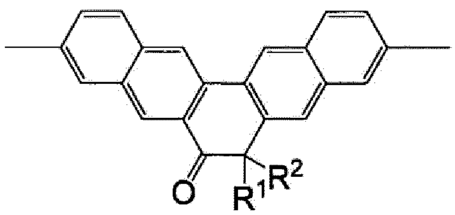

(4)

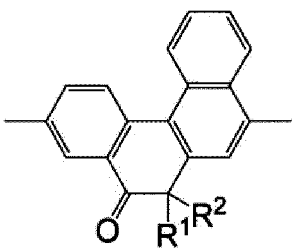

(5)

In Formulas (1) to (5), $R^1$ and $R^2$ are the same as described above.

The constitutional unit DU is preferably a constitutional unit having a ketone structure and represented by the following Formula (II).

[Chem. 14]

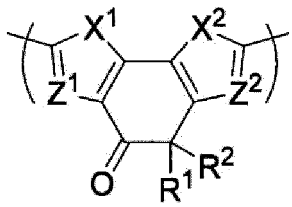

( I I )

In Formula (II), $X^1$ and $X^2$ each independently represent a sulfur atom or an oxygen atom.

$Z^1$ and $Z^2$ each independently represent a group represented by $=C(-R^4)-$ or a nitrogen atom.

$R^1$ and $R^2$ are the same as the above definitions in Formula (I). Examples and preferred examples of $R^1$ and $R^2$ are the same as the examples and preferred examples of $R^1$ and $R^2$ in Formula (I).

$R^4$ represents a hydrogen atom, a halogen atom, an alkyl group which may have a substituent, a cycloalkyl group which may have a substituent, an alkenyl group which may have a substituent, a cycloalkenyl group which may have a substituent, an alkynyl group which may have a substituent, a cycloalkynyl group which may have a substituent, an alkyloxy group which may have a substituent, an alkylthio group which may have a substituent, an aryl group which may have a substituent, an aryloxy group which may have a substituent, an arylthio group which may have a substituent, a monovalent heterocyclic group which may have a substituent, a group represented by $-C(=O)-R^a$, or a group represented by $-SO_2-R^b$, and $R^a$ and $R^b$ each independently represent a hydrogen atom, an alkyl group which may have a substituent, an aryl group which may have a substituent, an alkyloxy group which may have a substituent, an aryloxy group which may have a substituent, or a monovalent heterocyclic group which may have a substituent. In a case where these groups have a plurality of substituents, these substituents may be the same as or different from each other.

Examples and specific examples of the respective groups represented by $R^4$ are the same as the examples and the specific examples in "Description of Terms".

$R^4$ is preferably a hydrogen atom or an alkyl group, and more preferably a hydrogen atom.

Examples of the constitutional unit represented by Formula (II) include groups represented by the following Formulas (101) to (116). In Formulas (101) to (116), $R^1$ and $R^2$ are the same as described above.

[Chem. 15]

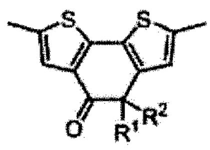

(101)

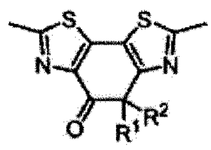

(102)

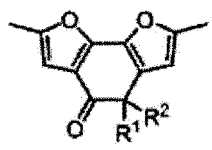

(103)

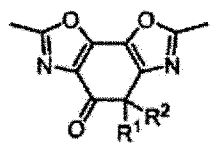

(104)

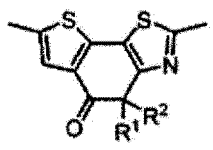

(105)

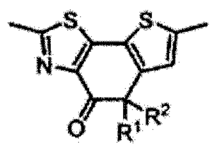

(106)

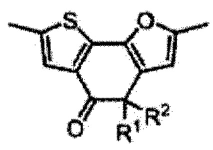

(107)

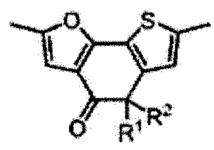

(108)

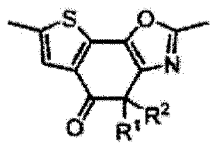

(109)

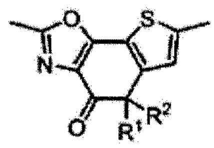

(110)

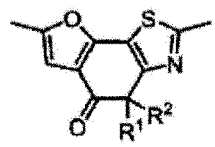

(111)

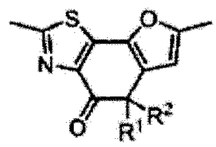

(112)

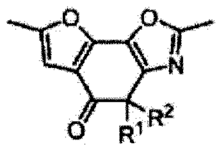

(113)

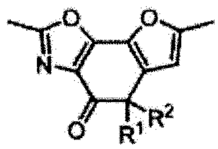

(114)

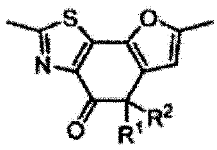

(115)

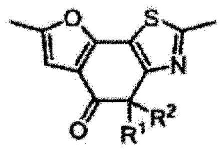

(116)

In Formula (II), both $X^1$ and $X^2$ are preferably sulfur atoms. Both $Z^1$ and $Z^2$ are preferably groups represented by =CH-. More preferably, both $X^1$ and $X^2$ are sulfur atoms, and both $Z^1$ and $Z^2$ are groups represented by =CH-.

The constitutional unit represented by Formula (II) is preferably a group represented by Formula (101), Formula (102), Formula (105), or Formula (106), more preferably a group represented by Formula (101) or Formula (102), and still more preferably a group represented by Formula (101).

The constitutional unit AU preferably includes one or more pairs of atoms $\pi$-bonded to each other. $AUD_{max}$ is preferably less than 0.7, more preferably less than 0.3, still more preferably less than 0.1, and still more preferably less than 0.04, under a condition in which Expression (a) : $DUD_{max} - AUD_{max} > 0$ is satisfied, in which $AUD_{max}$ is a maximum value among absolute values of differences in electronegativity of the pairs of atoms included in the constitutional unit AU and $\pi$-bonded to each other. The definition of $DUD_{max}$ is as described above.

It is preferable that the constitutional unit AU does not have any one of a ketone structure, a sulfoxide structure (-S(=O)-), and a sulfone structure (-$SO_2$-). Examples of the constitutional unit AU include a group represented by any one of the following Formulas (AU101) to (AU172) and (AU178) to (AU185), and a group in which a hydrogen atom in this group is substituted with a substituent. In Formulas (AU101) to (AU172) and (AU178) to (AU185), R represents a hydrogen atom or a substituent.

[Chem. 16]

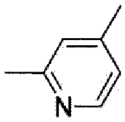

(AU101)

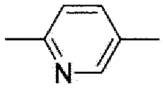

(AU102)

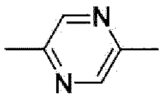

(AU103)

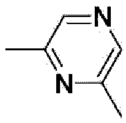

(AU104)

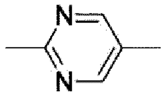

(AU105)

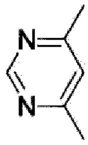

(AU106)

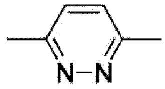

(AU107)

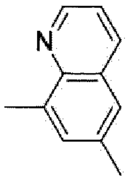

(AU108)

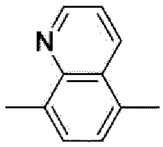

(AU109)

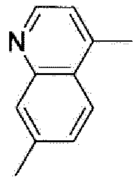

(AU110)

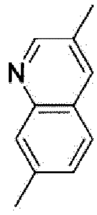

(AU111)

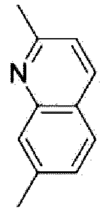

(AU112)

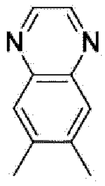

(AU113)

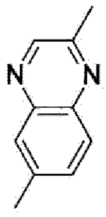

(AU114)

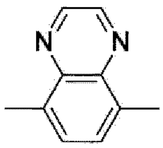

(AU115)

[Chem. 17]

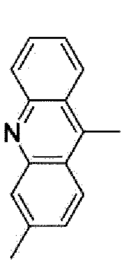
(AU116)

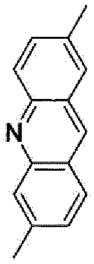
(AU117)

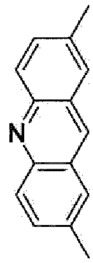
(AU118)

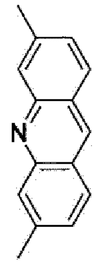
(AU119)

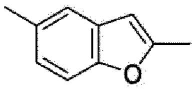
(AU120)

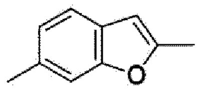
(AU121)

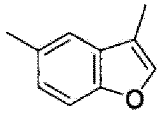
(AU122)

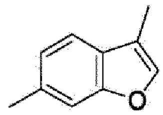
(AU123)

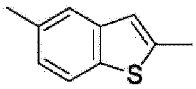
(AU124)

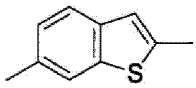
(AU125)

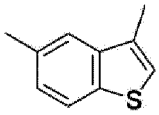
(AU126)

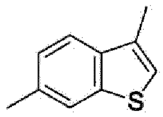
(AU127)

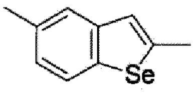
(AU128)

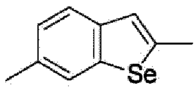
(AU129)

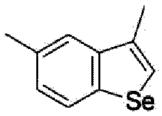
(AU130)

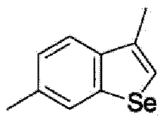
(AU131)

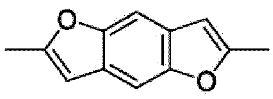
(AU132)

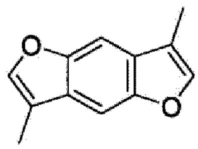
(AU133)

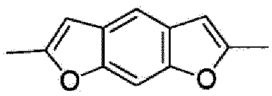
(AU134)

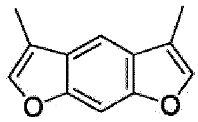
(AU135)

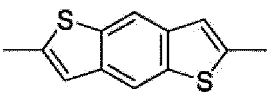
(AU136)

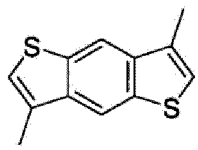
(AU137)

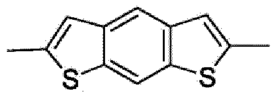
(AU138)

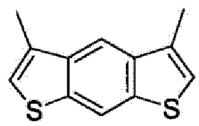
(AU139)

[Chem. 18]

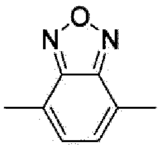
(AU140)

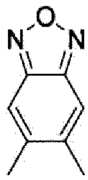
(AU141)

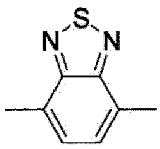
(AU142)

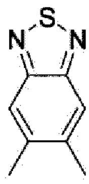
(AU143)

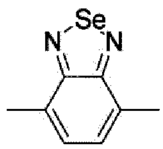
(AU144)

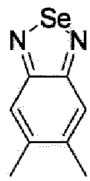
(AU145)

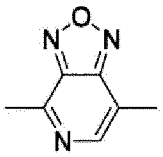
(AU146)

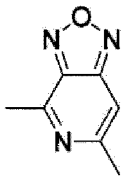
(AU147)

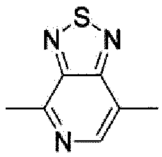
(AU148)

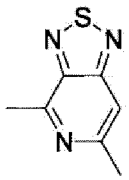
(AU149)

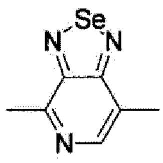
(AU150)

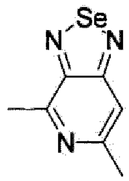
(AU151)

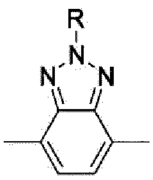
(AU152)

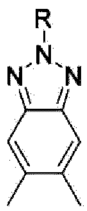
(AU153)

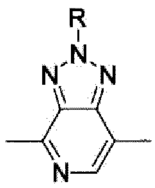
(AU154)

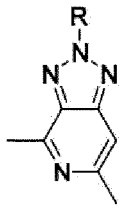
(AU155)

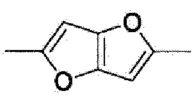
(AU156)

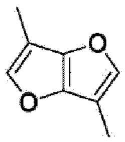
(AU157)

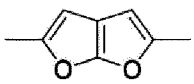
(AU158)

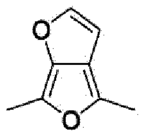
(AU159)

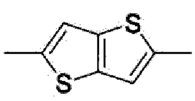
(AU160)

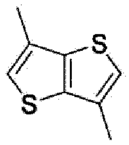
(AU161)

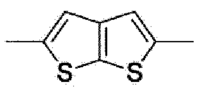
(AU162)

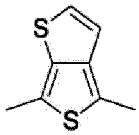
(AU163)

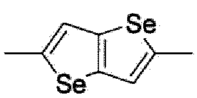
(AU164)

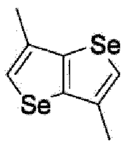
(AU165)

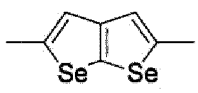
(AU166)

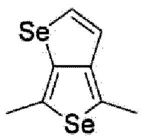
(AU167)

[Chem. 19]

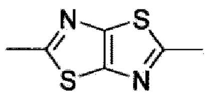 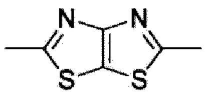 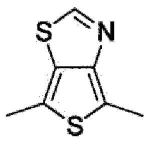 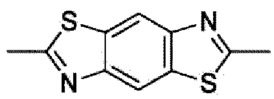 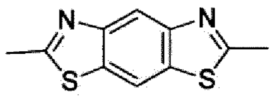

(AU168) (AU169) (AU170) (AU171) (AU172)

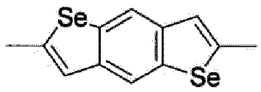 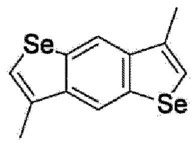 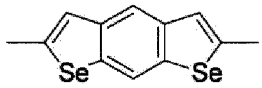 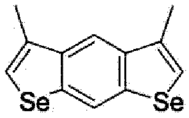

(AU178) (AU179) (AU180) (AU181)

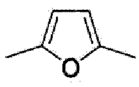 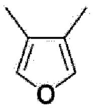 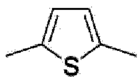 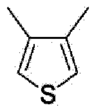

(AU182) (AU183) (AU184) (AU185)

The constitutional unit AU is preferably a group represented by any one of Formula (AU115), Formula (AU136), Formula (AU140), Formulas (AU142) to (AU160), and Formulas (AU163) to (AU172), and more preferably a constitutional unit represented by Formula (AU142) or Formula (AU160).

In a case where the polymer that can be contained in the p-type semiconductor material contains the constitutional unit DU and the constitutional unit AU, when the amount of all constitutional units contained in the polymer is 100 mol%, the total amount of the constitutional unit DU and the constitutional unit AU is preferably 20 mol% or more, more preferably 40 mol% or more, and still more preferably 50 mol%, in terms of improving charge transportability as the p-type semiconductor material, but is usually 100 mol% or less, and may be 100 mol%.

In an embodiment, the polymer that can be contained in the p-type semiconductor material preferably contains a group represented by Formula (101), a group represented by Formula (AU115), a group represented by Formula (AU136), a group represented by Formula (AU140), a group represented by Formula (AU142), a group represented by Formula (AU148), a group represented by Formula (AU152), a group represented by Formula (AU154), or a group represented by Formula (AU160).

In another embodiment, the polymer that can be contained in the p-type semiconductor material preferably contains a group represented by Formula (102), a group represented by Formula (AU115), a group represented by Formula (AU136), a group represented by Formula (AU140), a group represented by Formula (AU142), a group represented by Formula (AU148), a group represented by Formula (AU152), a group represented by Formula (AU154), or a group represented by Formula (AU160).

In still another embodiment, the polymer that can be contained in the p-type semiconductor material preferably contains a group represented by Formula (103), a group represented by Formula (AU115), a group represented by Formula (AU136), a group represented by Formula (AU140), a group represented by Formula (AU142), a group represented by Formula (AU148), a group represented by Formula (AU152), a group represented by Formula (AU154), or a group represented by Formula (AU160).

In still another embodiment, the polymer that can be contained in the p-type semiconductor material preferably contains a group represented by Formula (104), a group represented by Formula (AU115), a group represented by Formula (AU136), a group represented by Formula (AU140), a group represented by Formula (AU142), a group represented by Formula (AU148), a group represented by Formula (AU152), a group represented by Formula (AU154), or a group represented by Formula (AU160).

The polymer that can be contained in the p-type semiconductor material is particularly preferably a polymer represented by the following formula.

[Chem. 20]

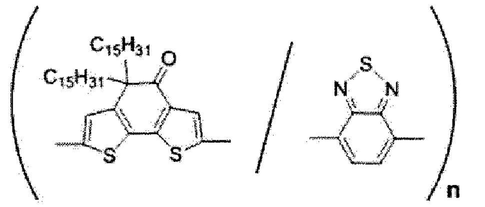

P − 1

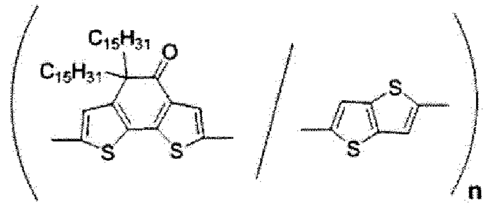

P − 2

In the p-type semiconductor material that can be contained in the active layer, a weight ratio of the polymer is preferably 90 wt% or more, more preferably 95 wt% or more, and still more preferably 98 wt% or more, but is usually 100 wt% or less, and may be 100 wt%.

(n-Type Semiconductor Material)

The n-type semiconductor material that can be contained in the active layer of the present embodiment contains a non-fullerene compound. Since a large number of compounds are known and commercially available as the non-fullerene compound that can be applied to the n-type semiconductor material, a non-fullerene compound can be appropriately selected from these compounds and applied as the n-type semiconductor material of the present embodiment.
The non-fullerene compound that can be contained in the n-type semiconductor material preferably contains a moiety DP having an electron donating property and a moiety AP having an electron accepting property.
More preferably, in the non-fullerene compound that can be contained in the n-type semiconductor material, the moiety DP includes one or more pairs of atoms π-bonded to each other, and among absolute values of differences in electronegativity of the pairs of atoms π-bonded to each other, a maximum value is represented by $DPD_{max}$, the moiety AP includes one or more pairs of atoms π-bonded to each other, and among absolute values of differences in electronegativity of the pairs of atoms π-bonded to each other, a maximum value is represented by $APD_{max}$, and the following Expression (b):

$$APD_{max} - DPD_{max} > 0 \quad (b)$$

is satisfied.
$APD_{max}$ is preferably 0.05 or more, more preferably 0.4 or more, still more preferably 0.5 or more, and still more preferably 0.8 or more, under the condition in which Expression (b) is satisfied.
$DPD_{max}$ is preferably less than 0.7, more preferably less than 0.3, still more preferably less than 0.1, and still more preferably less than 0.04, under the condition in which Expression (b) is satisfied.
It is preferable that the moiety DP does not have any one of a ketone structure, a sulfoxide structure, and a sulfone structure. Examples of the moiety AP include a moiety having a ketone structure, an imine structure, a sulfoxide structure, or a sulfone structure.
The non-fullerene compound that can be contained in the n-type semiconductor material is preferably a compound represented by the following Formula (III).

$$A^1\text{-}B^{10}\text{-}A^2 \qquad (III)$$

In Formula (III), $A^1$ and $A^2$ each independently represent an electron-withdrawing group, and $B^{10}$ represents a group having a n-conjugated system.
The π-conjugated system means a system in which π electrons are delocalized to a plurality of bonds.
Examples of the electron-withdrawing group represented by $A^1$ or $A^2$ include a group represented by -$CH=C(-CN)_2$ or any one of the following Formulas (a-1) to (a-9).

[Chem. 21]

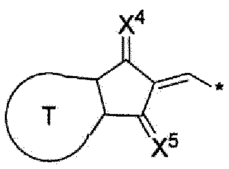

(a-1)

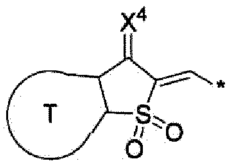

(a-2)

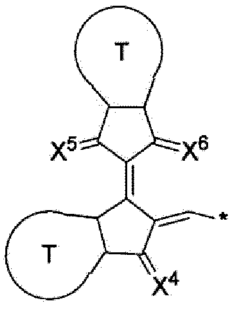

(a-3)

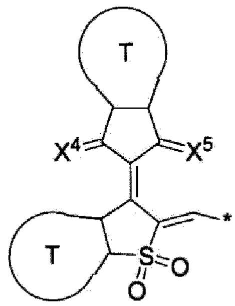

(a-4)

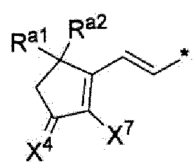

(a-5)

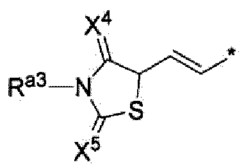

(a-6)

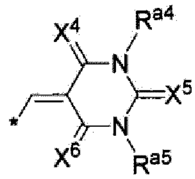

(a-7)

In Formula (a-1) to Formula (a-7),
T represents a carbocyclic ring which may have a substituent or a heterocyclic ring which may have a substituent. Each of the carbocyclic ring and the heterocyclic ring may be a single ring or a fused ring. In a case where these rings have a plurality of substituents, these substituents may be the same as or different from each other.

Examples of the carbocyclic ring which is represented by T and may have a substituent include an aromatic carbocyclic ring, and an aromatic carbocyclic ring is preferable. Specific examples of the carbocyclic ring which is represented by T and may have a substituent include a benzene ring, a naphthalene ring, an anthracene ring, a tetracene ring, a pentacene ring, a pyrene ring, and a phenanthrene ring, a benzene ring, a naphthalene ring, and a phenanthrene ring are preferable, a benzene ring and a naphthalene ring are more preferable, and a benzene ring is still more preferable. These rings may have a substituent.

Examples of the heterocyclic ring which is represented by T and may have a substituent include an aromatic heterocyclic ring, and an aromatic carbocyclic ring is preferable. Specific examples of the heterocyclic ring which is represented by T and may have a substituent include a pyridine ring, a pyridazine ring, a pyrimidine ring, a pyrazine ring, a pyrrole ring, a furan ring, a thiophene ring, an imidazole ring, an oxazole ring, a thiazole ring, and a thienothiophene ring, a pyridine ring, a pyrazine ring, a thiazole ring, and a thiophene ring are preferable, and a thiophene ring is more preferable. These rings may have a substituent.

Examples of the substituent that can be included in the carbocyclic ring or the heterocyclic ring represented by T include a halogen atom, a cyano group, an alkyl group which may have a substituent, an alkyloxy group which may have a substituent, an aryl group which may have a substituent, and a monovalent heterocyclic group which may have a substituent, and it is preferably a fluorine atom and/or an alkyl group having 1 to 6 carbon atoms.

$X^4$, $X^5$, and $X^6$ each independently represent an oxygen atom, a sulfur atom, an alkylidene group, or a group represented by $=C(-CN)_2$, and each are preferably an oxygen atom, a sulfur atom, or a group represented by $=C(-CN)_2$.

$X^7$ represents a hydrogen atom, a halogen atom, a cyano group, an alkyl group which may have a substituent, an alkyloxy group which may have a substituent, an aryl group which may have a substituent, or a monovalent heterocyclic group which may have a substituent.

$R^{a1}$, $R^{a2}$, $R^{a3}$, $R^{a4}$, and $R^{a5}$ each independently represent a hydrogen atom, a halogen atom, an alkyl group which may have a substituent, an alkyloxy group which may have a substituent, an aryl group which may have a substituent, or a monovalent heterocyclic group which may have a substituent, and may be preferably an alkyl group which may have a substituent or an aryl group which may have a substituent. Examples and specific examples of the respective groups represented by $R^{a1}$ to $R^{a5}$ are the same as the examples and the specific examples in "Description of Terms".

[Chem. 22]

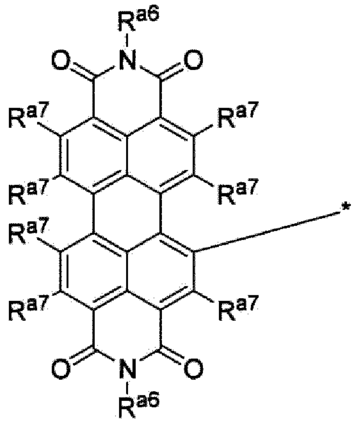

(a-8)

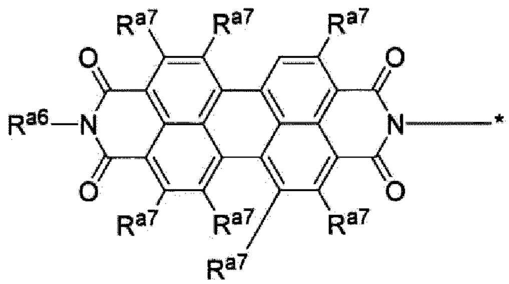

(a-9)

In Formula (a-8) and Formula (a-9),
$R^{a6}$ and $R^{a7}$ each independently represent a hydrogen atom, a halogen atom, an alkyl group which may have a substituent, a cycloalkyl group which may have a substituent, an alkyloxy group which may have a substituent, a cycloalkyloxy group which may have a substituent, a monovalent aromatic carbocyclic group which may have a substituent, or a monovalent aromatic heterocyclic group which may have a substituent, and a plurality of $R^{a6}$'s and a plurality of $R^{a7}$'s may be the same as or different from each other.

Examples and specific examples of the respective groups represented by $R^{a6}$ and $R^{a7}$ are the same as the examples and the specific examples in "Description of Terms".

The group represented by Formula (a-8) or Formula (a-9) contains a moiety AP having an electron accepting property and a moiety DP having an electron donating property.

The moiety AP and the moiety DP in Formula (a-8) and Formula (a-9) are shown in the following formulas.

[Chem. 23]

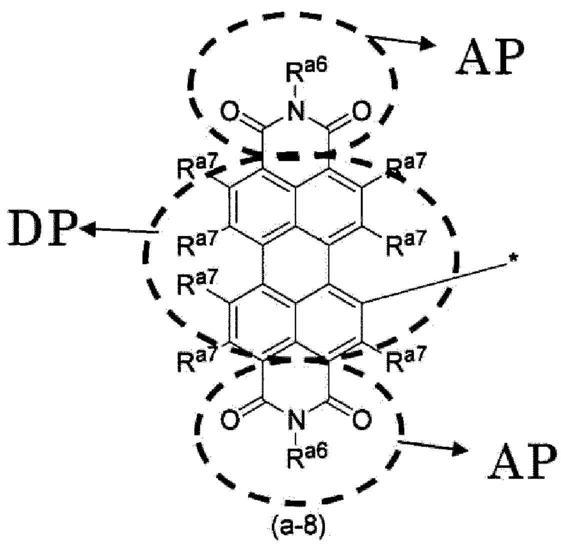


(a-8)

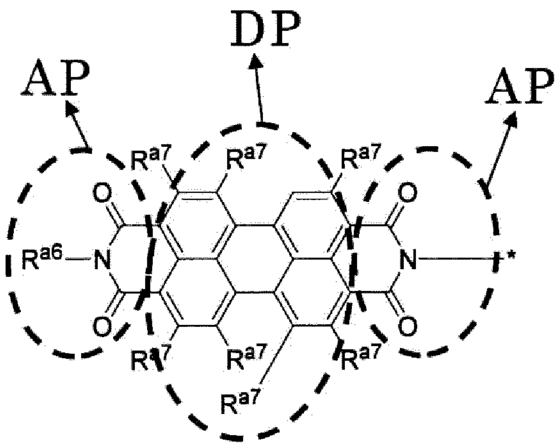


(a-9)

As the electron-withdrawing group represented by $A^1$ or $A^2$, the following group is preferable. Here, a plurality of R's each independently represent a hydrogen atom or a substituent, and preferably represent a hydrogen atom, a halogen atom, or an alkyl group. $R^{a3}$, $R^{a4}$, and $R^{a5}$ each independently represent the same meanings as described above, and preferably an alkyl group which may have a substituent or an aryl group which may have a substituent.

[Chem. 24]

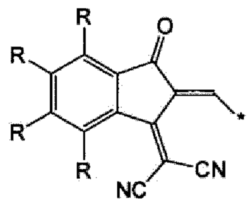

(a-1-1)

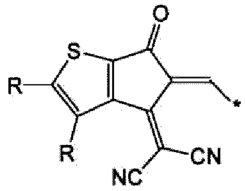

(a-1-2)

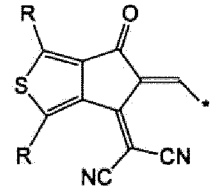

(a-1-3)

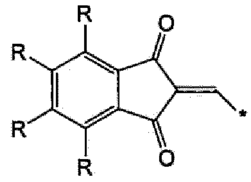

(a-1-4)

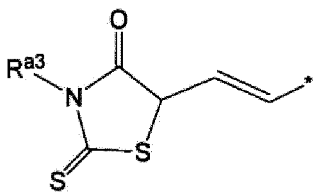

(a-6-1)

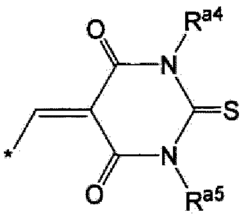

(a-7-1)

Examples of the group represented by $B^{10}$ and having a $\pi$-conjugated system include a group represented by $-(S^1)_{n1}-B^{11}-(S^2)_{n2}-$ in a compound represented by Formula (IV) described below. The definitions of $S^1$, $B^{11}$, $S^2$, n1, and n2 will be described below.

The non-fullerene compound that can be contained in the n-type semiconductor material is preferably a compound represented by the following Formula (IV).

$$A^1-(S^1)_{n1}-B^{11}-(S^2)_{n2}-A^2 \qquad (IV)$$

In Formula (IV),
$A^1$ and $A^2$ each independently represent an electron-withdrawing group. Examples and preferred examples of $A^1$ and $A^2$ are the same as the examples and preferred examples described in $A^1$ and $A^2$ in Formula (III).

$S^1$ and $S^2$ each independently represent a divalent carbocyclic group which may have a substituent, a divalent heterocyclic group which may have a substituent, a group represented by $-C(R^{s1})=C(R^{s2})-$ (where, $R^{s1}$ and $R^{s2}$ each independently represent a hydrogen atom or a substituent (preferably, a hydrogen atom, a halogen atom, an alkyl group which may have a substituent, an alkyl group which may have a substituent, an alkyloxy group which may have a substituent, a cyano group, an aryl group which may have a substituent, or a substituent, or a monovalent heterocyclic group which may have a substituent)), or a group represented by $-C \equiv C-$.

The divalent carbocyclic group which may have a substituent and the divalent heterocyclic group which may have a substituent may be fused rings, the divalent carbocyclic group and the divalent heterocyclic group being represented by $S^1$ or $S^2$. In a case where the divalent carbocyclic group or the divalent heterocyclic group has a plurality of substituents, these substituents may be the same as or different from each other.

Examples of the divalent carbocyclic group include a divalent aromatic carbocyclic group.

Examples of the divalent heterocyclic group include a divalent aromatic heterocyclic group.

In a case where the divalent aromatic carbocyclic group or the divalent aromatic heterocyclic group is a fused ring, all of the rings constituting the fused ring may be a fused ring having aromaticity, or only some rings constituting the fused ring may be a fused ring having aromaticity.

Examples of the constitutional unit AU as $S^1$ or $S^2$ include a group represented by any one of Formulas (AU101) to (AU172) and (AU178) to (AU185), and a group in which a hydrogen atom in this group is substituted with a substituent.

$S^1$ and $S^2$ preferably each independently represent a group represented by any one of the following Formulas (s-1) and (s-2).

[Chem. 25]

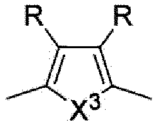

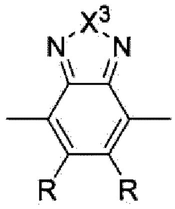

(s-1) (s-2)

In Formulas (s-1) and (s-2),
$X^3$ represents an oxygen atom or a sulfur atom.

A plurality of R's each independently represent a hydrogen atom or a substituent.

$S^1$ and $S^2$ preferably each independently represent a group represented by Formula (AU142), Formula (AU184), or Formula (AU148), or a group in which a hydrogen atom in this group is substituted with a substituent, and more preferably a group represented by Formula (AU142) or Formula (AU184), or a group in which one hydrogen atom in the group represented by Formula (AU184) is substituted with an alkyloxy group.

$B^{11}$ is a fused ring group having two or more structures selected from the group consisting of a carbocyclic structure and a heterocyclic structure, or a fused ring group that does not have an ortho-peri-fused structure, and represents a fused ring group which may have a substituent.

The fused ring group represented by $B^{11}$ may have a structure in which two or more structures that are the same as each other are fused.

In a case where the fused ring group represented by $B^{11}$ has a plurality of substituents, these substituents may be the same as or different from each other.

Examples of a carbocyclic structure that can constitute the fused ring group represented by $B^{11}$ include a ring structure represented by any one of the following Formulas (Cy1) and (Cy2).

[Chem. 26]

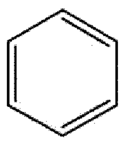

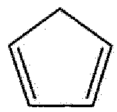

(Cy1) (Cy2)

Examples of a heterocyclic structure that can constitute the fused ring group represented by $B^{11}$ include a ring structure represented by any one of the following Formulas (Cy3) to (Cy9).

[Chem. 27]

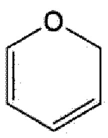

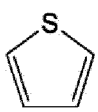

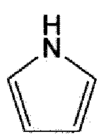

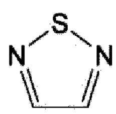

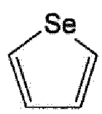

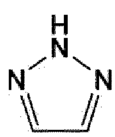

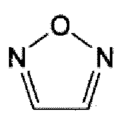

(Cy3) (Cy4) (Cy5) (Cy6) (Cy7) (Cy8) (Cy9)

$B^{11}$ is preferably a fused ring group having two or more structures selected from the group consisting of structures represented by Formulas (Cy1) to (Cy9), a fused ring group that does not have an ortho-peri-fused structure, or a fused ring group which may have a substituent. $B^{11}$ may have a structure obtained by condensing two or more identical structures among the structures represented by Formulas (Cy1) to (Cy9).

$B^{11}$ is more preferably a fused ring group having two or more structures selected from the group consisting of structures represented by Formulas (Cy1) to (Cy6) and (Cy8), a fused ring group that does not have an ortho-peri-fused

structure, or a fused ring group which may have a substituent.

The substituent which may be included in the fused ring group represented by $B^{11}$ is preferably an alkyl group which may have a substituent, an aryl group which may have a substituent, an alkyloxy group which may have a substituent, or a monovalent heterocyclic group which may have a substituent. The aryl group which may be included in the fused ring group represented by $B^{11}$ may be substituted with, for example, an alkyl group.

Examples of the fused ring group represented by $B^{11}$ include a group represented by any one of the following Formulas (b-1) to (b-14), and a group in which a hydrogen atom in this group is further substituted with a substituent (preferably, an alkyl group which may have a substituent, an aryl group which may have a substituent, an alkyloxy group which may have a substituent, or a monovalent heterocyclic group which may have a substituent). In the formulas, a plurality of R's each independently represent a hydrogen atom or a substituent, and preferably an alkyl group which may have a substituent or an aryl group which may have a substituent.

[Chem. 28]

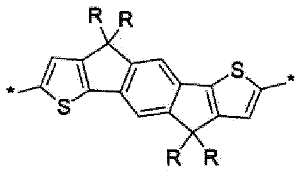
(b-1)

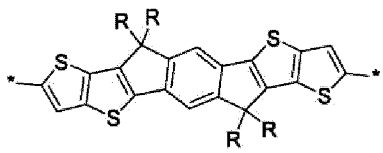
(b-2)

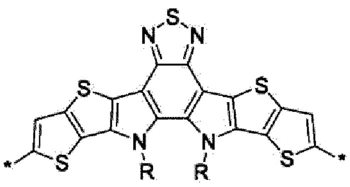
(b-3)

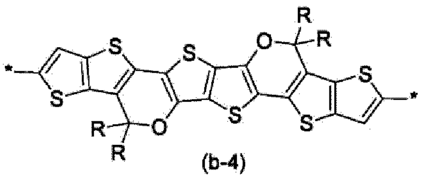
(b-4)

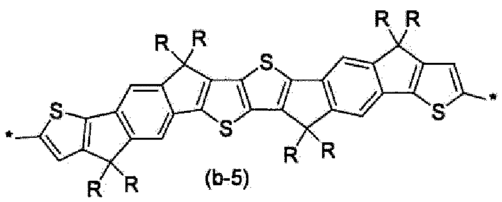
(b-5)

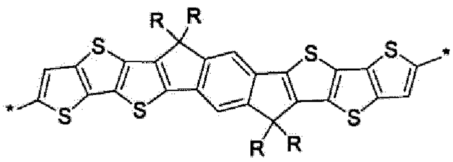
(b-6)

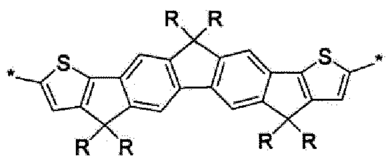
(b-7)

[Chem. 29]

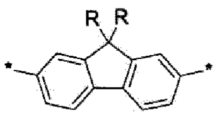

(b-8)

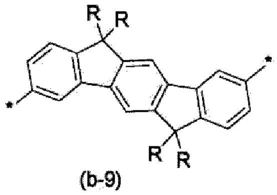

(b-9)

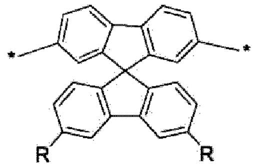

(b-10)

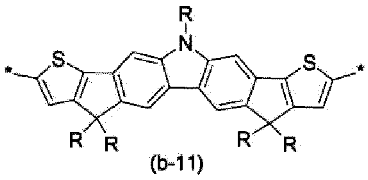

(b-11)

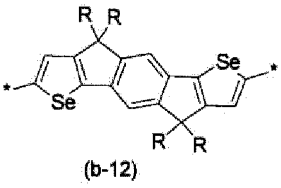

(b-12)

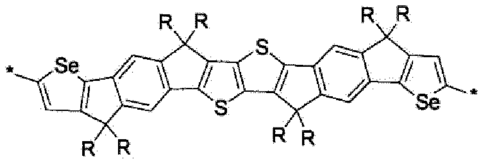

(b-13)

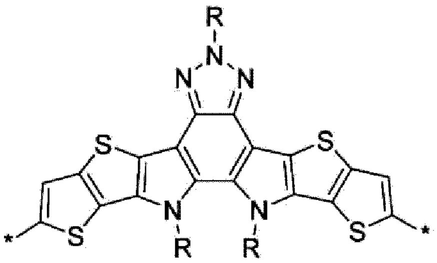

(b-14)

n1 and n2 each independently represent an integer of 0 or more, preferably each independently represent 0 or 1, and more preferably represent 0 or 1 at the same time.

Examples of the compound represented by Formula (III) or Formula (IV) include compounds represented by the following formulas. In the formulas, a plurality of X's each independently represent a hydrogen atom, a halogen atom, a cyano group, or an alkyl group which may have a substituent, and a plurality of R's each independently represent a hydrogen atom, an alkyl group which may have a substituent, an aryl group which may have a substituent, or an alkyloxy group which may have a substituent.

[Chem. 30]

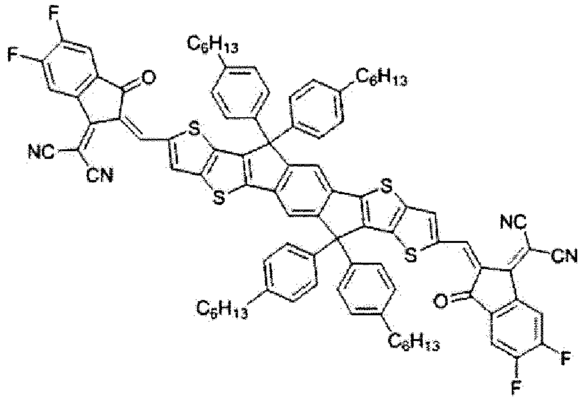

N − 1

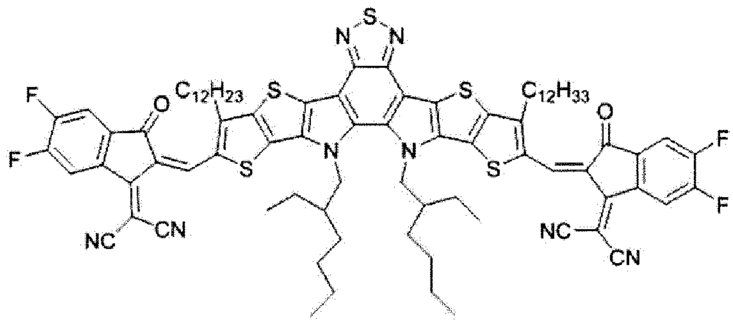

N − 2

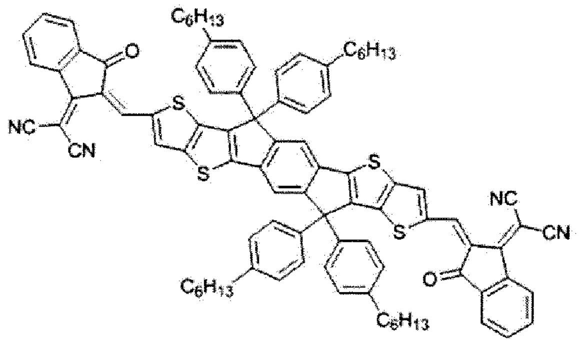

N − 3

[Chem. 31]

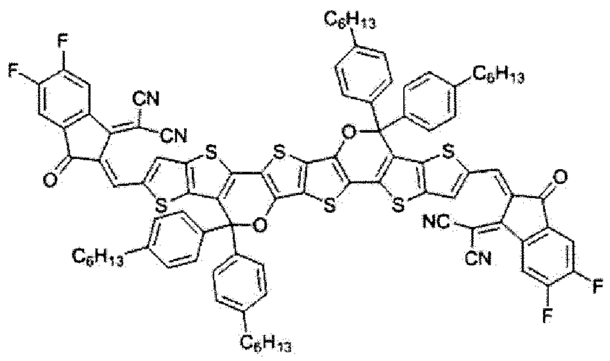

N − 4

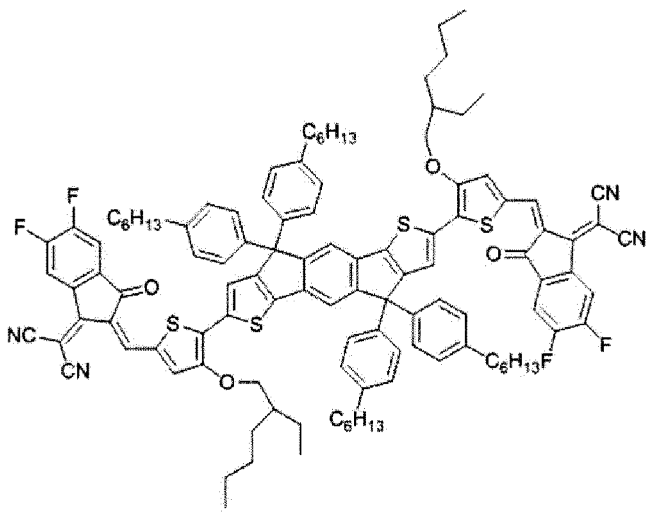

N − 5

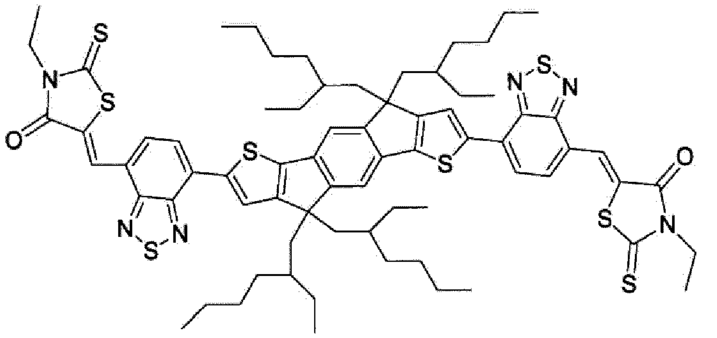

N − 6

[Chem. 32]

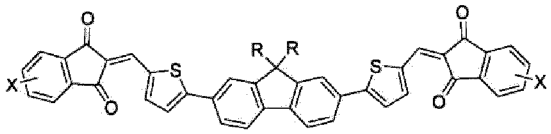

(n1)

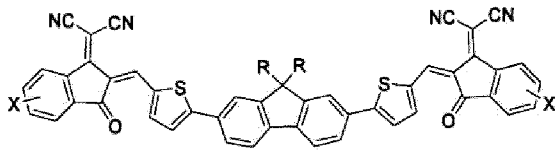

(n2)

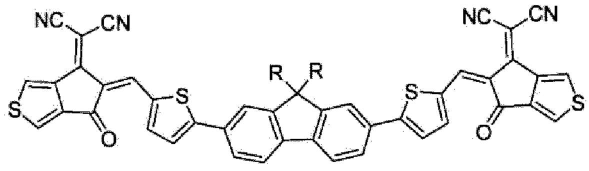

(n3)

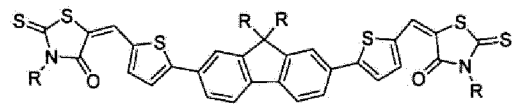

(n4)

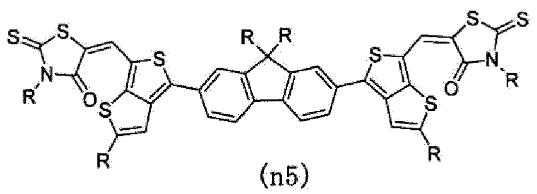

(n5)

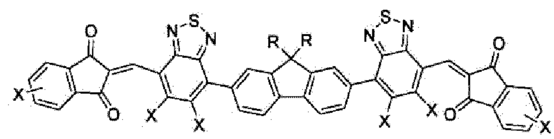

(n6)

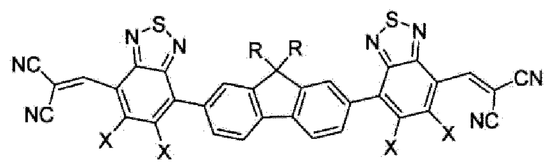

(n7)

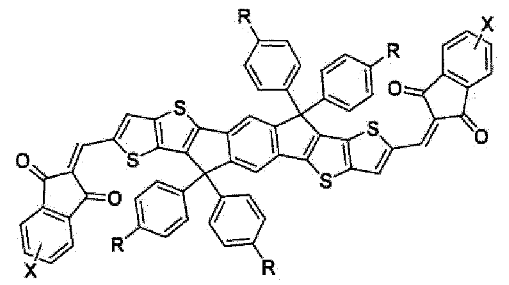

(n8)

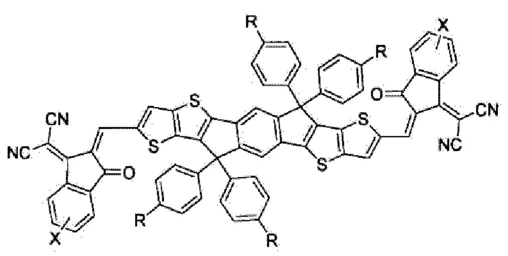

(n9)

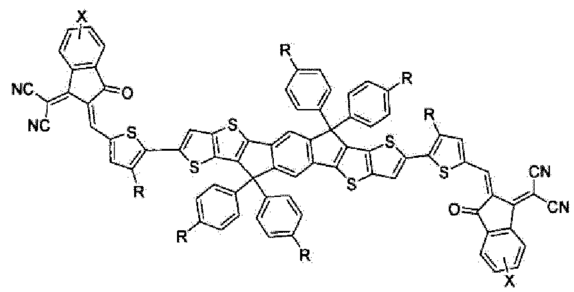

(n10)

[Chem. 33]

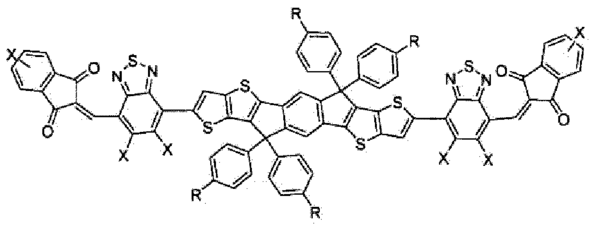

(n11)

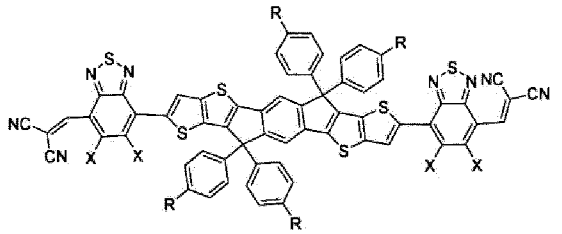

(n12)

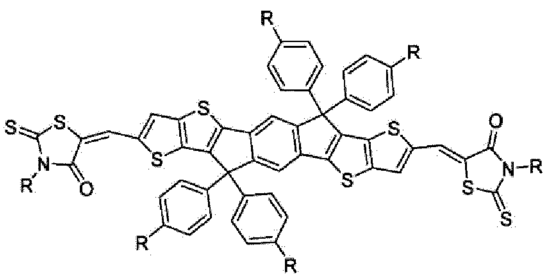

(n13)

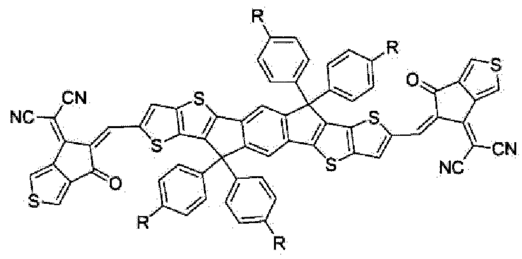

(n14)

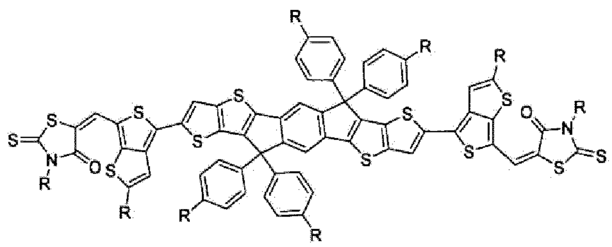

(n15)

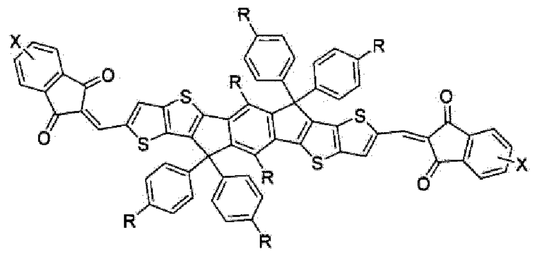

(n16)

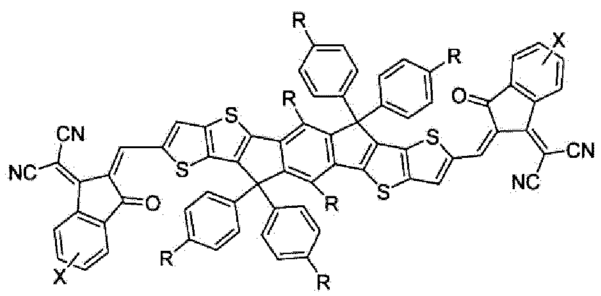

(n17)

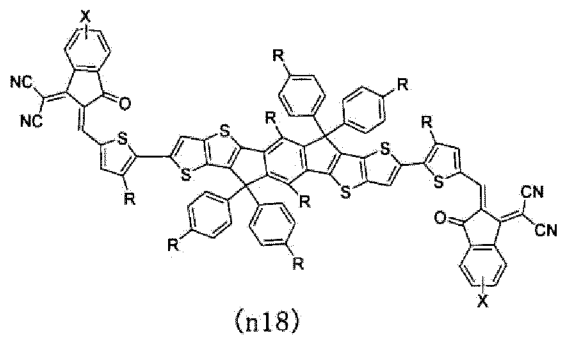

(n18)

[Chem. 34]

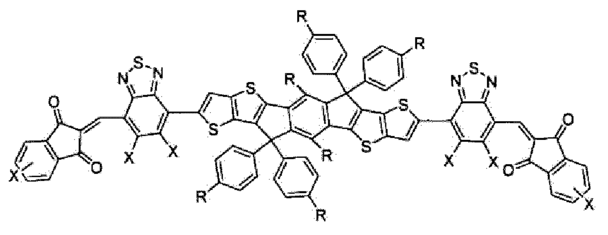

(n19)

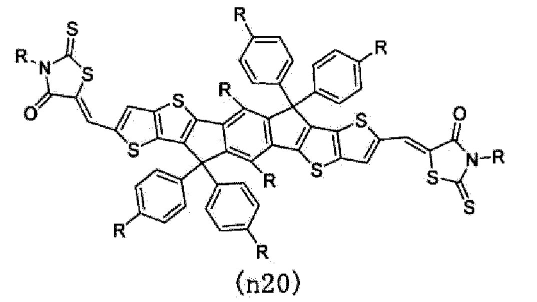

(n20)

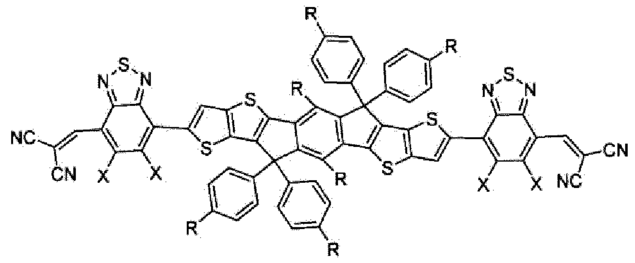

(n21)

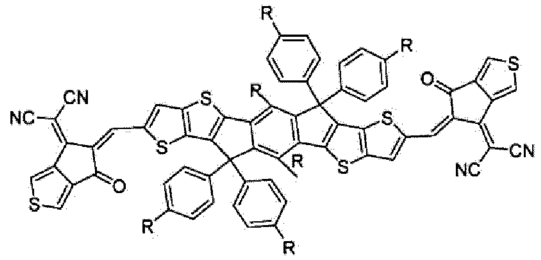

(n22)

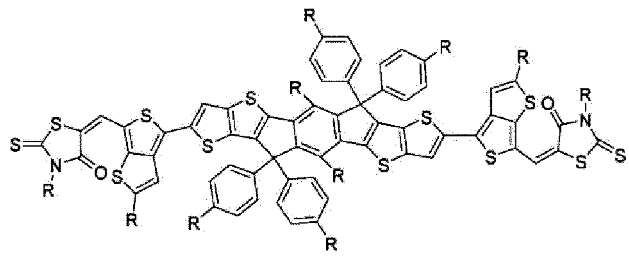

(n23)

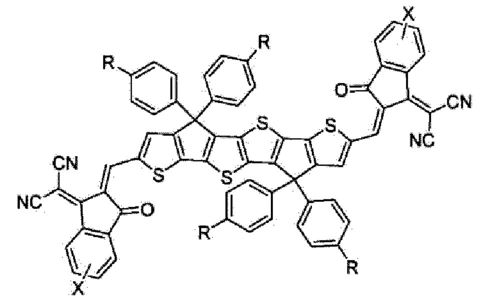

(n24)

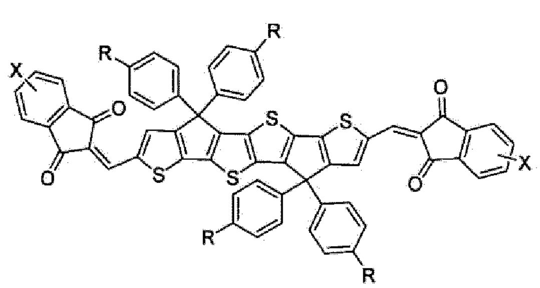

(n25)

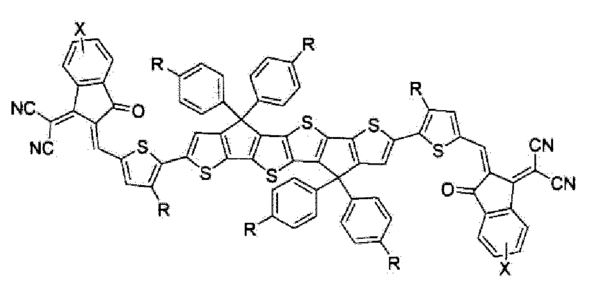

(n26)

[Chem. 35]

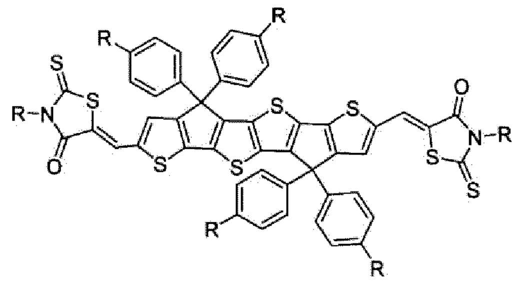

(n27)

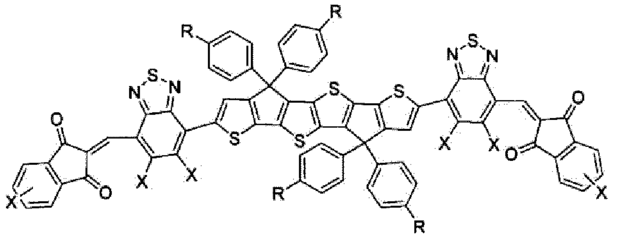

(n28)

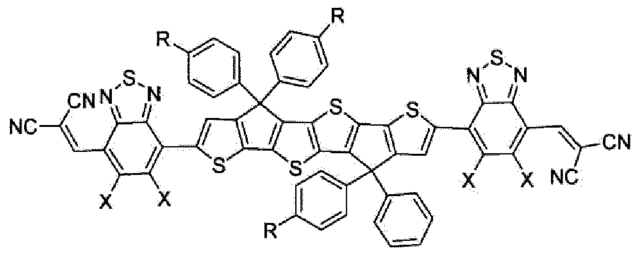

(n29)

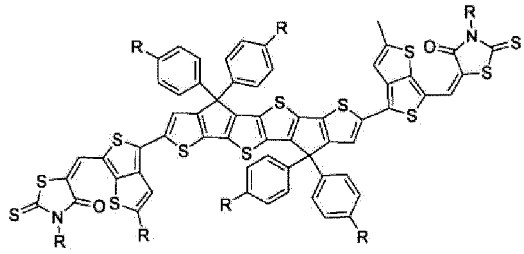

(n30)

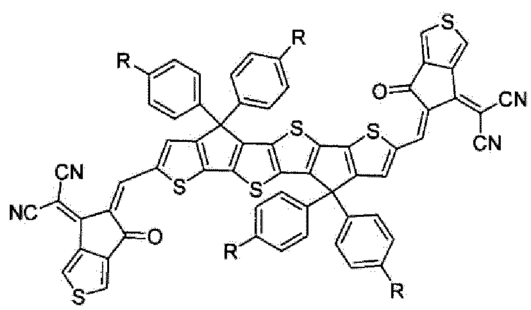

(n31)

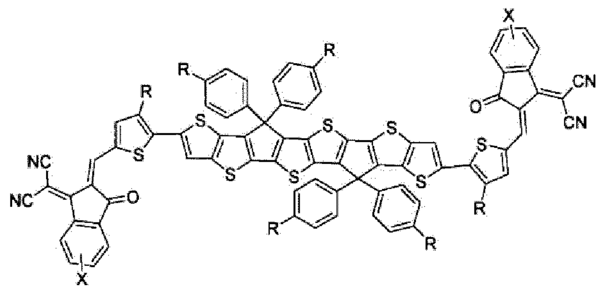

(n32)

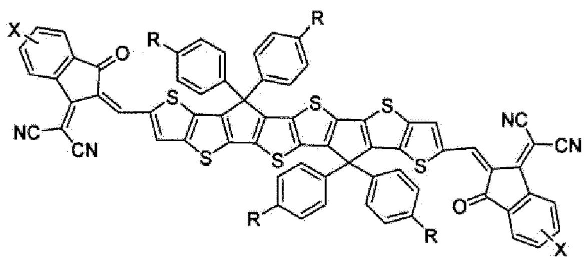

(n33)

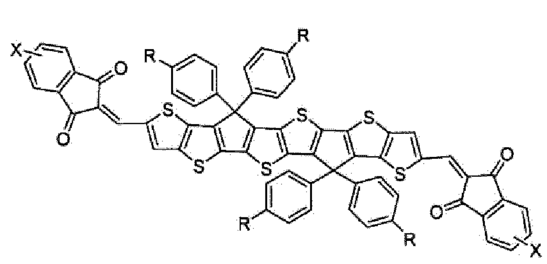

(n34)

[Chem. 36]

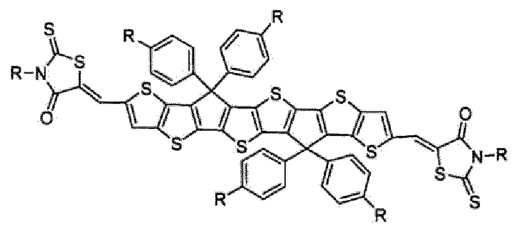

(n35)

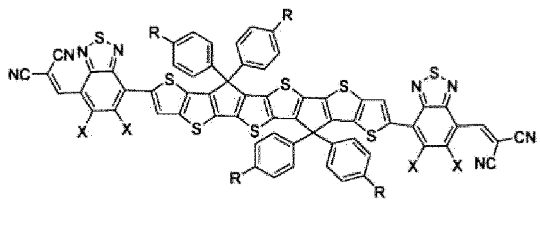

(n36)

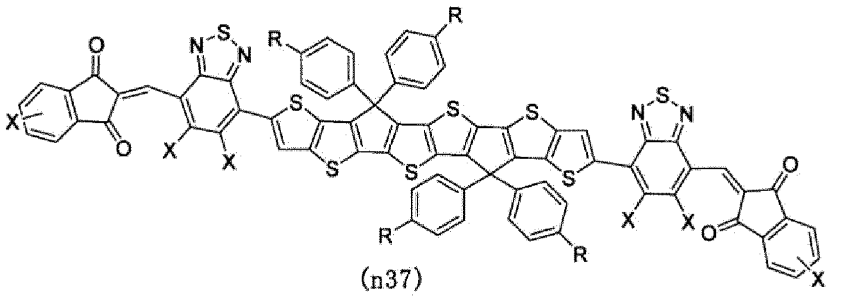

(n37)

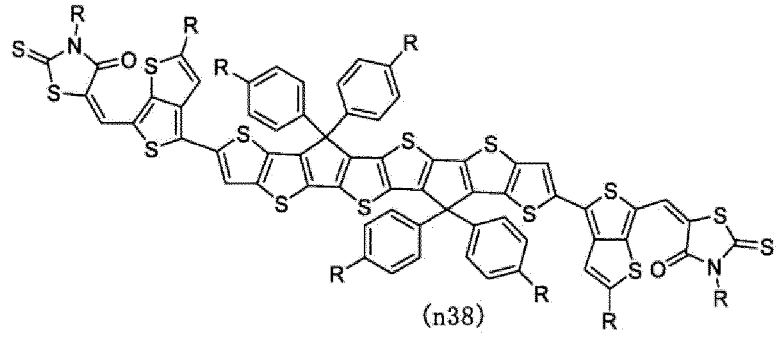

(n38)

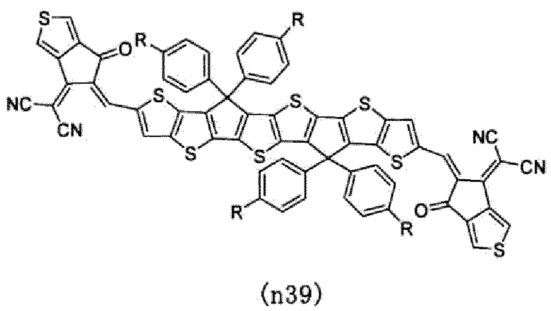

(n39)

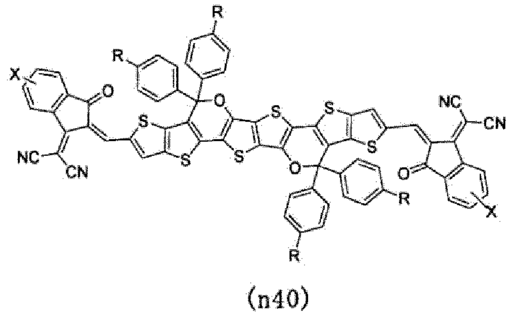

(n40)

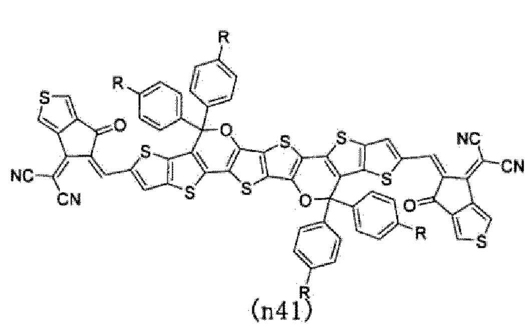

(n41)

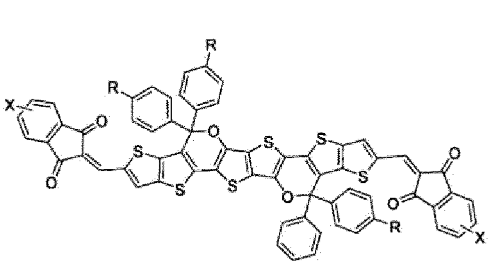

(n42)

[Chem. 37]

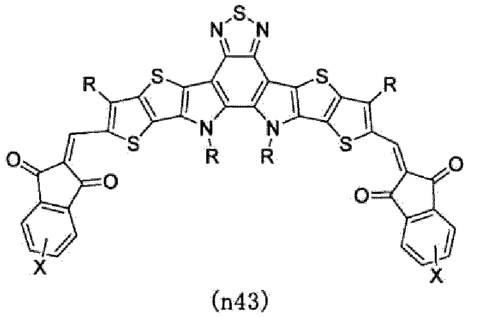

(n43)

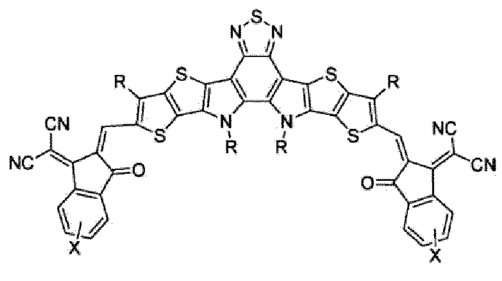

(n44)

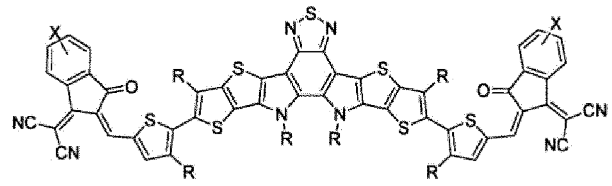

(n45)

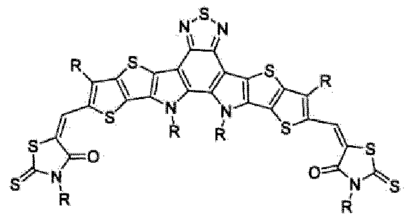

(n46)

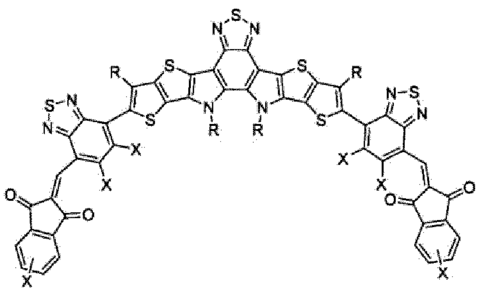

(n47)

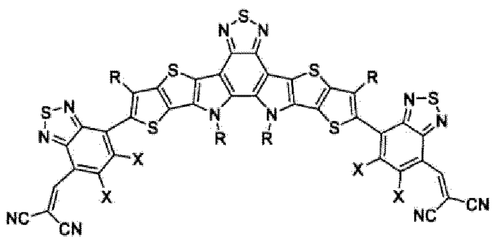

(n48)

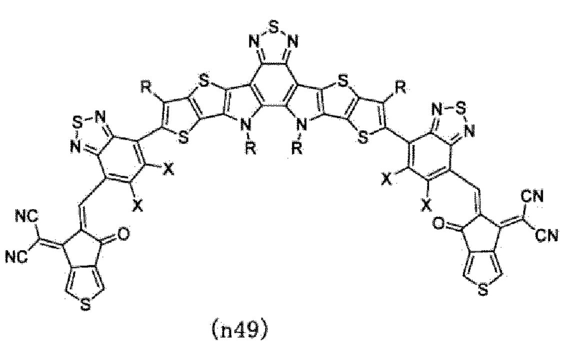

(n49)

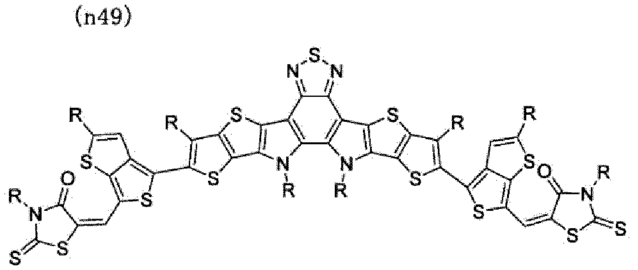

(n50)

[Chem. 38]

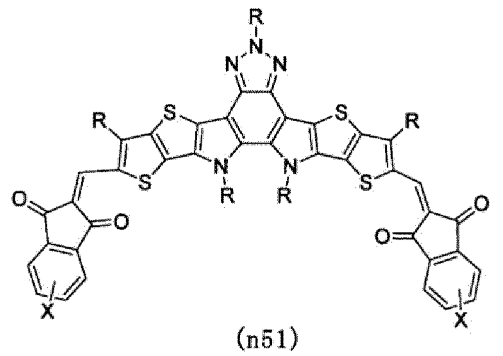

(n51)

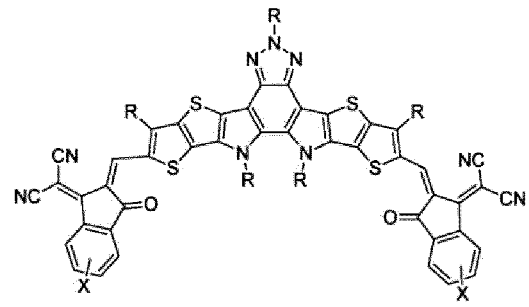

(n52)

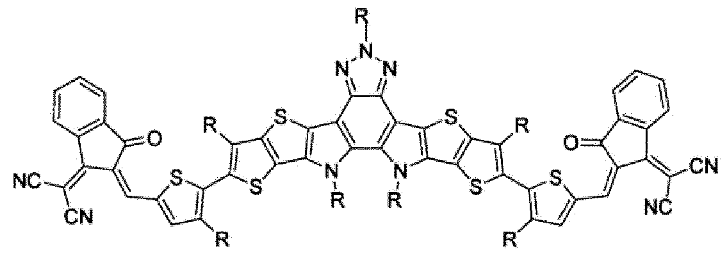

(n53)

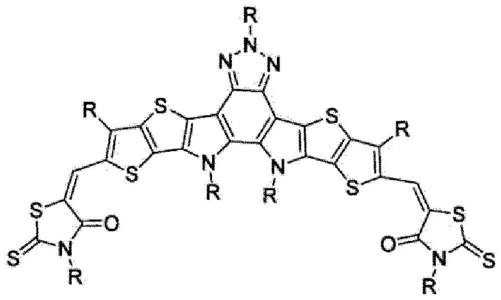

(n54)

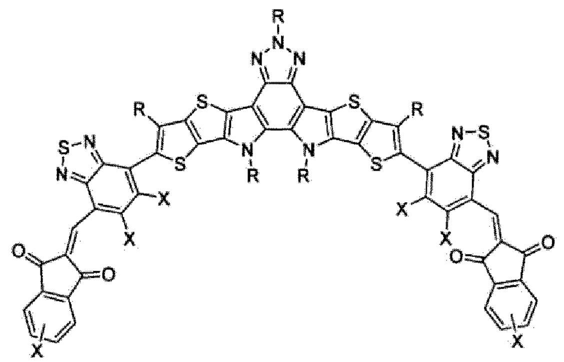

(n55)

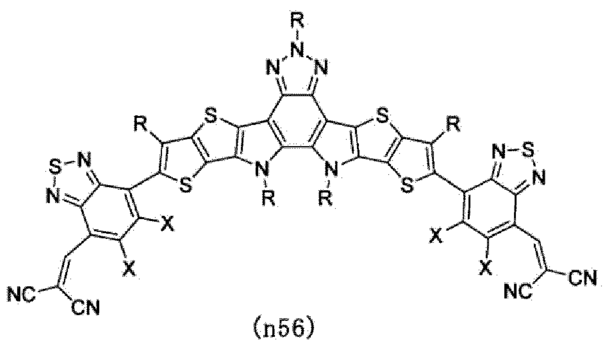

(n56)

[Chem. 39]

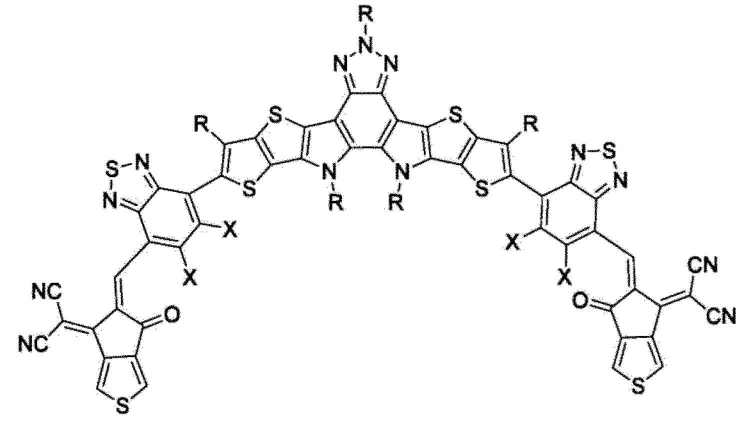

(n57)

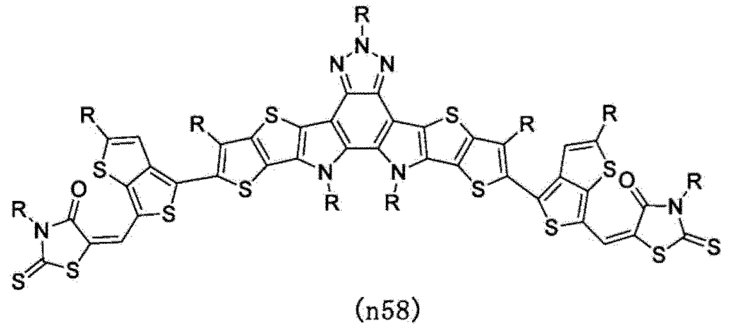

(n58)

Examples of the compound represented by Formula (III) or Formula (IV) also include a compound represented by any one of the following Formulas (n59) to (n61). In the formulas, a plurality of R's each independently represent a hydrogen atom, an alkyl group which may have a substituent, an aryl group which may have a substituent, or an alkyloxy group which may have a substituent.

[Chem. 40]

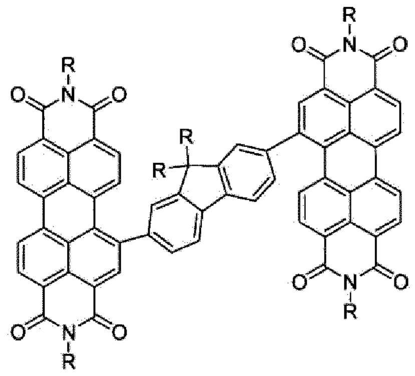

(n59)

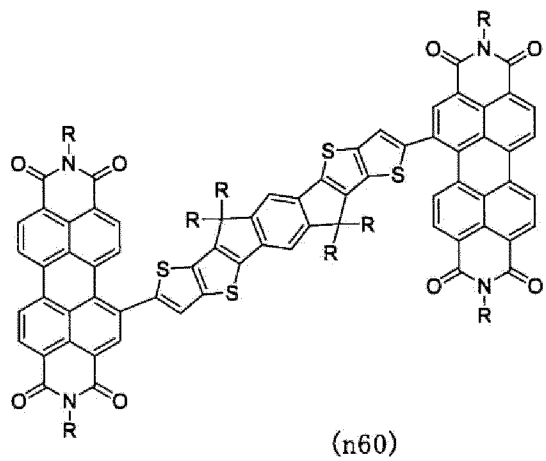

(n60)

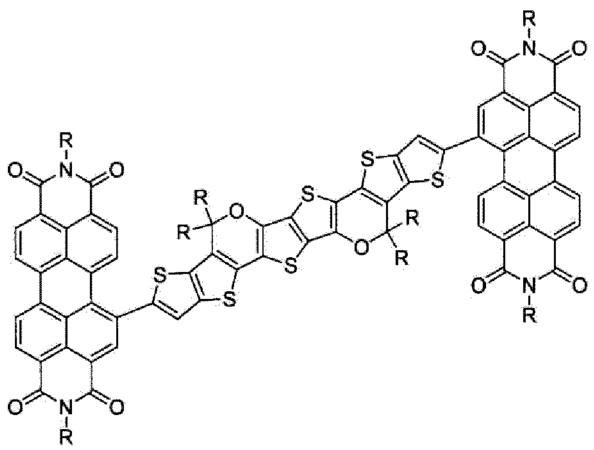

(n61)

The non-fullerene compound contained in the n-type semiconductor material may be a compound having a perylene tetracarboxylic acid diimide structure. Examples of the compound having a perylene tetracarboxylic acid diimide structure as the non-fullerene compound contained in the n-type semiconductor material include a compound represented by any one of Formulas (n59) to (n61) and a compound represented by any one of the following Formulas (n62) to (n106). In Formulas (n59) to (n106), a plurality of R's each independently represent a hydrogen atom, an alkyl group which may have a substituent, an aryl group which may have a substituent, or an alkyloxy group which may have a substituent.

[Chem. 41]

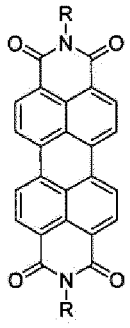

(n62)

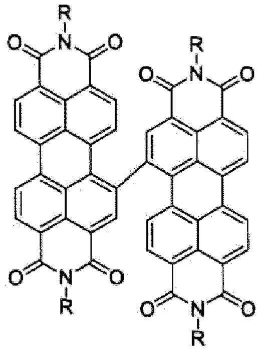

(n63)

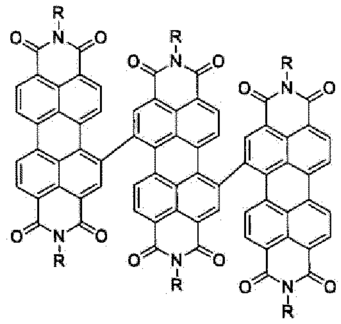

(n64)

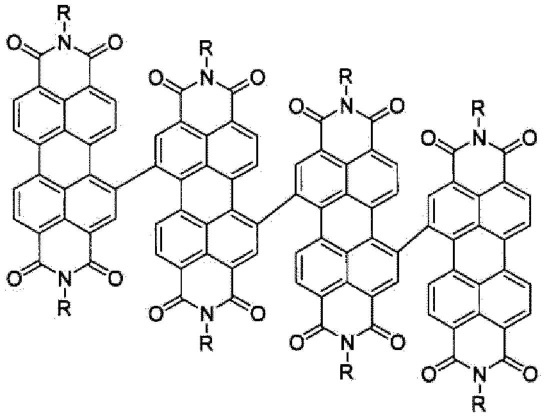

(n65)

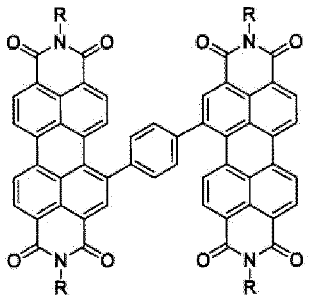

(n66)

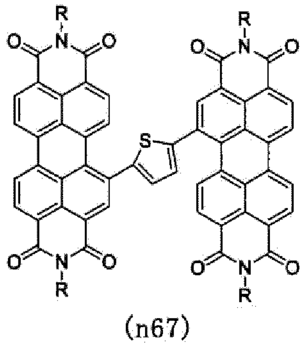

(n67)

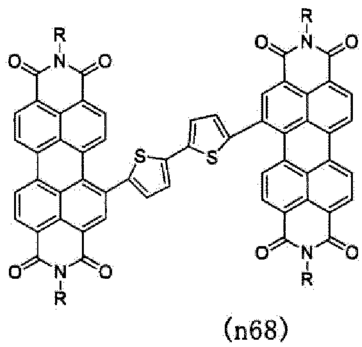

(n68)

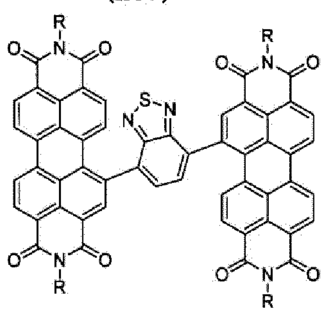

(n69)

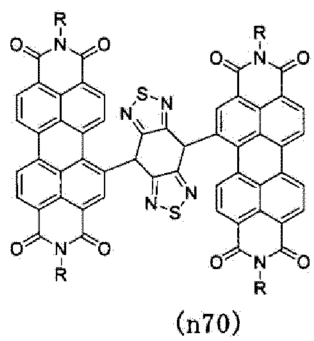

(n70)

[Chem. 42]

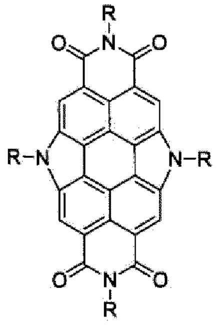

(n71)

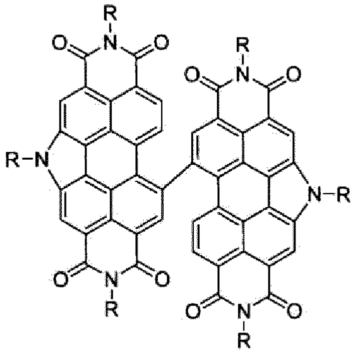

(n72)

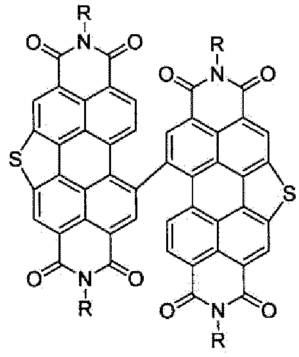

(n73)

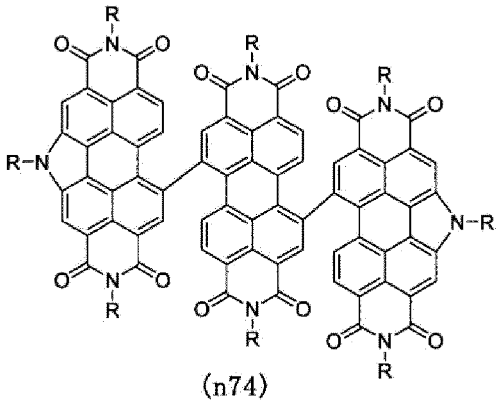

(n74)

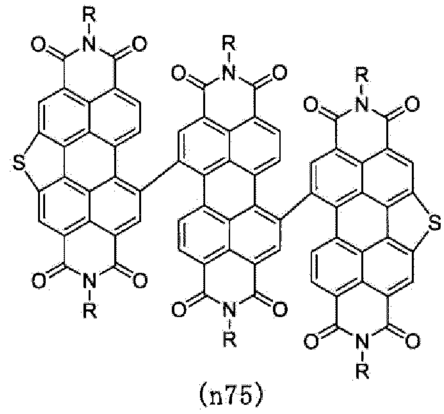

(n75)

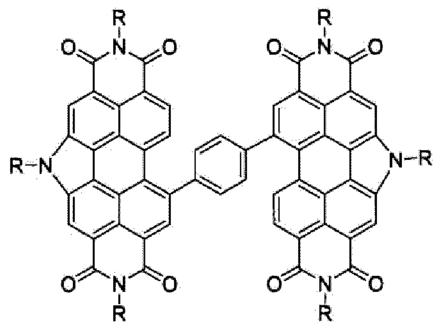

(n76)

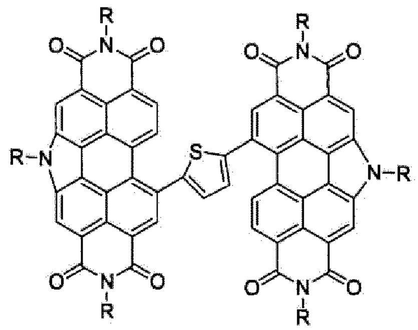

(n77)

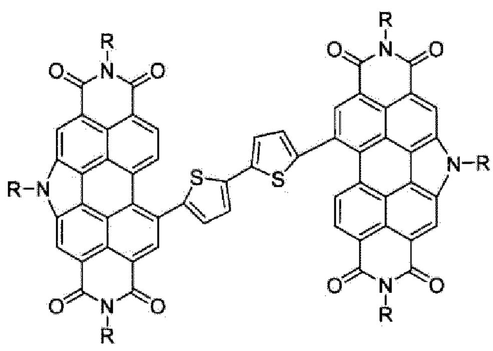

(n78)

[Chem. 43]

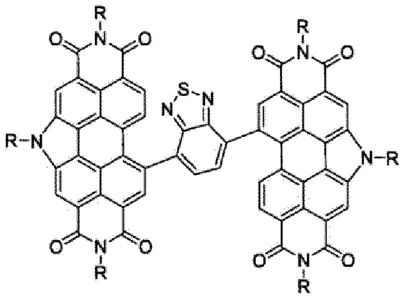

(n79)

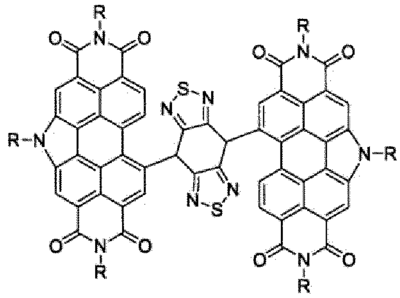

(n80)

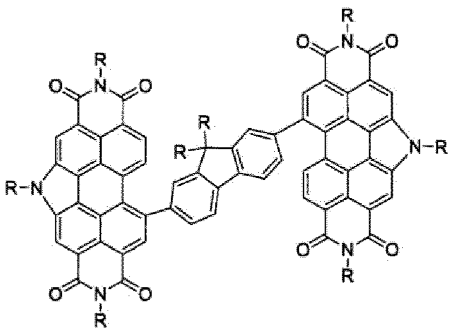

(n81)

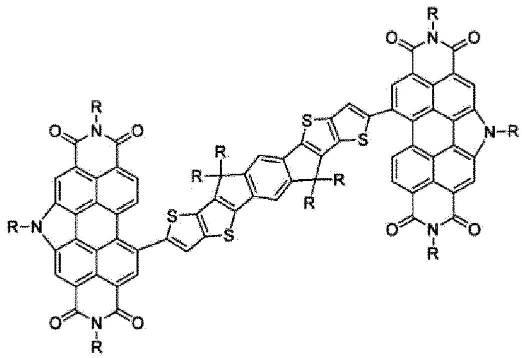

(n82)

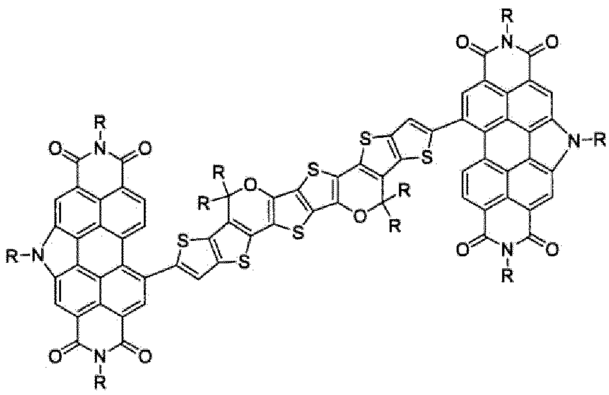

(n83)

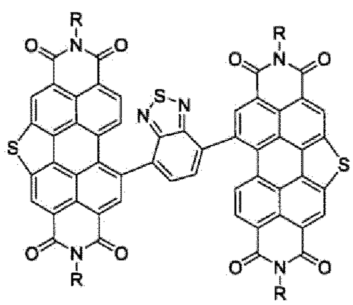

(n84)

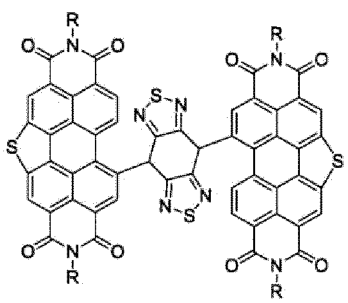

(n85)

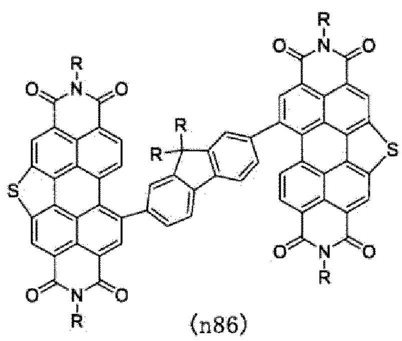

(n86)

[Chem. 44]

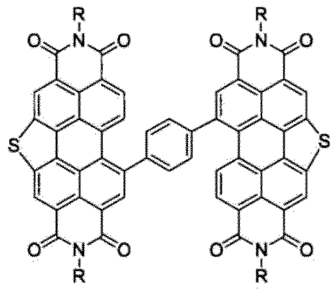

(n87)

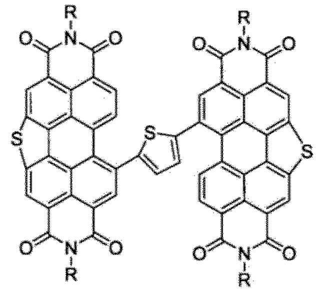

(n88)

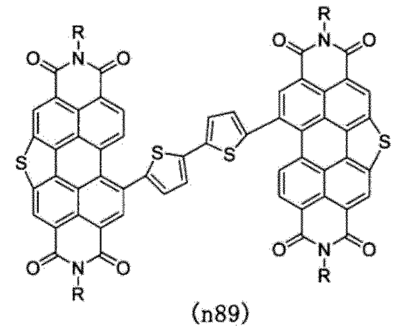

(n89)

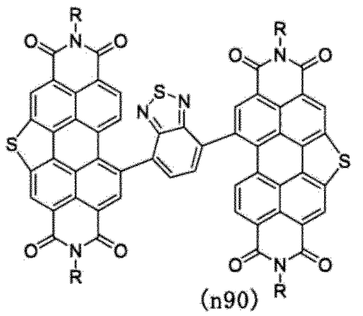

(n90)

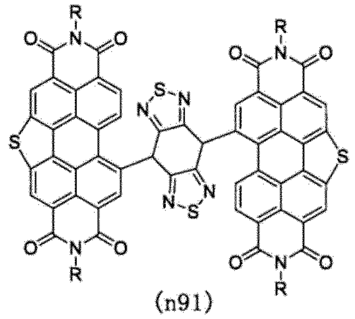

(n91)

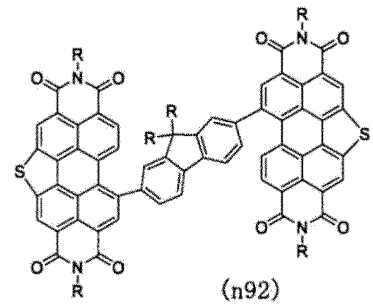

(n92)

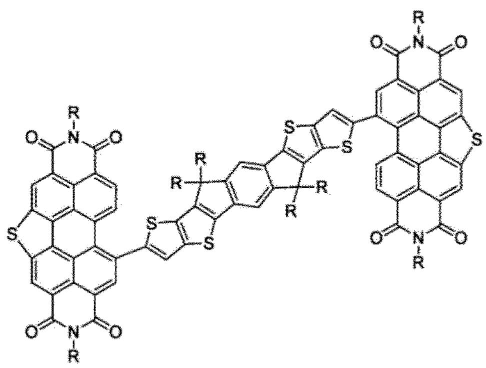

(n93)

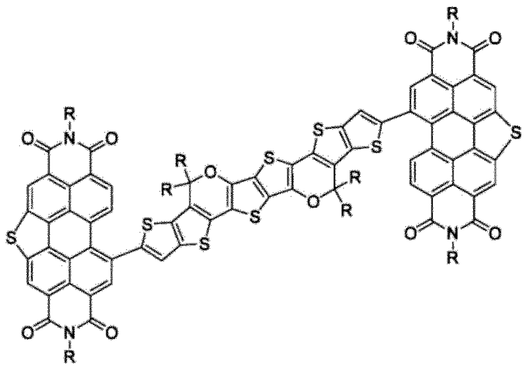

(n94)

[Chem. 45]

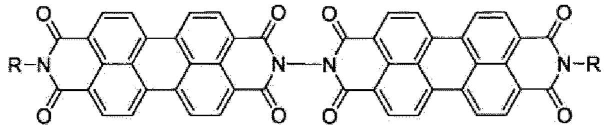

(n95)

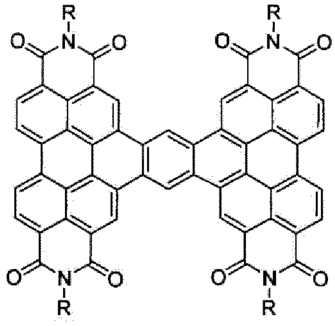

(n96)

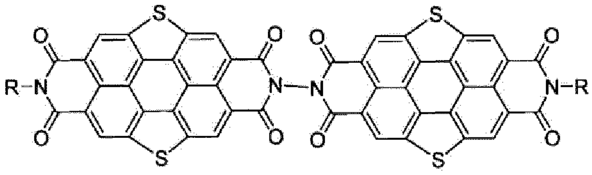

(n97)

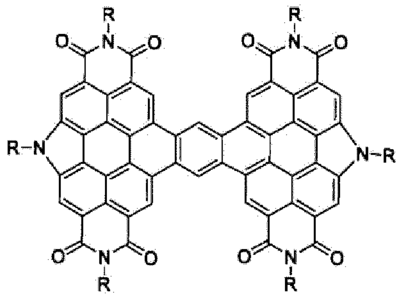

(n98)

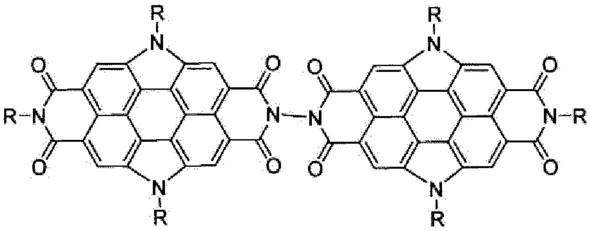

(n99)

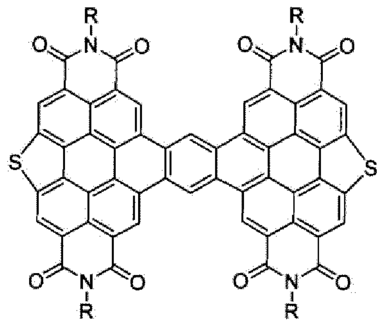

(n100)

[Chem. 46]

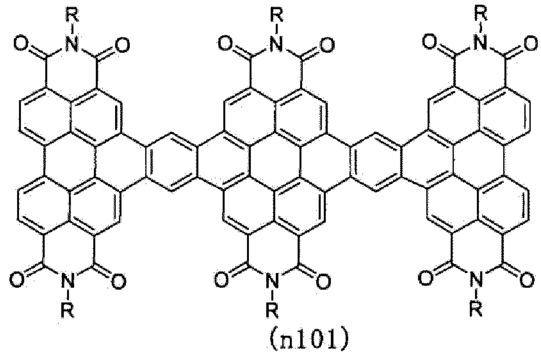

(n101)

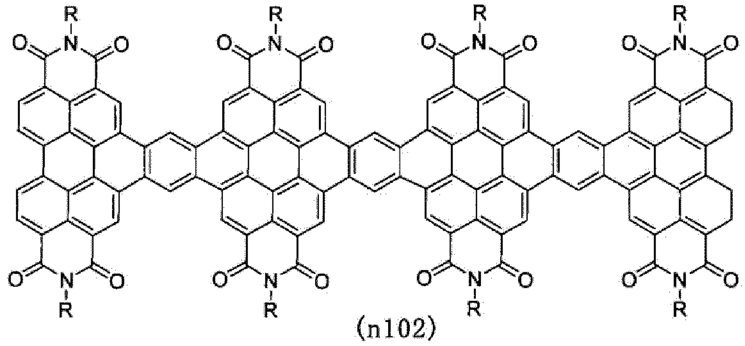

(n102)

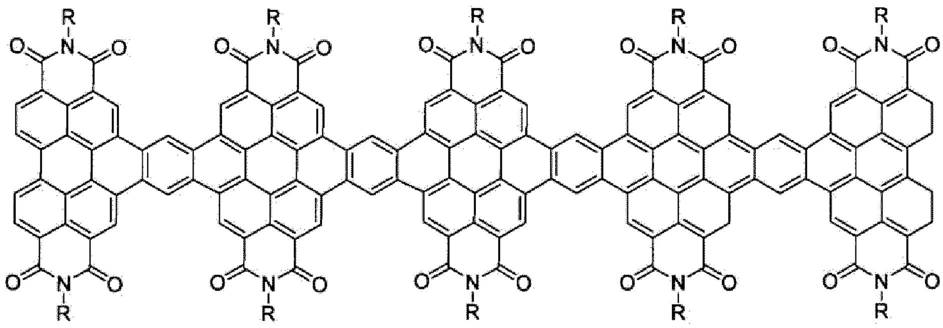

(n103)

[Chem. 47]

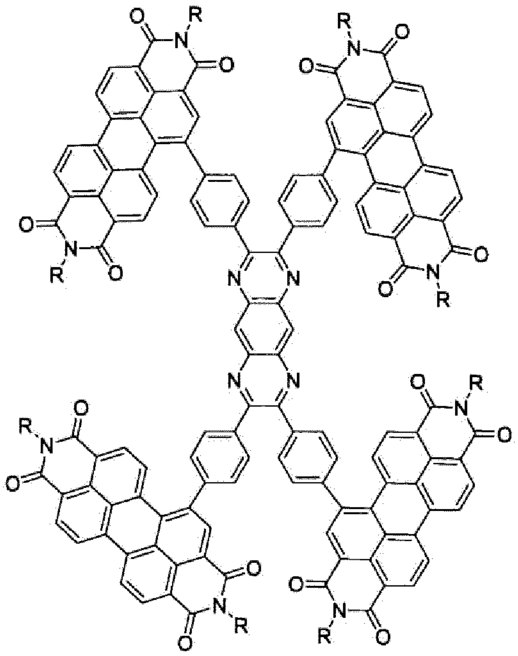

(n104)

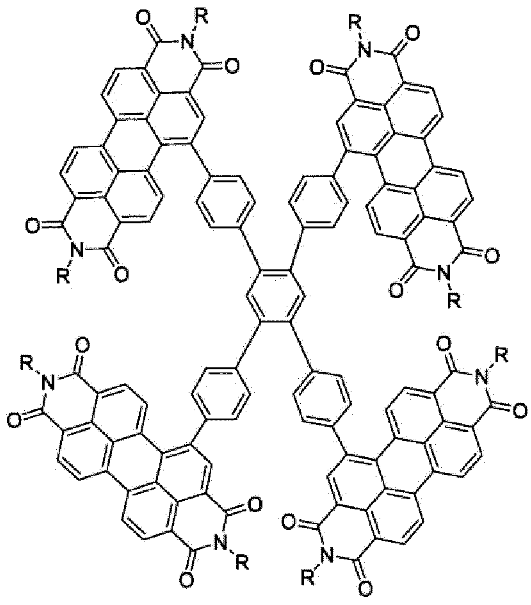

(n105)

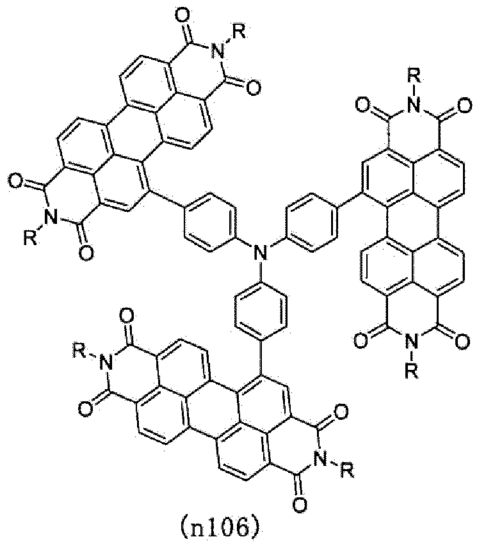

(n106)

The non-fullerene compound contained in the n-type semiconductor material is preferably a compound represented by the following Formula (V) or (VI) and more preferably a compound represented by the following Formula (V). The compound represented by the following Formula (V) or (VI) is a compound having a perylene tetracarboxylic acid diimide structure.

[Chem. 48]

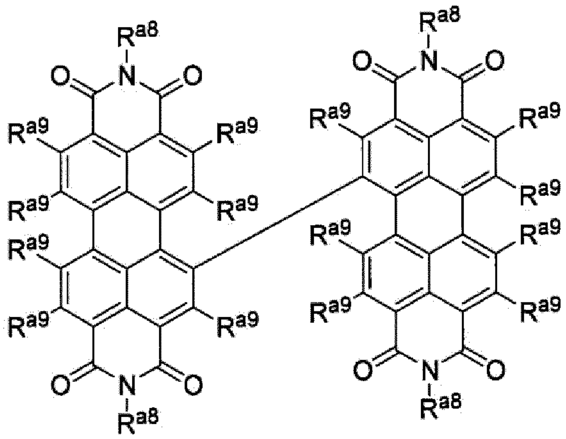

( V )

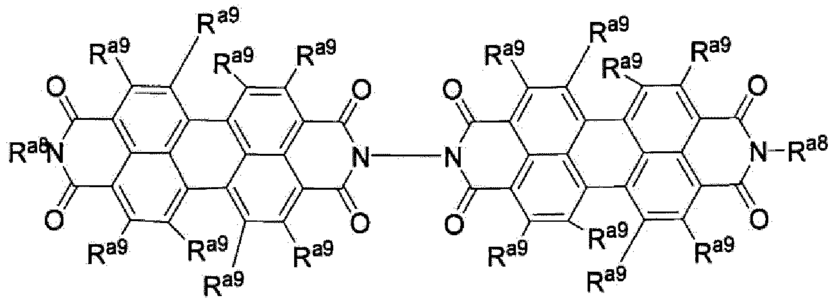

( V I )

In Formulas (V) and Formula (VI), $R^{a8}$ and $R^{a9}$ each independently represent a hydrogen atom, a halogen atom, an alkyl group which may have a substituent, a cycloalkyl group which may have a substituent, an alkyloxy group which may have a substituent, a cycloalkyloxy group which may have a substituent, a monovalent aromatic carbocyclic group which may have a substituent, or a monovalent aromatic heterocyclic group which may have a substituent, and a plurality of $R^{a8}$'s and a plurality of $R^{a9}$'s may be the same as or different from each other.

Examples and specific examples of the respective groups represented by $R^{a8}$ and $R^{a9}$ are the same as the examples and the specific examples in "Description of Terms".

$R^{a8}$'s are the same as or different from each other and each are preferably an alkyl group which may have a substituent or an aryl group which may have a substituent, more preferably an alkyl group which may have a substituent, and still more preferably an alkyl group which have 6 to 20 carbon atoms and may have a substituent. The number of carbon atoms of the substituent is not included in the number of carbon atoms.

$R^{a9}$'s are the same as or different from each other and each are preferably a hydrogen atom, a halogen atom, an alkyl group which may have a substituent, an alkyloxy group which may have a substituent, an aryl group which may have a substituent, or a monovalent heterocyclic group which may have a substituent, and more preferably a hydrogen atom.

Examples of the compound represented by Formula (V) or (VI) include a compound represented by the following formula.

[Chem. 49]

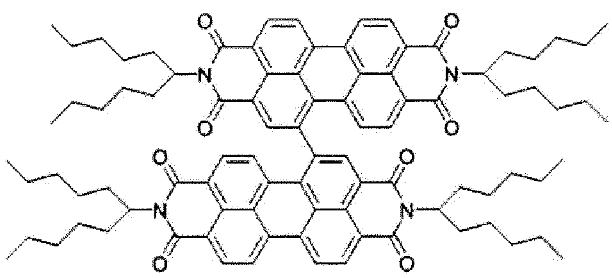

In the n-type semiconductor material that can be contained in the active layer, a weight ratio of the non-fullerene compound is preferably 90 wt% or more, more preferably 95 wt% or more, and still more preferably 98 wt% or more, but is usually 100 wt% or less, and may be 100 wt%.

(Relationship between p-Type Semiconductor Material and n-Type Semiconductor Material)

A relationship between an energy level value of each of a HOMO and a LUMO of the polymer as the p-type semiconductor material and an energy level value of each of a HOMO and a LUMO of the non-fullerene compound as the n-type semiconductor material, the p-type semiconductor material and the n-type semiconductor material being contained in the active layer, can be appropriately set in a range in which the photodetector is operated.

A value of $\Delta HO = |HOn| - |HOp|$ is preferably greater than -0.5 eV and more preferably greater than -0.10 eV, but is preferably less than 3 eV, more preferably less than 2 eV, still more preferably greater than -0.5 eV and less than 3 eV, and still more preferably greater than -0.10 eV and less than 2 eV, in which |HOp| and ILUp| are absolute values of the energy levels of the HOMO and the LUMO of the polymer as the p-type semiconductor material, respectively, and |HOn| and |LUn| are absolute values of the energy levels of the HOMO and the LUMO of the non-fullerene compound as the n-type semiconductor material, respectively.

In addition, a value of $\Delta LU = |LUn| - |LUp|$ is preferably greater than -0.5 eV and preferably greater than 0.01 eV, but is preferably less than 2 eV, more preferably greater than -0.5 eV and less than 2 eV, and still more preferably greater than 0.01 eV and less than 2 eV.

(Structure, Thickness, and the like of Active Layer)

In the present embodiment, the p-type semiconductor material and the n-type semiconductor material are preferably contained in the active layer in a form having a bulk heterojunction.

In the present embodiment, a thickness of the active layer is not particularly limited. The thickness may be any suitable thickness in consideration of a balance between suppression of a dark current and extraction of a generated photocurrent.

The thickness of the active layer is preferably 200 nm or more, and more preferably 250 nm or more, particularly from the viewpoint of further reducing the dark current. In addition, the thickness of the active layer is preferably 10 μm or less, more preferably 5 μm or less, and still more preferably 1 μm or less.

The active layer can be formed by any suitable conventionally known forming step. In the present embodiment, the active layer is preferably produced by a coating method using an ink (coating liquid).

As a method of coating the ink to an object to be coated, any suitable coating method can be used.

As the coating method, a slot die coating method, a slit coating method, a knife coating method, a spin coating method, a micro-gravure coating method, a gravure coating method, a bar coating method, an inkjet printing method, a nozzle coating method, or a capillary coating method is preferable, a slot die coating method, a slit coating method, a spin coating method, a capillary coating method, or a bar coating method is more preferable, and a slot die coating method, a slit coating method, or a spin coating method is still more preferable.

The ink for forming the active layer will be described below in detail.

[1.1.2. Substrate]

The photodetector is usually formed on a substrate (support substrate). In addition, there is also a case where sealing is performed by the substrate (support substrate). One of the pair of electrodes is usually formed on the substrate.

A material of the substrate is not particularly limited as long as it is a material that is not chemically changed particularly when a layer containing an organic compound is formed.

Examples of the material of the substrate include glass, plastic, a polymer film, and silicon. In a case where an opaque substrate is used, it is preferable that an electrode (in other words, the electrode provided on a side far from the opaque substrate) provided on a side opposite to an electrode provided on the opaque substrate is a transparent or translucent electrode.

[1.1.3. Electrode]

The photodetector includes a first electrode and a second electrode that are a pair of electrodes. At least one electrode of the pair of electrodes is preferably a transparent or translucent electrode in order to allow light to be incident.

Examples of a material of the transparent or translucent electrode include a conductive metal oxide film and a translucent metal thin film. Specific examples of the material of the transparent or translucent electrode include indium oxide, zinc oxide, tin oxide, and a conductive material such as indium tin oxide (ITO), indium zinc oxide (IZO), or NESA,

which is a composite thereof, gold, platinum, silver, and copper. As the material of the transparent or translucent electrode, ITO, IZO, or tin oxide is preferable. In addition, as the electrode, a transparent conductive film using an organic compound such as polyaniline and a derivative thereof, or polythiophene and a derivative thereof, as a material, may be used. The transparent or translucent electrode may be the first electrode or the second electrode.

When one electrode of the pair of electrodes is transparent or translucent, the other electrode may be an electrode having low light transmittance. Examples of the material of the electrode having low light transmittance include a metal and a conductive polymer. Specific examples of a material of the electrode having low light transmittance include metals such as lithium, sodium, potassium, rubidium, cesium, magnesium, calcium, strontium, barium, aluminum, scandium, vanadium, zinc, yttrium, indium, cerium, samarium, europium, terbium, and ytterbium, and an alloy of two or more of these metals, an alloy of one or more of these metals and one or more metals selected from the group consisting of gold, silver, platinum, copper, manganese, titanium, cobalt, nickel, tungsten, and tin, graphite, a graphite interlayer compound, polyaniline and a derivative thereof, and polythiophene and a derivative thereof. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

[1.1.4. Intermediate Layer]

As illustrated in Fig. 1, the photodetector of the present embodiment preferably includes an intermediate layer (buffer layer) such as a charge transport layer (an electron transport layer, a hole transport layer, an electron injection layer, or a hole injection layer) as a constituent element for improving characteristics such as photoelectric conversion efficiency.

In addition, examples of a material used for the intermediate layer include a metal such as calcium, an inorganic oxide semiconductor such as molybdenum oxide or zinc oxide, and a mixture (PEDOT:PSS) of poly(3,4-ethylenedioxythiophene) (PEDOT) and poly(4-styrenesulfonate) (PSS).

As illustrated in Fig. 1, the photodetector preferably includes a hole transport layer provided between the first electrode and the active layer. The hole transport layer has a function of transporting holes from the active layer to the first electrode.

The hole transport layer provided in contact with the first electrode may be particularly referred to as a hole injection layer. The hole transport layer (hole injection layer) provided in contact with the first electrode has a function of promoting injection of holes into the first electrode. The hole transport layer (hole injection layer) may be in contact with the active layer.

The hole transport layer contains a hole transporting material. Examples of the hole transporting material include polythiophene and a derivative thereof, an aromatic amine compound, a polymer compound containing a constitutional unit having an aromatic amine residue, CuSCN, CuI, NiO, tungsten oxide ($WO_3$), and molybdenum oxide ($MoO_3$).

The intermediate layer can be formed by any suitable conventionally known forming method. The intermediate layer can be formed by, for example, a vacuum deposition method or a coating method similar to that in the formation method of the active layer.

As illustrated in Fig. 1, the photodetector of the present embodiment preferably includes an electron transport layer provided between the second electrode and the active layer as the intermediate layer. The electron transport layer has a function of transporting electrons from the active layer to the second electrode. The electron transport layer may be in contact with the second electrode. The electron transport layer may be in contact with the active layer.

The electron transport layer provided in contact with the second electrode may be particularly referred to as an electron injection layer. The electron transport layer (electron injection layer) provided in contact with the second electrode has a function of promoting injection of electrons generated in the active layer into the second electrode.

The electron transport layer contains an electron transporting material. Examples of the electron transporting material include ethoxylated polyethylenimine (PEIE), a polymer compound having a fluorene structure, a metal such as calcium, and a metal oxide.

Examples of the polymer compound having a fluorene structure include poly[(9,9-bis(3'-(N,N-dimethylamino)propyl)-2,7-fluoren)-ortho-2,7-(9,9'-dioctylfluorene)] (PFN) and PFN-P2.

Examples of the metal oxide include zinc oxide, gallium-doped zinc oxide, aluminum-doped zinc oxide, titanium oxide, and niobium oxide. As the metal oxide, a metal oxide containing zinc is preferable, and zinc oxide is particularly preferable.

Examples of other electron transporting materials include poly(4-vinylphenol) and perylene diimide.

The photodetector according to the present embodiment preferably has a configuration in which intermediate layers are a hole transport layer and an electron transport layer, and a substrate (a support substrate), a first electrode, a hole transport layer, an active layer, an electron transport layer, and a second electrode are laminated in this order so as to be in contact with each other.

[1.1.5. Sealing Member]

It is preferable that the photodetector of the present embodiment further includes a sealing member and is a sealing body sealed by the sealing member.

Any suitable conventionally known member can be used as the sealing member. Examples of the sealing member include a combination of a glass substrate as a substrate (sealing substrate) and a sealing material (adhesive) as a UV curable resin.

The sealing member may be a sealing layer having a layer structure of one or more layers. Examples of the layer constituting the sealing layer include a gas barrier layer and a gas barrier film.

The sealing layer is preferably formed of a material having a property of blocking moisture (water vapor barrier property) or a property of blocking oxygen (oxygen barrier property). Examples of a preferred material as the material of the sealing layer include an organic material such as polyethylene trifluoride, polytrifluoroethylene chloride (PCTFE), polyimide, polycarbonate, polyethylene terephthalate, alicyclic polyolefin, or an ethylene vinyl alcohol copolymer, and an inorganic material such as silicon oxide, silicon nitride, aluminum oxide, or diamondlike carbon.

The sealing member is usually formed of a material that can withstand a heat treatment performed when the sealing member is incorporated into a device to which a photodetector is applied, for example, a device of the following application example.

[1.2. Second Embodiment]

A photodetector according to a second embodiment contains a polymer in which a p-type semiconductor material contained in an active layer is a polymer containing a constitutional unit DU having an electron donating property and a constitutional unit AU having an electron accepting property. The constitutional unit DU includes one or more pairs of atoms $\pi$-bonded to each other. The constitutional unit AU includes one or more pairs of atoms $\pi$-bonded to each other.

In addition, in the present embodiment, an n-type semiconductor material contained in the active layer contains a non-fullerene compound.

The non-fullerene compound contains a moiety DP having an electron donating property and a moiety AP having an electron accepting property. The moiety DP includes one or more pairs of atoms $\pi$-bonded to each other. The moiety AP includes one or more pairs of atoms $\pi$-bonded to each other.

Among absolute values of differences in electronegativity of the pair of atoms included in the constitutional unit DU and $\pi$-bonded to each other, a maximum value is represented by $DUD_{max}$,

among absolute values of differences in electronegativity of the pair of atoms included in the constitutional unit AU and $\pi$-bonded to each other, a maximum value is represented by $AUD_{max}$,

among absolute values of differences in electronegativity of the pair of atoms included in the moiety DP and $\pi$-bonded to each other, a maximum value is represented by $DPD_{max}$,

among absolute values of differences in electronegativity of the pair of atoms included in the moiety AP and $\pi$-bonded to each other, a maximum value is represented by $APD_{max}$, and $DUD_{max}$, $AUD_{max}$, $DPD_{max}$, and $APD_{max}$ satisfy Expression (a) and Expression (b).

The photodetector of the present embodiment has the same configuration as that of the photodetector according to the first embodiment except that the p-type semiconductor material and the n-type semiconductor material that can be contained in the active layer are the above-described materials. Hereinafter, the p-type semiconductor material and the n-type semiconductor material that can be contained in the active layer in the photodetector of the present embodiment will be described.

(p-Type Semiconductor Material)

The p-type semiconductor material contains a polymer containing a constitutional unit DU having an electron donating property and a constitutional unit AU having an electron accepting property. The constitutional unit DU includes one or more pairs of atoms $\pi$-bonded to each other. $DUD_{max}$ is preferably 0.05 or more, more preferably 0.4 or more, still more preferably 0.5 or more, and still more preferably 0.8 or more, under the condition in which Expression (a): $DUD_{max} - AUD_{max} > 0$ is satisfied.

The constitutional unit AU includes one or more pairs of atoms $\pi$-bonded to each other. $AUD_{max}$ is preferably less than 0.7, more preferably less than 0.3, still more preferably less than 0.1, and still more preferably less than 0.04, under the condition in which Expression (a): $DUD_{max} - AUD_{max} > 0$ is satisfied.

Examples of the constitutional unit DU include a unit having a ketone structure, an imine structure, a sulfoxide structure, or a sulfone structure.

It is preferable that the constitutional unit AU does not have any one of a ketone structure, a sulfoxide structure, and a sulfone structure.

Examples and preferred examples of the constitutional unit DU and the constitutional unit AU are the same as the examples and preferred examples of the constitutional unit DU and the constitutional unit AU described in the polymer that can be contained in the p-type semiconductor material of the first embodiment.

When the amount of all constitutional units contained in the polymer that can be contained in the p-type semiconductor material is 100 mol%, the total amount of the constitutional unit DU and the constitutional unit AU is preferably 20 mol% or more, more preferably 40 mol% or more, and still more preferably 50 mol%, in terms of improving charge transportability as the p-type semiconductor material, but is usually 100 mol% or less, and may be 100 mol%.

In the p-type semiconductor material that can be contained in the active layer, a weight ratio of the polymer is preferably 90 wt% or more, more preferably 95 wt% or more, and still more preferably 98 wt% or more, but is usually 100 wt% or less, and may be 100 wt%.

(n-Type Semiconductor Material)

The n-type semiconductor material contains a non-fullerene compound. The non-fullerene compound contains a moiety DP having an electron donating property and a moiety AP having an electron accepting property. The moiety AP includes one or more pairs of atoms $\pi$-bonded to each other.

$APD_{max}$ is preferably 0.05 or more, more preferably 0.4 or more, still more preferably 0.5 or more, and still more preferably 0.8 or more, under the condition in which Expression (b) is satisfied.

$DPD_{max}$ is preferably less than 0.7, more preferably less than 0.3, still more preferably less than 0.1, and still more preferably less than 0.04, under the condition in which Expression (b) is satisfied.

In the non-fullerene compound, a plurality of moieties DP may exist, and a plurality of moieties AP may exist.

It is preferable that the moiety DP does not have any one of a ketone structure, a sulfoxide structure, and a sulfone structure.

Examples of the moiety AP include a moiety having a ketone structure, a moiety having an imine structure, a moiety having a sulfoxide structure, and a moiety having a sulfone structure.

Examples of the non-fullerene compound in the present embodiment include a compound represented by Formula (III) and a compound having a perylene tetracarboxylic acid diimide structure. Examples and preferred examples of the compound represented by Formula (III) and examples and preferred examples of the compound having a perylene tetracarboxylic acid diimide structure are the same as the examples and preferred examples described in the first embodiment.

In the n-type semiconductor material that can be contained in the active layer, a weight ratio of the non-fullerene compound is preferably 90 wt% or more, more preferably 95 wt% or more, and still more preferably 98 wt% or more, but is usually 100 wt% or less, and may be 100 wt%.

Even in the present embodiment, similar to the first embodiment, a relationship between an energy level value of each of a HOMO and a LUMO of the polymer as the p-type semiconductor material and an energy level value of each of a HOMO and a LUMO of the non-fullerene compound as the n-type semiconductor material can be appropriately set in a range in which the photodetector is operated. In addition, a range of the value of $\Delta HO = |HOn| - |HOp|$ and a range of the value of $\Delta LU = |LUn| - |LUp|$ may be the same as the ranges described in the first embodiment.

[1.3. Characteristics of Photodetector]

In the photodetector of the embodiment, a dark current ratio (dark current (-3 V)/dark current (-0.5 V)) is preferably 20 or less, more preferably 10 or less, and still more preferably 8 or less. It is preferable that the value is smaller, and the dark current ratio may be, for example, 1 or more.

When the dark current ratio is large, it may be necessary to greatly change a design of the device according to a dark current value when the photodetector is mounted on various devices to be used with different reverse biases applied. Since the photodetector of the embodiment has a small dark current ratio, it is not necessary to greatly change the design of the device according to the dark current value even when the photodetector is mounted on various devices.

[1.4. Method of Manufacturing Photodetector]

The photodetector of the embodiment can be manufactured by a known method. For example, the photodetector can be manufactured by laminating an electrode and layers such as an intermediate layer and an active layer on a substrate by a method such as a vapor deposition method or a coating method.

[1.5. Use of Photodetector]

The photodetector of the embodiment can allow a photocurrent to flow by irradiating light from the transparent or translucent electrode in a state in which a voltage (reverse bias voltage) is applied between the electrodes, and can be operated as a photodetector (photosensor). In addition, the photodetector can also be used as an image sensor by integrating a plurality of photodetectors.

The photodetector according to the present embodiment can be applied to a detection unit (sensor) included in various electronic devices such as a workstation, a personal computer, a portable information terminal, an access management system, a digital camera, and a medical device.

In particular, the photodetector according to the present embodiment can be applied to an image sensor and a biometric authentication device.

The photodetector of the present embodiment is included in the above-described exemplary electronic devices, and can be preferably applied to, for example, an image detection unit (for example, an image sensor such as an X-ray sensor) for a solid-state imaging device such as an X-ray imaging device or a CMOS image sensor, a detection unit (for example, a near-infrared sensor) that detects a predetermined feature of a part of a living body such as a fingerprint detection unit, a face detection unit, a vein detection unit, or an iris detection unit, and a detection unit of an optical biosensor such as a pulse oximeter.

Hereinafter, configuration examples of the image detection unit for a solid-state imaging device and the fingerprint detection unit for a biometric authentication device (for example, a fingerprint authentication device or the like) among the detection units to which the photodetector according to the present embodiment can be preferably applied will be described with reference to the drawings.

(Image Detection Unit)

Fig. 2 is a view schematically illustrating a configuration of an image detection unit for a solid-state imaging device.

An image detection unit 1 includes a CMOS transistor substrate 20, an interlayer insulating film 30 provided so as to cover the CMOS transistor substrate 20, a photodetector 10 according to the embodiment of the present invention provided on the interlayer insulating film 30, an interlayer wiring portion 32 provided so as to penetrate through the interlayer insulating film 30 and electrically connecting the CMOS transistor substrate 20 and the photodetector 10, a sealing layer 40 provided so as to cover the photodetector 10, and a color filter 50 provided on the sealing layer 40.

The CMOS transistor substrate 20 is included in a form according to a design with any suitable conventionally known configuration.

The CMOS transistor substrate 20 includes a functional element such as a CMOS transistor circuit (MOS transistor circuit) for realizing various functions that includes a transistor, a capacitor, and the like formed in a thickness of the substrate.

Examples of the functional element include a floating diffusion, a reset transistor, an output transistor, and a selection transistor.

With such a functional element, a wiring, and the like, a signal reading circuit and the like are built in the CMOS transistor substrate 20.

The interlayer insulating film 30 can be formed of any suitable conventionally known insulating material such as silicon oxide or an insulating resin. The interlayer wiring portion 32 can be formed of any suitable conventionally known conductive material (wiring material) such as copper or tungsten. The interlayer wiring portion 32 may be, for example, an in-hole wiring simultaneously formed with formation of a wiring layer or a buried plug formed separately from the wiring layer.

The sealing layer 40 can be formed of any suitable conventionally known material under a condition in which permeation of harmful substances such as oxygen and water that may cause functional deterioration of the photodetector 10 can be prevented or suppressed. The sealing layer 40 can have the same configuration as the sealing member 17 described above.

As the color filter 50, for example, a primary color filter formed of any suitable conventionally known material and corresponding to the design of the image detection unit 1 can be used. In addition, as the color filter 50, a complementary color filter capable of reducing the thickness as compared with the primary color filter can also be used. As the complementary color filter, for example, a color filter in which three types of (yellow, cyan, and magenta), three types of (yellow, cyan, and transparent), three types of (yellow, transparent, magenta), and three types of (transparent, cyan, and magenta) are combined can be used. This color filter can be arbitrarily preferably arranged corresponding to the design of the photodetector 10 and the CMOS transistor substrate 20 on the condition that the color image data can be generated.

Light received by the photodetector 10 through the color filter 50 is converted into an electrical signal according

to the amount of received light by the photodetector 10, and is output to the outside of the photodetector 10 through the electrodes as a light reception signal, that is, an electrical signal corresponding to an imaging target.

Then, the light reception signal output from the photodetector 10 is input to the CMOS transistor substrate 20 via the interlayer wiring portion 32, is read by the signal reading circuit built in the CMOS transistor substrate 20, and is subjected to signal processing by a further suitable conventionally known functional unit (not illustrated), such that image information is generated based on the imaging target.

(Fingerprint Detection Unit)

Fig. 3 is a view schematically illustrating a configuration example of a fingerprint detection unit integrally configured in a display device.

A display device 2 of a portable information terminal includes a fingerprint detection unit 100 including the photodetector 10 according to the embodiment of the present invention as a main constituent element, and a display panel unit 200 provided on the fingerprint detection unit 100 and displaying a predetermined image.

In the configuration example, the fingerprint detection unit 100 is provided in an area substantially coinciding with a display area 200a of the display panel unit 200. In other words, the display panel unit 200 is integrally laminated on the fingerprint detection unit 100.

In a case where the fingerprint detection unit is performed only in a partial area of the display area 200a, the fingerprint detection unit 100 may be provided corresponding to only the partial area.

The fingerprint detection unit 100 includes the photodetector 10 according to the present embodiment of the present invention as a functional unit exhibiting an essential function. The fingerprint detection unit 100 can include any suitable conventionally known member such as a protection film, a support substrate, a sealing substrate, a sealing member, a barrier film, a bandpass filter, or an infrared cut film (not illustrated) in a form corresponding to a design that can obtain desired characteristics. The configuration of the image detection unit described above can also be adopted for the fingerprint detection unit 100.

The photodetector 10 can be included in the display area 200a in any form. For example, a plurality of photodetectors 10 may be arranged in a matrix.

As described above, the photodetector 10 is provided on the support substrate 11, and electrodes (anode and cathode) are provided in the support substrate 11 in, for example, a matrix.

The light received by the photodetector 10 is converted into an electrical signal according to the amount of received light by the photodetector 10, and is output to the outside of the photodetector 10 through the electrodes as a light reception signal, that is, an electrical signal corresponding to an imaged fingerprint.

In this configuration example, the display panel unit 200 is configured as an organic electroluminescent display panel (organic EL display panel) including a touch sensor panel. For example, instead of the organic EL display panel, the display panel unit 200 may be configured as a display panel having any suitable conventionally known configuration such as a liquid crystal display panel including a light source such as a backlight.

The display panel unit 200 is provided on the fingerprint detection unit 100 described above. The display panel unit 200 includes an organic electroluminescent element (organic EL element) 220 as a functional unit exhibiting an essential function. The display panel unit 200 may further include any suitable conventionally known member such as a substrate (a support substrate 210 or a sealing substrate 240) such as a suitable conventionally known glass substrate, a sealing member, a barrier film, a polarizing plate such as a circular polarizing plate, or a touch sensor panel 230, in a form corresponding to desired characteristics.

In the configuration examples described above, the organic EL element 220 is used as a light source of a pixel in the display area 200a, and is also used as a light source for imaging a fingerprint in the fingerprint detection unit 100.

Here, an operation of the fingerprint detection unit 100 will be briefly described.

At the time of executing fingerprint authentication, the fingerprint detection unit 100 detects a fingerprint using light emitted from the organic EL element 220 of the display panel unit 200. Specifically, the light emitted from the organic EL element 220 passes through a constituent element existing between the organic EL element 220 and the photodetector 10 of the fingerprint detection unit 100, and is reflected by the skin (finger surface) of the fingertip of the finger placed so as to be in contact with a surface of the display panel unit 200 in the display area 200a. At least a part of the light reflected by the finger surface is transmitted through the constituent element existing between the organic EL element 220 and the photodetector 10, and is converted into an electrical signal corresponding to the amount of light received by the photodetector 10. Then, image information on the fingerprint of the finger surface is obtained from the converted electrical signal.

The portable information terminal including the display device 2 performs fingerprint authentication by comparing the obtained image information with previously recorded fingerprint data for fingerprint authentication by any suitable conventionally known step.

[2. Composition]

A composition according to the present embodiment of the present invention contains a p-type semiconductor material and an n-type semiconductor material. One kind of a p-type semiconductor material or a combination of two or more kinds of p-type semiconductor materials may be contained in the composition. In addition, one kind of an n-type semiconductor material or a combination of two or more kinds of p-type semiconductor materials may be contained in the composition. The p-type semiconductor material contains a polymer. The n-type semiconductor material contains a non-fullerene compound. The polymer and the non-fullerene material contained in the composition will be described below.
The composition can be used for forming the active layer of the photodetector. The composition can be preferably used for forming the active layer of the photodetector by a coating method as a form of an ink containing a solvent.
In addition to the polymer and the non-fullerene compound, the composition can contain optional components as long as the effect of the present invention is not inhibited.
Examples of the optional components include a p-type semiconductor material other than the polymer, an n-type semiconductor material other than the non-fullerene compound, a solvent, a surfactant, an ultraviolet absorber, an antioxidant, a sensitizer for sensitizing a function of generating charges by absorbed light, and a light stabilizer for increasing stability from ultraviolet rays.
A weight ratio (polymer/non-fullerene compound) of the polymer as a p-type semiconductor material to the non-fullerene compound as an n-type semiconductor material in the composition is preferably 1/0.1 or less and more preferably 1/0.5 or less, but is preferably 1/100 or more and more preferably 1/5 or more.
The composition may be in a form of an ink containing a solvent in addition to the n-type semiconductor material and the p-type semiconductor material. A concentration of each of the n-type semiconductor material and the p-type semiconductor material in the ink may be any concentration depending on solubility of each material in the solvent and the like.
For example, a concentration of the polymer in the ink is preferably 0.1 wt% or more and more preferably 0.5 wt% or more, but is preferably 10 wt% or less and more preferably 5 wt% or less.
In addition, for example, a concentration of the non-fullerene compound in the ink is preferably 0.1 wt% or more and more preferably 1.0 wt% or more, but is preferably 20 wt% or less and more preferably 10 wt% or less.
Examples of the solvent that can be contained in the composition include an aromatic hydrocarbon solvent, a halogenated hydrocarbon solvent, a ketone solvent, and an ester solvent, and a mixed solvent thereof. Specific examples of the aromatic hydrocarbon solvent include toluene, xylene (for example, o-xylene, m-xylene, or p-xylene), trimethylbenzene (for example, mesitylene or 1,2,4-trimethylbenzene (pseudocumene)), butylbenzene (for example, n-butylbenzene, sec-butylbenzene, or tert-butylbenzene), methylnaphthalene (for example, 1-methylnaphthalene), tetralin, and indane.
Examples of the halogenated hydrocarbon solvent include chlorobenzene and dichlorobenzene (for example, 1,2-dichlorobenzene).
Examples of the ketone solvent include acetone, methyl ethyl ketone, cyclohexanone, acetophenone, and propiophenone.
Examples of the ester solvent include ethyl acetate, butyl acetate, phenyl acetate, ethyl cellosolve acetate, methyl benzoate, butyl benzoate, and benzyl benzoate.
The ink can be prepared by a known method. For example, the ink can be prepared by adding and mixing the materials described above to the selected solvent (in a case where a plurality of kinds of solvents are used, a mixed solvent) and dissolving or dispersing the materials. The solvent and the materials may be mixed by heating at a temperature equal to or lower than a boiling point of the solvent.
After mixing the solvent and the materials, the obtained mixture may be filtered using a filter, and the obtained filtrate may be used as an ink. As the filter, for example, a filter formed of a fluororesin such as polytetrafluoroethylene (PTFE) can be used.
Hereinafter, the polymer and the non-fullerene material contained in the composition will be described.

[2.1. Embodiment C1]

A composition according to an embodiment C1 contains a p-type semiconductor material and an n-type semiconductor material. The p-type semiconductor material contains a polymer having a HOMO with an energy level of -5.45 eV or less, and the n-type semiconductor material contains a non-fullerene compound.
Examples and preferred examples of the polymer having a HOMO of -5.45 eV or less that can be contained in the composition according to the present embodiment are the same as the examples and preferred examples shown in the description of [1. Photodetector]. In addition, examples and preferred examples of the non-fullerene compound that can be contained in the composition according to the present embodiment are the same as the examples and

preferred examples shown in the description of [1. Photodetector].

[2.2. Embodiment C2]

A composition according to an embodiment C2 contains a p-type semiconductor material and an n-type semiconductor material. The p-type semiconductor material contains a polymer containing a constitutional unit DU having an electron donating property and a constitutional unit AU having an electron accepting property, and the constitutional unit DU includes one or more pairs of atoms π-bonded to each other. The constitutional unit AU includes one or more pairs of atoms n-bonded to each other.
The n-type semiconductor material contains a non-fullerene compound.
The non-fullerene compound contains a moiety DP having an electron donating property and a moiety AP having an electron accepting property. The moiety DP includes one or more pairs of atoms n-bonded to each other. The moiety AP includes one or more pairs of atoms n-bonded to each other.
Among absolute values of differences in electronegativity of the pair of atoms included in the constitutional unit DU and π-bonded to each other, a maximum value is represented by $DUD_{max}$,

among absolute values of differences in electronegativity of the pair of atoms included in the constitutional unit AU and π-bonded to each other, a maximum value is represented by $AUD_{max}$,
among absolute values of differences in electronegativity of the pair of atoms included in the moiety DP and n-bonded to each other, a maximum value is represented by $DPD_{max}$,
among absolute values of differences in electronegativity of the pair of atoms included in the moiety AP and n-bonded to each other, a maximum value is represented by $APD_{max}$, and $DUD_{max}$, $AUD_{max}$, $DPD_{max}$, and $APD_{max}$ satisfy Expression (a) and Expression (b).

Examples and preferred examples of the polymer that can be contained in the composition according to the present embodiment are the same as the examples and preferred examples shown in the description of [1. Photodetector]. In addition, examples and preferred examples of the non-fullerene compound that can be contained in the composition according to the present embodiment are the same as the examples and preferred examples shown in the description of [1. Photodetector].

EXAMPLES

Hereinafter, examples will be described in order to describe the present invention in more detail. The present invention is not limited to the examples described below. The operations described below were performed under the conditions of normal temperature and normal pressure unless otherwise specified.

[Used Compound]

(p-Type Semiconductor Material)

Compounds as p-type semiconductor materials used in examples and comparative examples are as follows.
In the following formulas, "2-EH" represents a 2-ethylhexyl group.

[Chem. 50]

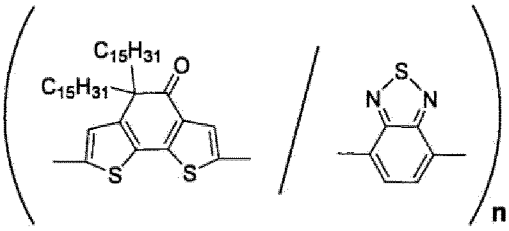

(50:50;mol% ) P-1

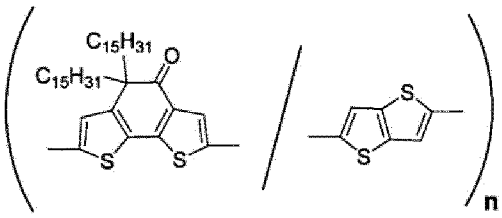

(50:50;mol% ) P-2

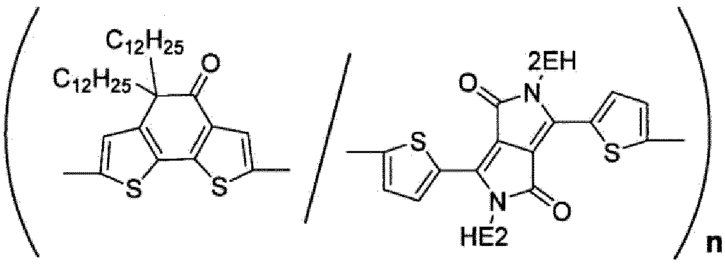

(50:50;mol% ) P-3

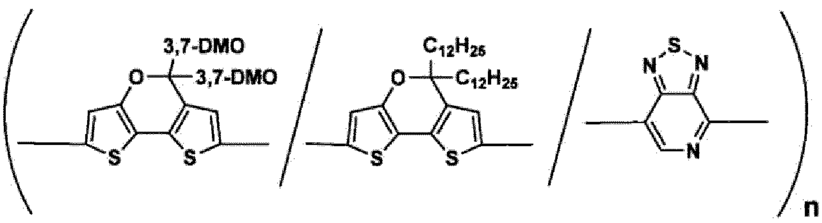

(25:25:50;mol% ) P-4

3,7-DMO = 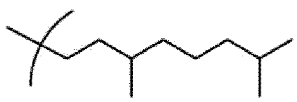

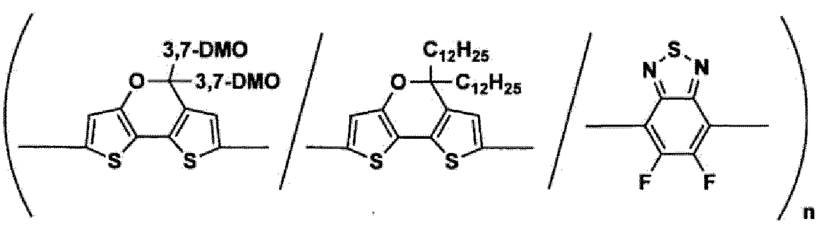

(25:25:50;mol% ) P-5

3,7-DMO = 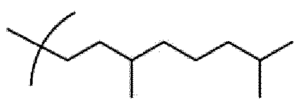

[Chem. 51]

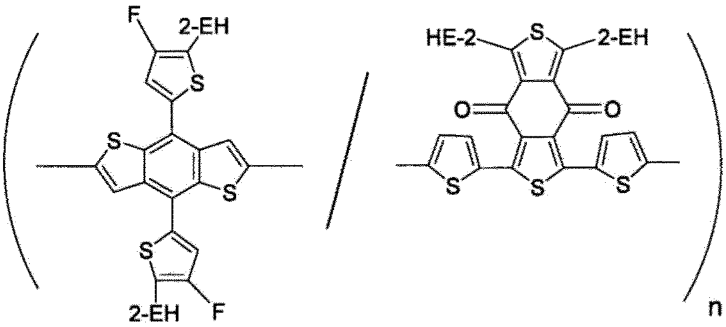

(50:50;mol%) P-6

2-EH =

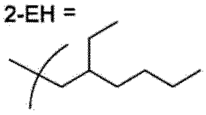

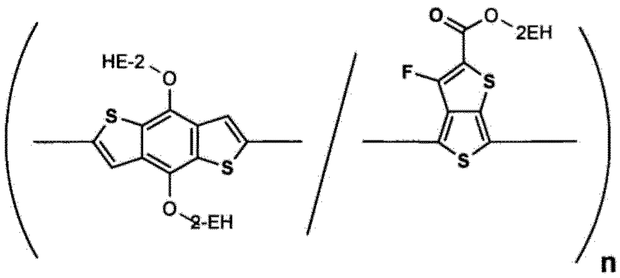

(50:50;mol%) P-7

2-EH =

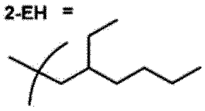

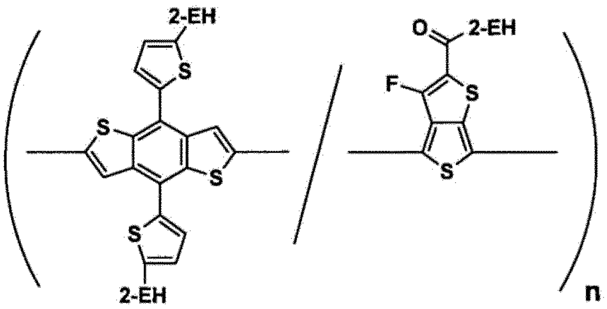

(50:50;mol%) P-8

2-EH =

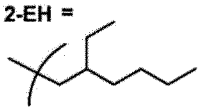

The polymer P-1 was synthesized with reference to the method described in JP-A-2014-31364 and used.

The polymer P-2 was synthesized with reference to the method described in JP-A-2014-31364 and used.

The polymer P-3 was synthesized with reference to the method described in JP-A-2014-31364 and used.

The polymer P-4 was synthesized with reference to the method described in WO 2011/052709 A and used.

The polymer P-5 was synthesized with reference to the method described in WO 2013/051676 A and used.

As the polymer P-6, PM6 (trade name, manufactured by 1-Material Inc.) was obtained from the market and used.

As the polymer P-7, PTB7 (trade name, manufactured by 1-Material Inc.) was obtained from the market and used.

As the polymer P-8, PCE10/PTB7-Th (trade name, manufactured by 1-Material Inc.) was obtained from the market and used.

(n-Type Semiconductor Material)

Compounds as n-type semiconductor materials used in examples and comparative examples are as follows.

[Chem. 52]

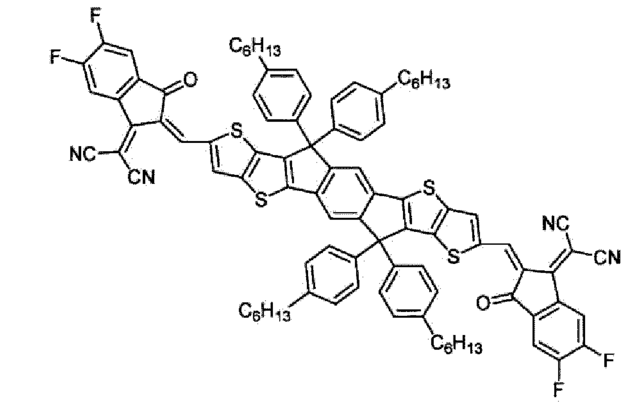

N-1

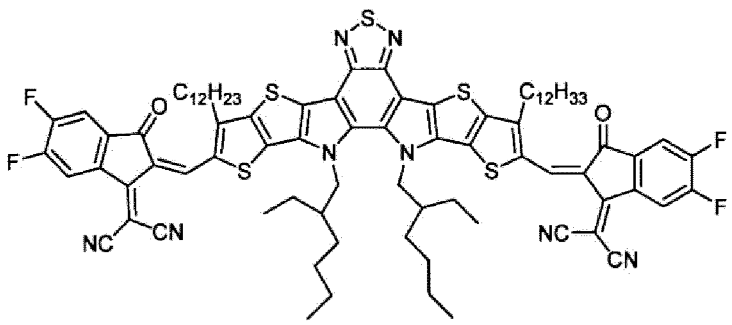

N-2

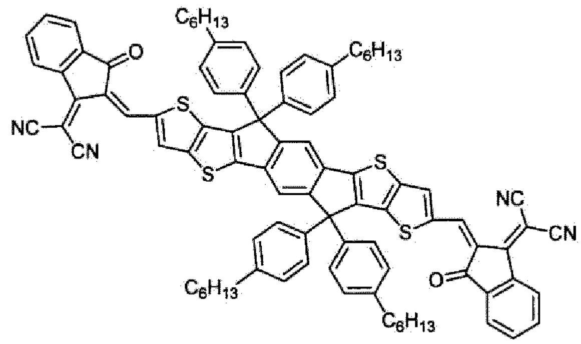

N-3

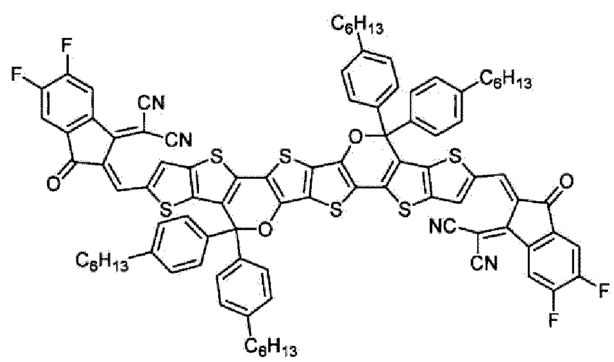

N-4

[Chem. 53]

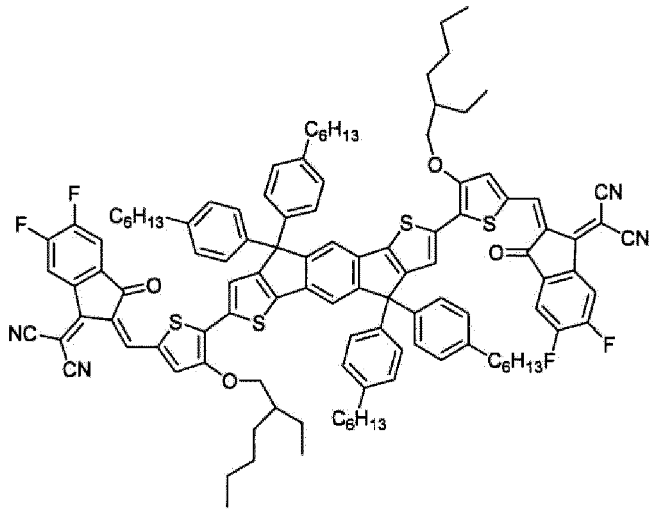

N-5

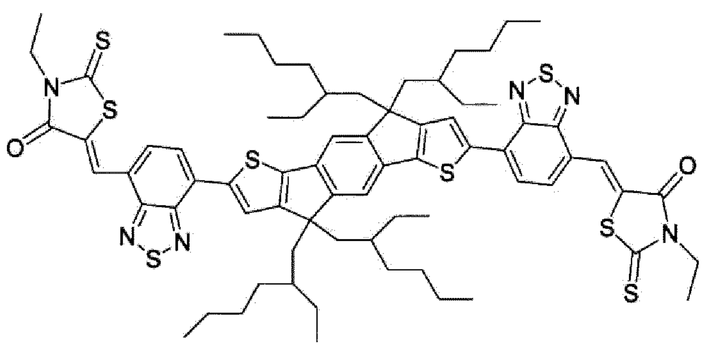

N-6

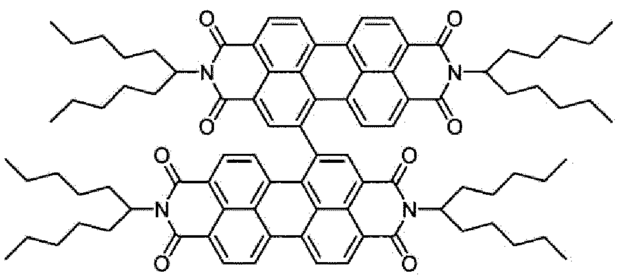

N-7

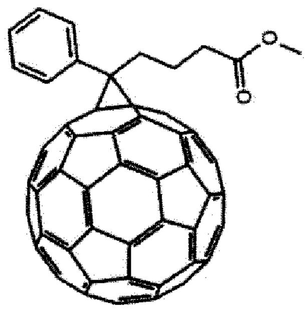

N-8

[Chem. 54]

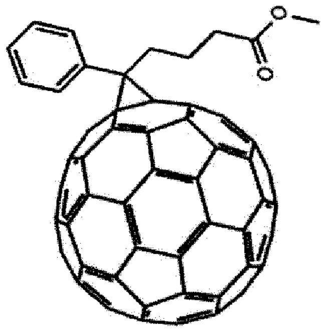

N-9

As the compound N-1, ITIC-4F (trade name, manufactured by 1-Material Inc.) was obtained from the market and used.
As the compound N-2, Y6 (trade name, manufactured by 1-Material Inc.) was obtained from the market and used.
As the compound N-3, ITIC (trade name, manufactured by 1-Material Inc.) was obtained from the market and used.
As the compound N-4, COi8DFIC (trade name, manufactured by 1-Material Inc.) was obtained from the market and used.
As the compound N-5, IEICO-4F (trade name, manufactured by 1-Material Inc.) was obtained from the market and used.
As the compound N-6, EH-IDTBR (trade name, manufactured by 1-Material Inc.) was obtained from the market and used.
As the compound N-7, Di-PDI (trade name, manufactured by 1-Material Inc.) was obtained from the market and used.
As the compound N-8, E100 (trade name, manufactured by Frontier Carbon Corporation, [60]PCBM) was obtained from the market and used.
As the compound N-9, ADS71BFA (trade name, manufactured by American Dye Source, Inc., [70]PCBM) was obtained from the market and used.

(HOMOs, LUMOs, and Absorption Edge Wavelengths of Compounds)

HOMO energy level values (hereinafter, simply referred to as a HOMO) of the compounds used in the respective examples except for the compounds N-8 and N-9 were measured in the atmosphere using a photoelectron spectrometer (model AC-2, manufactured by RIKEN KEIKI CO., LTD.) by ultraviolet photoelectron spectroscopy (UPS method). A sample for measurement was prepared as follows.
A solution was obtained by dissolving the compound used in each example in ortho-dichlorobenzene. Next, the obtained solution was coated onto a glass substrate by a spin coating method to form a coating film, and the solution was dried on a hot plate at 70°C to form a layer having a thickness of 100 nm, thereby obtaining a sample.
In addition, LUMO energy level values (hereinafter, simply referred to as a LUMO) of the compounds used in the respective examples except for the compounds N-8 and N-9 were calculated from a band gap (Eg) and the HOMO energy level value by the following equation.

$$\mathrm{LUMO} = \mathrm{HOMO} + \mathrm{Eg}$$

The band gap was calculated by the following equation using an absorption edge wavelength of the compound.

$$\mathrm{Eg} = hc/\text{absorption edge wavelength}$$

Here, h represents a Planck's constant and c represents a speed of light. $h = 6.626 \times 10^{-34}$ Js and $c = 3 \times 10^{8}$ m/s.
The absorption edge wavelength was determined by the following method.
Using an ultraviolet-visible-near-infrared spectrophotometer "JASCO-V670" (manufactured by JASCO Corporation), an absorption spectrum of a thin film formed of a compound was measured with an absorbance as a vertical axis and a wavelength as a horizontal axis.

In the absorption spectrum, the wavelength at an intersection of a baseline and a straight line fitting to a descending curve on a long wavelength side in an absorption peak curve was defined as the absorption edge wavelength.

As the HOMO and LUMO values of the compounds N-8 and N-9, values estimated from cyclic voltammetry (CV) were used. CV measurement was performed under the following conditions in the same manner as the method described in Nanoscale Research Letters 2011, 6:545 p.

- The measurement was performed with a three-electrode system including a glassy carbon electrode as a working electrode, a platinum wire as a counter electrode, and an $Ag/Ag^+$ electrode as a reference electrode.
- The measurement was performed in a 0.1 M $Bu_4NPF_6$ ("Bu" represents butyl) acetonitrile solution, and a potential was estimated with reference to an internal ferrocene reference (E1/2 = 0.120V vs. $Ag/Ag^+$) measured in the same electrolyte.
- A scan rate was 100 mV/sec.

The energy level of the HOMO, the energy level of the LUMO, and the absorption edge wavelength of the compound used in each example are shown in the following table.

[Table 1]

Table 1

| Compound | HOMO (eV) | LUMO (eV) | Absorption edge wavelength (nm) |
|---|---|---|---|
| P-1 | -5.66 | -4.03 | 760 |
| P-2 | -5.58 | -3.67 | 650 |
| P-3 | -5.33 | -3.85 | 840 |
| P-4 | -5.03 | -3.89 | 1085 |
| P-5 | -5.20 | -3.81 | 892 |
| P-6 | -5.19 | -3.36 | 678 |
| P-7 | -4.99 | -3.32 | 740 |
| P-8 | -5.09 | -3.50 | 780 |
| N-1 | -5.88 | -4.33 | 800 |
| N-2 | -5.79 | -4.51 | 969 |
| N-3 | -5.74 | -4.15 | 780 |
| N-4 | -5.61 | -4.37 | 1000 |
| N-5 | -5.58 | -4.34 | 1000 |
| N-6 | -5.73 | -4.05 | 734 |
| N-7 | -5.76 | -3.73 | 611 |
| N-8 | -6.20 | -4.30 | Not measured |
| N-9 | -6.10 | -4.30 | Not measured |

Table 2 shows $DUD_{max}$, $AUD_{max}$, and a pair of atoms corresponding thereto.

[Table 2]

Table 2

| Compound | $DUD_{max}$ | Pair of atoms with $DUD_{max}$ | $AUD_{max}$ | Pair of atoms with $AUD_{max}$ |
|---|---|---|---|---|
| P-1 | 0.89 | 0/C | 0.49 | N/C |
| P-2 | 0.89 | 0/C | 0.00 | C/C |
| P-3 | 0.89 | 0/C | 0.89 | 0/C |
| P-4 | 0.00 | C/C | 0.49 | N/C |
| P-5 | 0.00 | C/C | 0.49 | N/C |
| P-6 | 0.00 | C/C | 0.89 | 0/C |
| P-7 | 0.00 | C/C | 0.89 | 0/C |
| P-8 | 0.00 | C/C | 0.89 | 0/C |

Table 3 shows $DPD_{max}$, $APD_{max}$, and a pair of atoms corresponding thereto.

[Table 3]

Table 3

| Compound | $DPD_{max}$ | Pair of atoms with $DPD_{max}$ | $APD_{max}$ | Pair of atoms with $APD_{max}$ |
|---|---|---|---|---|
| N-1 | 0.00 | C/C | 0.89 | 0/C |
| N-2 | 0.49 | N/C | 0.89 | 0/C |
| N-3 | 0.00 | C/C | 0.89 | 0/C |
| N-4 | 0.00 | C/C | 0.89 | 0/C |
| N-5 | 0.00 | C/C | 0.89 | 0/C |
| N-6 | 0.00 | C/C | 0.89 | 0/C |
| N-7 | 0.00 | C/C | 0.89 | 0/C |

[Preparation Example 1]

A compound N-1 as an n-type semiconductor material and a polymer P-1 as a p-type semiconductor material were mixed in a 1,2-dichlorobenzene solvent. At that time, the compound N-1 as an n-type semiconductor material was mixed so as to have a concentration of 2 wt% with respect to the total weight of the ink, and the polymer P-1 as a p-type semiconductor material was mixed so as to have a concentration of 2 wt% with respect to the total weight of the ink (n-type semiconductor material/p-type semiconductor material = 1/1). The mixed solution was stirred at 75°C for 3 hours, and then, the mixed solution was filtered using a filter, thereby obtaining an ink (I-1).

[Preparation Examples 2 to 12 and Comparative Preparation Examples 1 to 28]

An n-type semiconductor material and a p-type semiconductor material were used in combinations as shown in the following table. Inks (I-2) to (I-12) and inks (C-1) to (C-28) were prepared in the same manner as that of Preparation Example 1 except for this.

The values of $\Delta HO = |HOn| - |HOp|$ (eV) and the values of $\Delta LU = |LUn| - |LUp|$ (eV) are shown in Table 4. Here, |HOp| and |LUp| are an absolute value of the energy level of the HOMO and an absolute value of the energy level of the LUMO of the polymer as the p-type semiconductor material, respectively, and |HOn| and |LUn| are an absolute value of the energy level of the HOMO and an absolute value of the energy level of the LUMO of the compound as the n-type semiconductor material, respectively.

[Table 4]

Table 4

| | Ink | p-Type semiconductor material | n-Type semiconductor material | ΔHO (eV) | ΔLU (eV) |
|---|---|---|---|---|---|
| Preparation Example 1 | I-1 | P-1 | N-1 | 0.22 | 0.30 |
| Preparation Example 2 | I-2 | P-1 | N-3 | 0.08 | 0.12 |
| Preparation Example 3 | I-3 | P-1 | N-4 | -0.05 | 0.34 |
| Preparation Example 4 | I-4 | P-1 | N-5 | -0.08 | 0.31 |
| Preparation Example 5 | I-5 | P-1 | N-6 | 0.07 | 0.02 |
| Preparation Example 6 | I-6 | P-1 | N-7 | 0.10 | -0.30 |
| Preparation Example 7 | I-7 | P-2 | N-1 | 0.30 | 0.66 |
| Preparation Example 8 | I-8 | P-2 | N-2 | 0.21 | 0.84 |
| Preparation Example 9 | I-9 | P-2 | N-3 | 0.16 | 0.48 |
| Preparation Example 10 | I-10 | P-2 | N-4 | 0.03 | 0.70 |
| Preparation Example 11 | I-11 | P-2 | N-6 | 0.15 | 0.38 |
| Preparation Example 12 | I-12 | P-2 | N-7 | 0.18 | 0.06 |
| Comparative Preparation Example 1 | C-1 | P-1 | N-8 | 0.54 | 0.27 |
| Comparative Preparation Example 2 | C-2 | P-1 | N-9 | 0.44 | 0.27 |
| Comparative Preparation Example 3 | C-3 | P-2 | N-8 | 0.62 | 0.63 |
| Comparative Preparation Example 4 | C-4 | P-2 | N-9 | 0.52 | 0.63 |
| Comparative Preparation Example 5 | C-5 | P-3 | N-7 | 0.43 | -0.12 |
| Comparative Preparation Example 6 | C-6 | P-3 | N-5 | 0.25 | 0.49 |
| Comparative Preparation Example 7 | C-7 | P-3 | N-3 | 0.41 | 0.30 |
| Comparative Preparation Example 8 | C-8 | P-4 | N-1 | 0.85 | 0.44 |
| Comparative Preparation Example 9 | C-9 | P-4 | N-2 | 0.76 | 0.62 |
| Comparative Preparation Example 10 | C-10 | P-4 | N-3 | 0.71 | 0.26 |
| Comparative Preparation Example 11 | C-11 | P-4 | N-6 | 0.70 | 0.16 |
| Comparative Preparation Example 12 | C-12 | P-4 | N-7 | 0.73 | -0.16 |
| Comparative Preparation Example 13 | C-13 | P-4 | N-8 | 1.17 | 0.41 |

(continued)

| | | | | | |
|---|---|---|---|---|---|
| Preparation Example 12 | I-12 | P-2 | N-7 | 0.18 | 0.06 |
| Comparative Preparation Example 14 | C-14 | P-5 | N-1 | 0.68 | 0.52 |
| Comparative Preparation Example 15 | C-15 | P-5 | N-2 | 0.59 | 0.70 |
| Comparative Preparation Example 16 | C-16 | P-5 | N-4 | 0.41 | 0.56 |
| Comparative Preparation Example 17 | C-17 | P-5 | N-5 | 0.38 | 0.53 |
| Comparative Preparation Example 18 | C-18 | P-5 | N-7 | 0.56 | -0.08 |
| Comparative Preparation Example 19 | C-19 | P-5 | N-8 | 1.00 | 0.49 |
| Comparative Preparation Example 20 | C-20 | P-6 | N-1 | 0.69 | 0.97 |
| Comparative Preparation Example 21 | C-21 | P-6 | N-3 | 0.55 | 0.86 |
| Comparative Preparation Example 22 | C-22 | P-6 | N-4 | 0.42 | 1.01 |
| Comparative Preparation Example 23 | C-23 | P-6 | N-7 | 0.57 | 0.37 |
| Comparative Preparation Example 24 | C-24 | P-7 | N-3 | 0.75 | 0.90 |
| Comparative Preparation Example 25 | C-25 | P-7 | N-5 | 0.59 | 1.02 |
| Comparative Preparation Example 26 | C-26 | P-7 | N-6 | 0.74 | 0.73 |
| Comparative Preparation Example 27 | C-27 | P-8 | N-3 | 0.65 | 0.72 |
| Comparative Preparation Example 28 | C-28 | P-8 | N-5 | 0.49 | 0.84 |

[Example 1]

(Manufacture and Evaluation of Photoelectric Conversion Element as Photodetector)

(1) Manufacture of Photoelectric Conversion Element and Sealing Body thereof

A photoelectric conversion element and a sealing body thereof were manufactured in the following procedure.
A glass substrate on which an ITO thin film (first electrode) was formed was prepared at a thickness of 50 nm by a sputtering method, and a surface of the glass substrate was subjected to an ozone UV treatment.
Next, the ink (I-1) was coated onto the ITO thin film by a spin coating method to form a coating film. Then, the coating film was dried by a heat treatment for 10 minutes using a hot plate heated to 100°C under a nitrogen gas atmosphere to form an active layer. A thickness of the formed active layer was about 250 nm.
Next, a calcium (Ca) layer having a thickness of about 5 nm was formed on the formed active layer in a resistance heating vapor deposition device to form an electron transport layer.
Then, a silver (Ag) layer having a thickness of about 60 nm was formed on the formed electron transport layer to form a second electrode.
A photoelectric conversion element as a photodetector was manufactured on a glass substrate by the above

steps.

Next, a UV-curable sealing agent as a sealing material was coated onto a glass substrate as a support substrate so as to surround the periphery of the manufactured photoelectric conversion element, a glass substrate as a sealing substrate was bonded, and then, the photoelectric conversion element was sealed in a gap between the support substrate and the sealing substrate by irradiation with UV light.

Therefore, a sealing body of the photoelectric conversion element as a photodetector was obtained. The photoelectric conversion element sealed in the gap between the support substrate and the sealing substrate had a planar shape of a square of 2 mm × 2 mm when viewed from a thickness direction thereof.

(2) Evaluation of Photoelectric Conversion Element

A dark current when a voltage of 2 V to -10 V was applied to the sealing body of the manufactured photoelectric conversion element in a dark state in which light was not irradiated was measured using a source meter (KEITHLEY 2450 Source Meter, manufactured by Keithley Instruments).

A dark current when a voltage of -3 V was applied was evaluated according to the following criteria.

Good: The dark current was less than 100 $nA/cm^2$.
Poor: The dark current was 100 $nA/cm^2$ or more.

In addition, from the measurement results, a ratio (dark current (-3 V)/dark current (-0.5 V)) of a dark current obtained when a voltage of -3 V was applied to a dark current obtained when a voltage of -0.5 V was applied was determined.

The smaller the dark current ratio is, the more excellent the photodetector is.

The evaluation results are shown in the following table.

[Examples 2 to 12 and Comparative Examples 1 to 28]

The inks (I-2) to (I-12) or the inks (C-1) to (C-28) were used instead of the ink (I-1). Photoelectric conversion elements and sealing bodies thereof according to Examples 2 to 12 and Comparative Examples 1 to 28 were manufactured and evaluated in the same manner as that of Example 1 except for the above matters. The results are shown in the following table.

[Table 5]

Table 5

| | Ink | Dark current ratio (-3 V/-0.5 V) | Dark current (-3 V) evaluation |
|---|---|---|---|
| Example 1 | I-1 | 2.60 | Good |
| Example 2 | I-2 | 2.43 | Good |
| Example 3 | I-3 | 3.18 | Good |
| Example 4 | I-4 | 6.31 | Good |
| Example 5 | I-5 | 1.09 | Good |
| Example 6 | I-6 | 1.16 | Good |
| Example 7 | I-7 | 1.99 | Good |
| Example 8 | I-8 | 1.49 | Good |
| Example 9 | I-9 | 0.94 | Good |
| Example 10 | I-10 | 0.94 | Good |
| Example 11 | I-11 | 1.23 | Good |
| Example 12 | I-12 | 0.41 | Good |
| Comparative Example 1 | C-1 | 35.79 | Poor |

(continued)

| | Ink | Dark current ratio (-3 V/-0.5 V) | Dark current (-3 V) evaluation |
|---|---|---|---|
| Comparative Example 2 | C-2 | 38.08 | Poor |
| Comparative Example 3 | C-3 | 63.07 | Poor |
| Comparative Example 4 | C-4 | 45.20 | Poor |
| Comparative Example 5 | C-5 | 45.12 | Poor |
| Comparative Example 6 | C-6 | 13.16 | Poor |
| Comparative Example 7 | C-7 | 59.22 | Poor |
| Comparative Example 8 | C-8 | 35.34 | Poor |
| Comparative Example 9 | C-9 | 13.21 | Poor |
| Comparative Example 10 | C-10 | 13.28 | Poor |
| Comparative Example 11 | C-11 | 28.23 | Poor |
| Comparative Example 12 | C-12 | 19.01 | Poor |
| Comparative Example 13 | C-13 | 11.37 | Poor |
| Comparative Example 14 | C-14 | 29.11 | Poor |
| Comparative Example 15 | C-15 | 12.45 | Poor |
| Comparative Example 16 | C-16 | 12.91 | Poor |
| Comparative Example 17 | C-17 | 11.99 | Poor |
| Comparative Example 18 | C-18 | 12.76 | Poor |
| Comparative Example 19 | C-19 | 12.89 | Poor |
| Comparative Example 20 | C-20 | 45.20 | Poor |
| Comparative Example 21 | C-21 | 54.57 | Poor |
| Comparative Example 22 | C-22 | 38.08 | Poor |
| Comparative Example 23 | C-23 | 23.78 | Poor |
| Comparative Example 24 | C-24 | 13.79 | Poor |
| Comparative Example 25 | C-25 | 22.57 | Poor |
| Comparative Example 26 | C-26 | 21.64 | Poor |
| Comparative Example 27 | C-27 | 11.56 | Poor |
| Comparative Example 28 | C-28 | 70.25 | Poor |

According to the above results, the photodetector according to the example has a significantly smaller dark current ratio and a smaller dark current when a voltage of -3 V is applied than the photodetector according to the comparative example.

DESCRIPTION OF REFERENCE SIGNS

| | |
|---|---|
| 1 | Image detection unit |
| 2 | Display device |
| 10 | Photodetector |
| 11, 210 | Support substrate |
| 12 | First electrode |
| 13 | Hole transport layer |

14 Active layer
15 Electron transport layer
16 Second electrode
17 Sealing member
20 CMOS transistor substrate
30 Interlayer insulating film
32 Interlayer wiring portion
40 Sealing layer
50 Color filter
100 Fingerprint detection unit
200 Display panel unit
200a Display area
220 Organic EL element
230 Touch sensor panel
240 Sealing substrate

## Claims

**1.** A photodetector comprising: a first electrode; a second electrode; and an active layer provided between the first electrode and the second electrode,

wherein the active layer contains a p-type semiconductor material and an n-type semiconductor material,
the p-type semiconductor material contains a polymer having the highest occupied molecular orbital (HOMO) of - 5.45 eV or less, and
the n-type semiconductor material contains a non-fullerene compound.

**2.** A photodetector comprising: a first electrode; a second electrode; and an active layer provided between the first electrode and the second electrode,

wherein the active layer contains a p-type semiconductor material and an n-type semiconductor material,
the p-type semiconductor material contains a polymer containing a constitutional unit DU having an electron donating property and a constitutional unit AU having an electron accepting property,
the n-type semiconductor material contains a non-fullerene compound,
the constitutional unit DU includes one or more pairs of atoms n-bonded to each other, and among absolute values of differences in electronegativity of the pairs of atoms n-bonded to each other, a maximum value is represented by $DUD_{max}$,
the constitutional unit AU includes one or more pairs of atoms n-bonded to each other, and among absolute values of differences in electronegativity of the pairs of atoms n-bonded to each other, a maximum value is represented by $AUD_{max}$,
the non-fullerene compound contains a moiety DP having an electron donating property and a moiety AP having an electron accepting property,
the moiety DP includes one or more pairs of atoms n-bonded to each other, and among absolute values of differences in electronegativity of the pairs of atoms n-bonded to each other, a maximum value is represented by $DPD_{max}$,
the moiety AP includes one or more pairs of atoms n-bonded to each other, and among absolute values of differences in electronegativity of the pairs of atoms n-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

**3.** The photodetector according to claim 1, wherein the polymer contained in the p-type semiconductor material contains a constitutional unit DU having an electron donating property and a constitutional unit AU having an electron accepting property, and the non-fullerene compound contains a moiety DP having an electron donating property and a moiety AP having an electron accepting property.

**4.** The photodetector according to claim 3, wherein the constitutional unit DU includes one or more pairs of atoms n-bonded to each other, and among absolute values of differences in electronegativity of the pairs of atoms n-bonded to each other, a maximum value is represented by $DUD_{max}$,

the constitutional unit AU includes one or more pairs of atoms n-bonded to each other, and among absolute values of differences in electronegativity of the pairs of atoms n-bonded to each other, a maximum value is represented by $AUD_{max}$,
the moiety DP includes one or more pairs of atoms n-bonded to each other, and among absolute values of differences in electronegativity of the pairs of atoms n-bonded to each other, a maximum value is represented by $DPD_{max}$,
the moiety AP includes one or more pairs of atoms n-bonded to each other, and among absolute values of differences in electronegativity of the pairs of atoms n-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

**5.** The photodetector according to any one of claims 2 to 4, wherein the constitutional unit DU has a ketone structure, an imine structure, a sulfoxide structure, or a sulfone structure.

**6.** The photodetector according to any one of claims 2 to 5, wherein the moiety AP has a ketone structure, an imine structure, a sulfoxide structure, or a sulfone structure.

**7.** The photodetector according to any one of claims 1 to 6, wherein the polymer contained in the p-type semiconductor material contains a constitutional unit represented by the following Formula (I):

[Chem. 1]

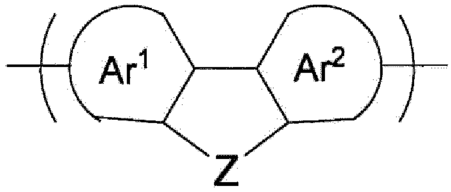

(I)

in the formula,
$Ar^1$ and $Ar^2$ each independently represent an aromatic carbocyclic ring which may have a substituent or an aromatic heterocyclic ring which may have a substituent, and
Z represents a group represented by any one of the following Formulas (Z-1) to (Z-4),

[Chem. 2]

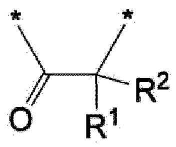

(Z-1)

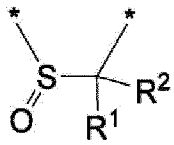

(Z-2)

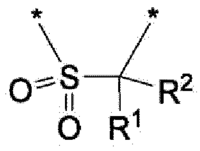

(Z-3)

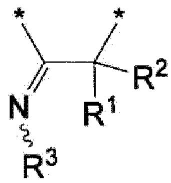

(Z-4)

wherein $R^1$, $R^2$, and $R^3$ each independently represent
a hydrogen atom,
a halogen atom,
an alkyl group which may have a substituent,
a cycloalkyl group which may have a substituent,
an alkenyl group which may have a substituent,
a cycloalkenyl group which may have a substituent,
an alkynyl group which may have a substituent,
a cycloalkynyl group which may have a substituent,
an alkyloxy group which may have a substituent,
an alkylthio group which may have a substituent,
an aryl group which may have a substituent,
an aryloxy group which may have a substituent,
an arylthio group which may have a substituent,
a monovalent heterocyclic group which may have a substituent,
a group represented by $-C(=O)-R^a$, or
a group represented by $-SO_2-R^b$, and
$R^a$ and $R^b$ each independently represent
a hydrogen atom,
an alkyl group which may have a substituent,
an aryl group which may have a substituent,
an alkyloxy group which may have a substituent,
an aryloxy group which may have a substituent, or
a monovalent heterocyclic group which may have a substituent.

**8.** The photodetector according to claim 7, wherein the polymer contained in the p-type semiconductor material contains a constitutional unit represented by the following Formula (II):
[Chem. 3]

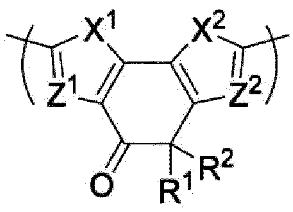

( I I )

in the formula,
$X^1$ and $X^2$ each independently represent a sulfur atom or an oxygen atom,
$Z^1$ and $Z^2$ each independently represent a group represented by $=C(-R^4)-$ or a nitrogen atom,
$R^1$ and $R^2$ represent the same meanings as described above,
$R^4$ represents
a hydrogen atom,
a halogen atom,
an alkyl group which may have a substituent,
a cycloalkyl group which may have a substituent,
an alkenyl group which may have a substituent,

a cycloalkenyl group which may have a substituent,
an alkynyl group which may have a substituent,
a cycloalkynyl group which may have a substituent,
an alkyloxy group which may have a substituent,
an alkylthio group which may have a substituent,
an aryl group which may have a substituent,
an aryloxy group which may have a substituent,
an arylthio group which may have a substituent,
a monovalent heterocyclic group which may have a substituent,
a group represented by $-C(=O)-R^a$, or
a group represented by $-SO_2-R^b$, and
$R^a$ and $R^b$ each independently represent
a hydrogen atom,
an alkyl group which may have a substituent,
an aryl group which may have a substituent,
an alkyloxy group which may have a substituent,
an aryloxy group which may have a substituent, or
a monovalent heterocyclic group which may have a substituent.

**9.** The photodetector according to any one of claims 1 to 8, wherein the non-fullerene compound contained in the n-type semiconductor material contains a compound represented by the following Formula (III):

$$A^1-B^{10}-A^2 \qquad (III)$$

in the formula,
$A^1$ and $A^2$ each independently represent an electron-withdrawing group, and
$B^{10}$ represents a group having a n-conjugated system.

**10.** The photodetector according to any one of claims 1 to 9, wherein the non-fullerene compound contained in the n-type semiconductor material contains a compound represented by the following Formula (IV):

$$A^1-(S^1)_{n1}-B^{11}-(S^2)_{n2}-A^2 \qquad (IV)$$

in Formula (IV),
$A^1$ and $A^2$ each independently represent an electron-withdrawing group,
$S^1$ and $S^2$ each independently represent
a divalent carbocyclic group which may have a substituent,
a divalent heterocyclic group which may have a substituent,
a group represented by $-C(R^{s1})=C(R^{s2})-$
(where, $R^{s1}$ and $R^{s2}$ each independently represent a hydrogen atom or a substituent), or
a group represented by -C=C-,
$B^{11}$ is a fused ring group having two or more structures selected from the group consisting of a carbocyclic structure and a heterocyclic structure, or a fused ring group that does not have an ortho-peri-fused structure, and represents a fused ring group which may have a substituent, and
n1 and n2 each independently represent an integer of 0 or more.

**11.** The photodetector according to claim 10, wherein $B^{11}$ is a fused ring group having two or more structures selected from the group consisting of structures represented by the following Formulas (Cy1) to (Cy9), or a fused ring group which may have a substituent,

[Chem. 4]

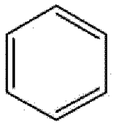
(Cy1)

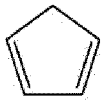
(Cy2)

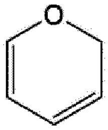
(Cy3)

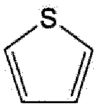
(Cy4)

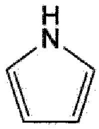
(Cy5)

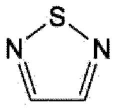
(Cy6)

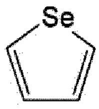
(Cy7)

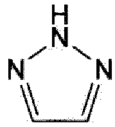
(Cy8)

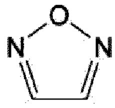
(Cy9)

.

**12.** The photodetector according to claim 10 or 11, wherein $S^1$ and $S^2$ each independently represent a group represented by any one of the following Formulas (s-1) and (s-2),

[Chem. 5]

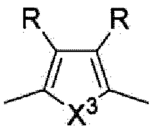
**(s-1)**

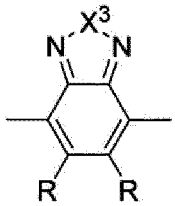
**(s-2)**

in Formula (s-1) and Formula (s-2),
$X^3$ represents an oxygen atom or a sulfur atom, and
a plurality of R's each independently represent a hydrogen atom or a substituent.

**13.** The photodetector according to any one of claims 9 to 12, wherein $A^1$ and $A^2$ each independently represent -CH=C(-CN)$_2$ or a group represented by any one of the following Formulas (a-1) to (a-9),

[Chem. 6]

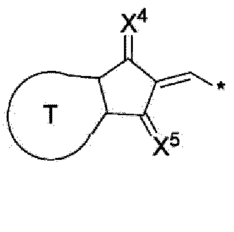

(a-1)

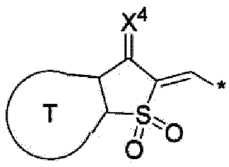

(a-2)

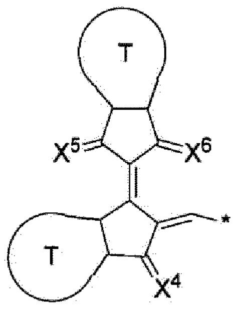

(a-3)

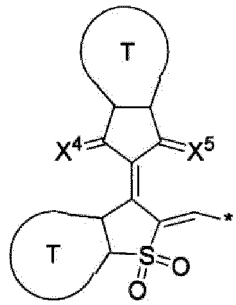

(a-4)

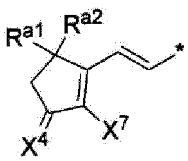

(a-5)

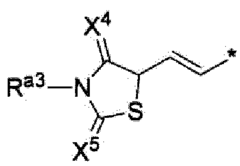

(a-6)

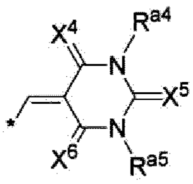

(a-7)

in Formulas (a-1) to (a-7),
T represents a carbocyclic ring which may have a substituent or a heterocyclic ring which may have a substituent,
$X^4$, $X^5$, and $X^6$ each independently represent an oxygen atom, a sulfur atom, an alkylidene group, or a group represented by $=C(-CN)_2$,
$X^7$ represents a hydrogen atom, a halogen atom, a cyano group, an alkyl group which may have a substituent, an alkyloxy group which may have a substituent, an aryl group which may have a substituent, or a monovalent heterocyclic group which may have a substituent, and
$R^{a1}$, $R^{a2}$, $R^{a3}$, $R^{a4}$, and $R^{a5}$ each independently represent a hydrogen atom, a halogen atom, an alkyl group which may have a substituent, an alkyloxy group which may have a substituent, an aryl group which may have a substituent, or a monovalent heterocyclic group which may have a substituent,

[Chem. 7]

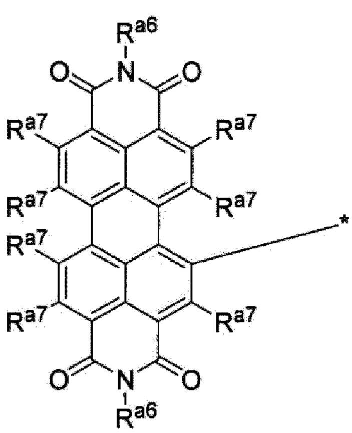

(a-8)

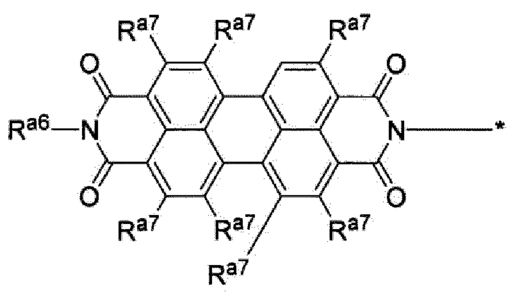

(a-9)

in Formula (a-8) and Formula (a-9),
$R^{a6}$ and $R^{a7}$ each independently represent
a hydrogen atom,
a halogen atom,
an alkyl group which may have a substituent,
a cycloalkyl group which may have a substituent,
an alkyloxy group which may have a substituent,
a cycloalkyloxy group which may have a substituent,
a monovalent aromatic carbocyclic group which may have a substituent, or
a monovalent aromatic heterocyclic group which may have a substituent, and
a plurality of $R^{a6}$'s and a plurality of $R^{a7}$'s may be the same as or different from each other.

**14.** The photodetector according to any one of claims 1 to 8, wherein the non-fullerene compound contains a compound represented by the following Formula (V) or (VI):

[Chem. 8]

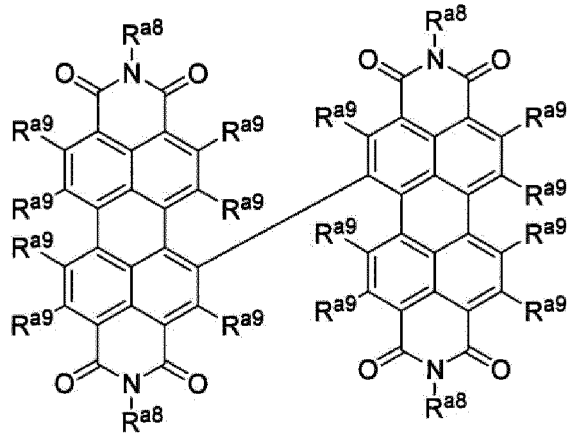

(V)

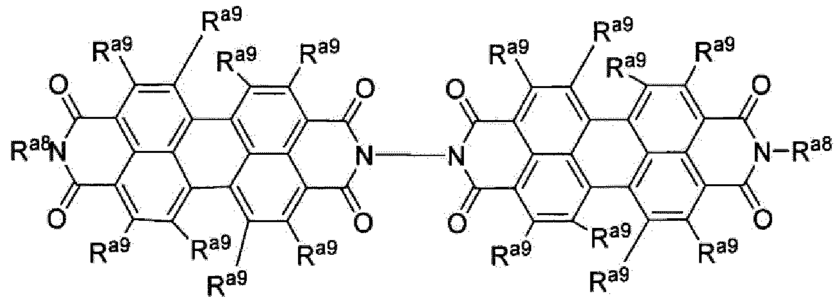

(VI)

in the formula,
$R^{a8}$ and $R^{a9}$ each independently represent
a hydrogen atom,
a halogen atom,
an alkyl group which may have a substituent,
a cycloalkyl group which may have a substituent,
an alkyloxy group which may have a substituent,
a cycloalkyloxy group which may have a substituent,
a monovalent aromatic carbocyclic group which may have a substituent, or
a monovalent aromatic heterocyclic group which may have a substituent, and
a plurality of $R^{a8}$'s and a plurality of $R^{a9}$'s may be the same as or different from each other.

**15.** A sensor comprising the photodetector according to any one of claims 1 to 14.

**16.** A biometric authentication device comprising the photodetector according to any one of claims 1 to 14.

**17.** An X-ray sensor comprising the photodetector according to any one of claims 1 to 14.

**18.** A near-infrared sensor comprising the photodetector according to any one of claims 1 to 14.

**19.** A composition comprising a p-type semiconductor material and an n-type semiconductor material,

wherein the p-type semiconductor material contains a polymer having a HOMO of -5.45 eV or less, and
the n-type semiconductor material contains a non-fullerene compound.

**20.** A composition comprising a p-type semiconductor material and an n-type semiconductor material,

wherein the p-type semiconductor material contains a polymer containing a constitutional unit DU having an electron donating property and a constitutional unit AU having an electron accepting property,
the n-type semiconductor material contains a non-fullerene compound,
the constitutional unit DU includes one or more pairs of atoms n-bonded to each other, and among absolute values of differences in electronegativity of the pairs of atoms n-bonded to each other, a maximum value is represented by $DUD_{max}$,
the constitutional unit AU includes one or more pairs of atoms n-bonded to each other, and among absolute values of differences in electronegativity of the pairs of atoms n-bonded to each other, a maximum value is represented by $AUD_{max}$,
the non-fullerene compound contains a moiety DP having an electron donating property and a moiety AP having an electron accepting property,
the moiety DP includes one or more pairs of atoms n-bonded to each other, and among absolute values of differences in electronegativity of the pairs of atoms π-bonded to each other, a maximum value is represented by $DPD_{max}$,
the moiety AP includes one or more pairs of atoms π-bonded to each other, and among absolute values of differences in electronegativity of the pairs of atoms π-bonded to each other, a maximum value is represented by $APD_{max}$, and
the following Expression (a) and Expression (b):

$$DUD_{max} - AUD_{max} > 0 \qquad (a)$$

$$APD_{max} - DPD_{max} > 0 \qquad (b)$$

are satisfied.

**21.** An ink comprising the composition according to claim 19 or 20.

[FIG. 1]

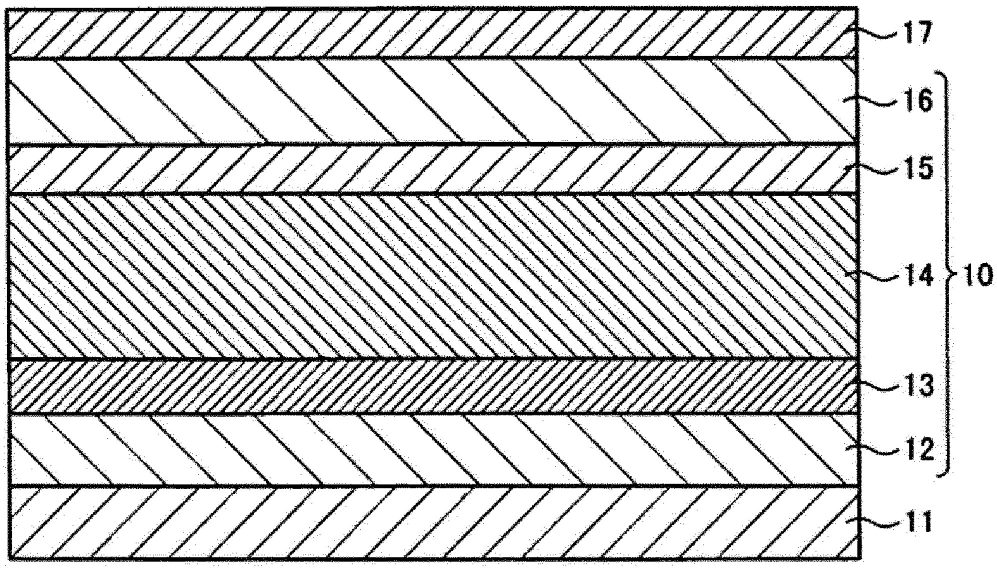


[FIG. 2]

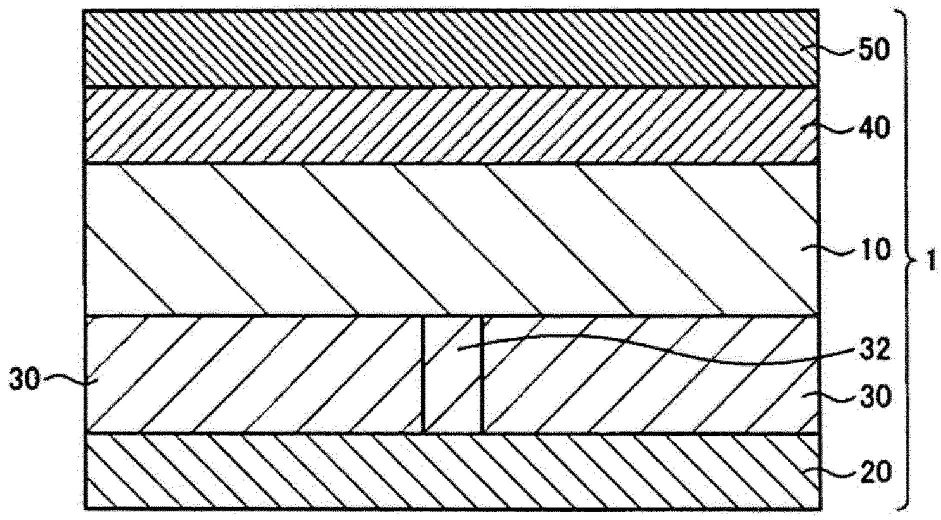


[FIG. 3]

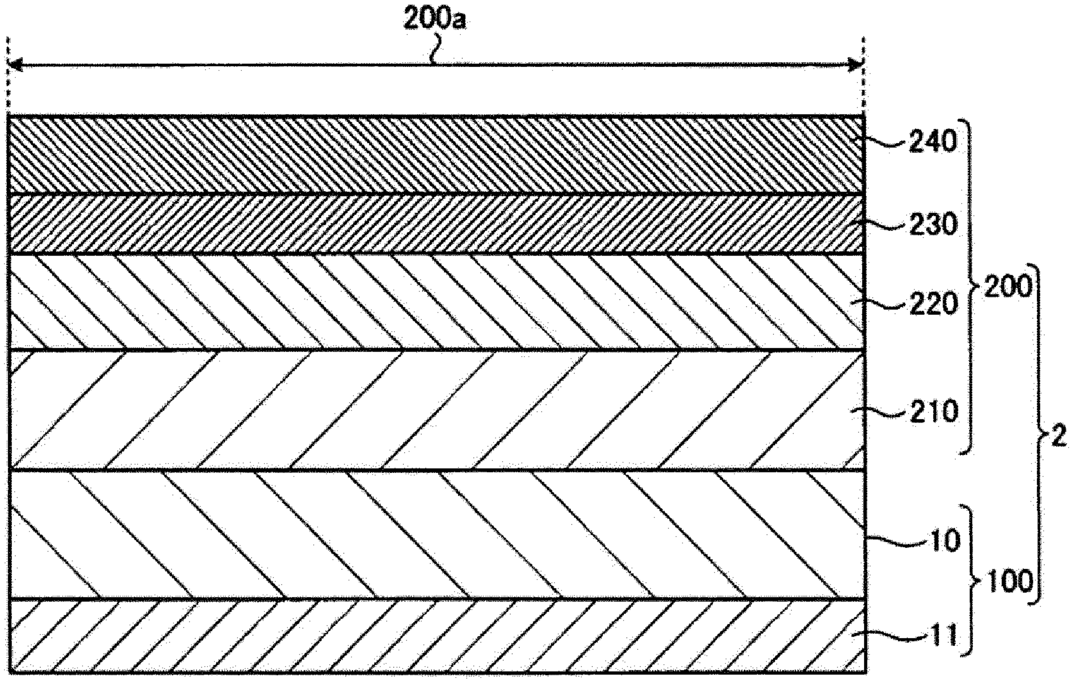
200a
240
230
220
210
200
2
10
100
11

## INTERNATIONAL SEARCH REPORT

International application No.
PCT/JP2021/011596

A. CLASSIFICATION OF SUBJECT MATTER
H01L 51/42(2006.01)i; H01L 31/10(2006.01)i; H01L 27/30(2006.01)i
FI: H01L31/08 T; H01L31/10 A; H01L27/30

According to International Patent Classification (IPC) or to both national classification and IPC

B. FIELDS SEARCHED

Minimum documentation searched (classification system followed by classification symbols)
H01L51/42-51/48; H01L31/08-31/119; H01L27/30

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| Y | WO 2017/126401 A1 (SUMITOMO CHEMICAL CO., LTD.) 27 July 2017 (2017-07-27) paragraphs [0128]-[0129], [0159]-[0161], [0164], [0184], [0195], [0200], [0203] | 1-21 |
| Y | WO 2019/193331 A2 (CAMBRIDGE DISPLAY TECHNOLOGY LIMITED) 10 October 2019 (2019-10-10) specification, page 29, lines 16-22, page 30, line 26 to page 33, line 2 | 1-21 |
| A | JP 2015-220331 A (SUMITOMO CHEMICAL CO., LTD.) 07 December 2015 (2015-12-07) | 1-21 |
| A | US 2017/0057962 A1 (UNIVERSITY OF WASHINGTON) 02 March 2017 (2017-03-02) | 1-21 |

☐ Further documents are listed in the continuation of Box C.

☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 31 May 2021 (31.05.2021) | 08 June 2021 (08.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2021/011596

| Patent Documents referred in the Report | Publication Date | Patent Family | Publication Date |
|---|---|---|---|
| WO 2017/126401 A1 | 27 Jul. 2017 | US 2021/0139643 A1 paragraphs [0179]-[0182], [0226]-[0231], [0237], [0264]-[0265], [0286]-[0287], [0296], [0299] | |
| WO 2019/193331 A2 | 10 Oct. 2019 | GB 2572573 A<br>GB 2572659 A | |
| JP 2015-220331 A | 07 Dec. 2015 | (Family: none) | |
| US 2017/0057962 A1 | 02 Mar. 2017 | WO 2015/038671 A2 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014031364 A
- WO 2011052709 A
- WO 2013051676 A


### Non-patent literature cited in the description


- *Appl. Phys. Lett.,* 2017, vol. 110, 083301
- *RSC Adv.,* 2017, vol. 7, 1743-1748
- *Nanoscale Research Letters,* 2011, vol. 6, 545